(19) Europäisches Patentamt
European Patent Office
Office européen des brevets

(11) EP 4 141 978 A1

(12) **EUROPEAN PATENT APPLICATION**

(43) Date of publication:
**01.03.2023 Bulletin 2023/09**

(21) Application number: **21194297.4**

(22) Date of filing: **01.09.2021**

(51) International Patent Classification (IPC):
***H01L 51/52*** *(2006.01)* ***C07C 211/00*** *(2006.01)*

(52) Cooperative Patent Classification (CPC):
**H01L 51/5275;** H01L 2251/55

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.08.2021 KR 20210111834**

(71) Applicant: **Dongjin Semichem Co., Ltd.**
**Hwaseong-si, Gyeonggi-do 18635 (KR)**

(72) Inventors:
- **Ham, Ho Wan**
  **Hwaseong-si,Gyeonggi-do (KR)**
- **An, Hyun Cheol**
  **Hwaseong-si,Gyeonggi-do (KR)**
- **Min, Byung Cheol**
  **Hwaseong-si,Gyeonggi-do (KR)**
- **Lee, Dong Hyun**
  **Hwaseong-si,Gyeonggi-do (KR)**
- **Han, Jeong Woo**
  **Hwaseong-si,Gyeonggi-do (KR)**
- **Ann, Ja Eun**
  **Hwaseong-si,Gyeonggi-do (KR)**
- **Kwon, Dong Yuel**
  **Hwaseong-si,Gyeonggi-do (KR)**
- **Je, Hwan il**
  **Hwaseong-si,Gyeonggi-do (KR)**

(74) Representative: **Grünecker Patent- und Rechtsanwälte**
**PartG mbB**
**Leopoldstraße 4**
**80802 München (DE)**

# (54) NEW ORGANIC COMPOUND FOR CAPPING LAYER AND ORGANIC LIGHT EMITTING DIODE COMPRISING TO THE SAME

(57) As a compound for a capping layer for an organic light emitting device, disclosed is a capping layer compound including: a first electrode and a second electrode; an organic material layer interposed between the first electrode and the second electrode; and a capping layer disposed outside one or more of the first electrode and the second electrode, wherein the capping layer satisfies the following Conditions (1) to (3) and includes a compound represented by the following Formula (1).
Condition (1) n(@450nm) ≥ 2.50
Condition (2) k(@450nm) ≤ 0.30
Condition (3) k (@380 nm) ≥ 0.90
(Wherein n represents a refractive index at each wavelength, and k represents an extinction coefficient at each wavelength)

<Formula 1>

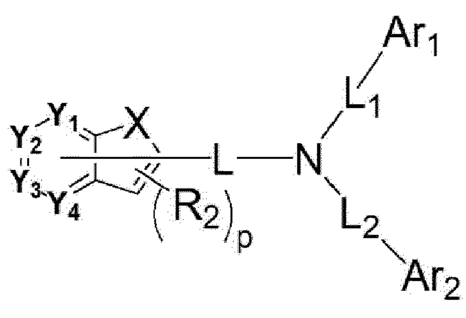

EP 4 141 978 A1

FIG. 1

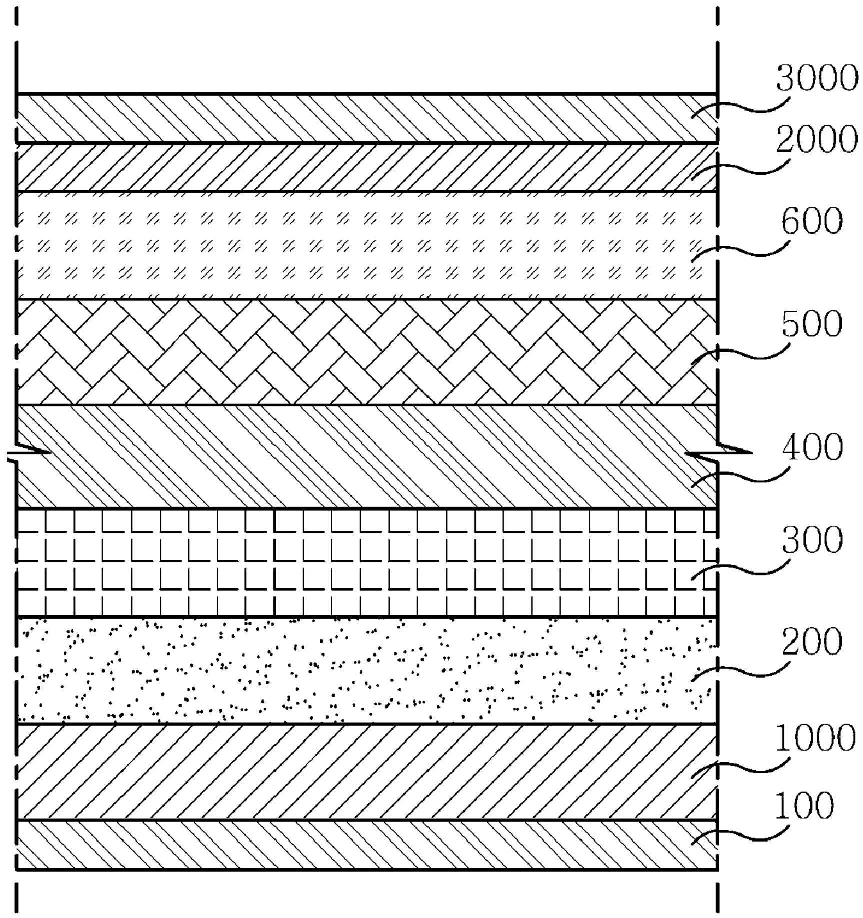

## Description

BACKGROUND OF THE INVENTION

Field of the Invention

The present invention relates to an organic compound for a capping layer and an organic light emitting device having the same.

Description of the Related Art

Materials used for organic layers in an organic light emitting device may be classified into a light emitting material, a hole injection material, a hole transport material, an electron transport material, an electron injection material, and the like, according to the functions thereof.

In addition, the light emitting material may be classified into a fluorescent material derived from a singlet excited state of an electron and a phosphorescent material derived from a triplet excited state of an electron according to a light emitting mechanism, and also classified into blue, green, and red light emitting materials according to the emitting color, and may be divided into yellow and orange, necessary to realize better natural colors.

A typical organic light emitting device may have a structure in which an anode is formed on a substrate, and a hole transport layer, a light emitting layer, an electron transport layer, and a cathode are sequentially formed on the anode. Here, the hole transport layer, the light emitting layer, and the electron transport layer are organic thin films made of an organic compound.

The principle for driving an organic light emitting device having the structure described above will be described below.

When a voltage is applied between the anode and the cathode, holes injected from the anode move to the light emitting layer via the hole transport layer, and electrons injected from the cathode move to the light emitting layer via the electron transport layer. The holes and electrons recombine in the light emitting layer to generate excitons.

Light is generated as this exciton changes from an excited state to a ground state. Regarding the efficiency of the organic light emitting device, internal luminous efficiency and external luminous efficiency are considered. The internal luminous efficiency is related to how efficiently excitons are generated and photoconverted in organic material layers interposed between the first and second electrodes, such as a hole transport layer, a light emitting layer, and an electron transport layer. Theoretically, it is known that the internal luminous efficiency is 25% for the fluorescence 100% for the phosphorescence.

On the other hand, the external luminous efficiency refers to how efficiently the light generated in the organic material layers exits the organic light emitting device. It is known that the level of the external luminous efficiency is about 20% of level of the internal luminous efficiency. As a method of increasing the light extraction from the organic lighting emitting device, various organic compounds having a refractive index of 1.7 or higher have been used as an application for a capping layer to prevent the total reflection and loss of light going out to the outside. Thus, to increase the external luminous efficiency of the organic light emitting device, efforts have been made to develop organic compounds with high refractive index and thin film stability.

Documents of Related Art

(Patent Document 1) Korean Patent Application Publication No. 10-2004-0098238

SUMMARY OF THE INVENTION

An objective of the present disclosure is to provide an organic light emitting device with a capping layer that has a high refractive index of 2.50 or higher at a wavelength of 450 nm and can realize high efficiency and high color purity with an excellent light extraction effect.

In addition, an objective of the present disclosure is to provide an organic light emitting device with a capping layer capable of realizing high efficiency and high color purity by minimizing absorption intensity in a visible light region by having an extinction coefficient (k) of 0.30 or less at a wavelength of 450 nm.

In addition, an objective of the present disclosure is to provide an organic light emitting device with a capping layer capable of improving the degradation of a lifetime from the external environment by increasing the absorption wavelength in the ultraviolet region to have an extinction coefficient (k) of 0.90 or more at a wavelength of 380 nm.

In addition, an objective of this disclosure is to provide a capping layer compound having a high refractive index and excellent thin film stability and an organic light emitting device including the same capping layer compound, the

compound having a structure in which a fused ring formed by two or more rings including a 5-membered cyclic ring and a 6-membered cyclic ring fused to each other with or without a heteroatom of N, O, S, Se, or Te is directly bonded to or indirectly bonded to a nitrogen of one arylamine via a linker.

In addition, an objective of the present disclosure is to provide an organic light emitting device with a capping layer containing a compound to have a wide bandgap that cannot absorb visible light region, high refractive index and increase absorption wavelength in the ultraviolet region and to realize high color purity, high efficiency, and a long lifetime. The capping layer compound includes a structure in which a fused ring formed by rings including a 5-membered cyclic ring and a 6-membered cyclic ring fused is bonded to the nitrogen of an arylamine, wherein the 5-membered cyclic ring may be a heterocyclic 5-membered cyclic ring containing O, S, Se or Te, or the 6-membered cyclic ring may be a heterocyclic 6-membered cyclic ring containing nitrogen (N).

A further objective of the present disclosure is to provide a capping layer compound and an organic light emitting device including the same, the compound minimizing the bulky characteristic of an end portion of the arylamine or an end portion of the fused ring to improve an intermolecular arrangement characteristics, thereby improving both the refractive index and stability against external air and moisture. The compound also has a high glass transition temperature (Tg) and a high decomposition temperature (Td), thereby preventing recrystallization of molecules and enabling a stable thin film that is durable against heat generated during an operation of an organic light emitting device so that organic light emitting device has increased efficiency and improved lifetime.

The above tasks and additional tasks will be described in detail below.

As a means for achieving the objectives,

the present disclosure provides an organic light emitting device may include,
a first electrode and a second electrode;
an organic material layer interposed between the first electrode and the second electrode; and
a capping layer disposed on an outer surface of one or more of the first electrode and the second electrode,
wherein the capping layer satisfies the following Conditions (1) to (3) and includes a compound represented by the following Formula (1).

$$\text{Condition (1) } n(@450nm) \geq 2.50$$

$$\text{Condition (2) } k(@450nm) \leq 0.30$$

$$\text{Condition (3) } k\ (@380\ nm) \geq 0.90$$

(Where n represents a refractive index at each wavelength, and k represents an extinction coefficient at each wavelength)

<Formula 1>

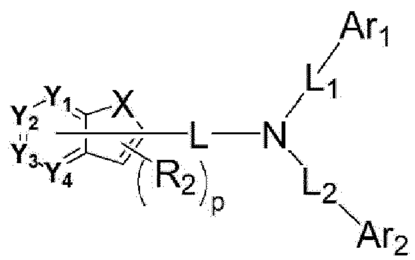

In Formula 1,

X represents O, S, Se, Te, or CRR';
each of R and R' independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy group, a substituted or unsubstituted C1~C30 sulfide, a substituted or unsubstituted C6~ C50 aryl group, or a substituted or unsubstituted C2~ C50 heteroaryl group, and adjacent R and R' may or may not form a ring by combining with each other,

each of $Y_1$ to $Y_4$ independently represents C, $CR_1$ or, N, $R_1$ independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy group, a substituted or unsubstituted C1~C30 sulfide group, or a substituted or unsubstituted C6C~50 aryl group, and adjacent $R_1$ may or may not form a ring by combining with each other,

each of $Ar_1$ and $Ar_2$ independently represents a substituted or unsubstituted C6~C50 aryl group, or a substituted or unsubstituted C2~ C50 heteroaryl group,

$R_2$ independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy group, a substituted or unsubstituted C1~ C30 sulfide group, or a substituted or unsubstituted C6~ C50 aryl group, or a substituted or unsubstituted C2~ C50 heteroaryl group,

each of L, $L_1$, and $L_2$ independently represents a direct bond, a substituted or unsubstituted C6~ C50 arylene group, or a substituted or unsubstituted C2~ C50 heteroarylene group, and

p represents an integer in a range of 0 to 2.

The organic light emitting device having a capping layer according to an embodiment of the present invention feature that the capping layer can realize high efficiency and high color purity with an excellent light extraction effect by having a high refractive index of 2.50 or higher at a wavelength of 450 nm and by minimizing absorption intensity in a visible light region due to an extinction coefficient (k) of 0.30 or less at a wavelength of 450 nm. The capping layer also can improve the degradation in a lifetime from the external environment by increasing the absorption wavelength in the ultraviolet region to have an extinction coefficient (k) of 0.90 or more at a wavelength of 380 nm.

In addition, the capping layer compound, according to an embodiment of this disclosure, has or no heteroatoms of N, O, S, Se, or Te, and a fused ring in which two or more rings such as a 5-membered cyclic ring and a 6-membered cyclic ring are directly bonded to the nitrogen of one arylamine or bonded through a linking group, hence exhibiting excellent high refractive film stability.

According to the present invention, the compound has a structure in which the fused ring of the 5-membered cyclic ring and the 6-membered cyclic ring is bonded to the nitrogen of the arylamine, in which the 5-membered cyclic ring is a heterocyclic 5-membered cyclic ring containing O, S, Se, or Te, or the 6-membered cyclic ring is a heterocyclic 6-membered cyclic ring containing N. Therefore, the compound has a wide bandgap not to be able to absorb a visible light region and high refractive index and can absorb a broader range of UV rays, thereby enabling an organic light emitting device having high color purity, high efficiency, and long lifetime.

Furthermore, the capping layer compound according to an embodiment of the present disclosure minimizes the bulky characteristic of the end portion of the arylamine or the end portion of the fused ring to improve the intermolecular arrangement characteristics, thereby improving the refractive index and at the same time improving the stability against external air and moisture. Here, since the compound of the present disclosure has a high Tg and a high Td, recrystallization of molecules is prevented so that a stable thin film against heat generated during operation of an organic light emitting device can be maintained. Therefore, external quantum efficiency and lifetime are improved.

The above effects and additional effects will be described in detail below.

## BRIEF DESCRIPTION OF THE DRAWINGS

FIG. 1 is a cross-sectional view schematically showing a layer structure of an organic light emitting device.

FIG. 2 is a measurement of an extinction coefficient in a wavelength range of 360 nm to 460 nm.

## DETAILED DESCRIPTION OF THE INVENTION

Prior to a description of the present invention, it should be noted that the terms used in the present specification are used only to describe specific examples and are not intended to limit the scope of the present invention, which will be defined only by the appended claims. Unless otherwise defined herein, all terms including technical and scientific terms used herein have the same meaning as commonly understood by those who are ordinarily skilled in the art to which this invention pertains.

Unless otherwise stated herein, it will be further understood that the terms "comprise", "comprises", and "comprising", when used in this specification, specify the presence of stated features, regions, integers, steps, operations, elements and/or components but do not preclude the presence or addition of one or more other features, regions, integers, steps, operations, elements, components, and/or groups thereof.

Throughout this specification and claims, the term "aryl" refers to a C5~50 aromatic hydrocarbon group which

includes an aromatic ring, for example, phenyl, benzyl, naphthyl, biphenyl, terphenyl, fluorene, phenanthrenyl, triphenylenyl, perylenyl, crisenyl, fluoranthenyl, benzofluorenyl, benzotriphenylenyl, benzocrisenyl, anthracenyl, stilbenyl, pyrenyl. The term "heteroaryl" refers to a C2~50 aromatic ring containing at least one heteroatoms, for example, pyrrolyl, pyrazinyl, pyridinyl, indolyl, isoindolyl, furyl, benzofuranyl, isobenzofuranyl, dibenzofuranyl, benzothiophenyl, dibenzothiophenyl, quinolyl, isoquinolyl, quinoxalinyl, carbazolyl, phenanthridinyl, acridinyl, phenanthrolinyl, thienyl, and a pyridine ring, a pyrazine ring, a pyrimidine ring, a pyridazine ring, a triazine ring, an indole ring, a quinoline ring, an acridine ring, a pyrrolidine ring, a dioxane ring, a piperidine ring, a morpholine ring, a piperazine ring, a carbazole ring, a furan ring, a thiophene ring, an oxazole ring, an oxadiazole ring, a benzofuran ring, a thiazole ring, a thiadiazole ring, a benzothiophene ring, a triazole ring, an imidazole ring, a benzoimidazole ring, a pyran ring, a dibenzofuran ring.

In addition, in the formula, $Ar_x$ (where x is an integer) represents a substituted or unsubstituted C6~C50 aryl group, or a substituted or unsubstituted C2~C50 heteroaryl group, unless otherwise defined, and $L_x$ (where x is an integer) represents a direct bond, a substituted or unsubstituted C6~C50 arylene group, or a substituted or unsubstituted C2~C50 hetero arylene group, unless specifically defined, $R_x$ (where x is an integer) represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy group, a substituted or unsubstituted C1~C30 sulfide group, a substituted or unsubstituted C6~C50 aryl group, or a substituted or unsubstituted C2~C50 heteroaryl group, unless otherwise defined.

Throughout this specification and claims, the term "substituted or unsubstituted" may mean that it is substituted or not substituted with at least one selected from the group consisting of deuterium, halogen, an amino group, a cyano group, a nitrile group, a nitro group, a nitroso group, a sulfamoyl group, an isothiocyanate group, a thiocyanate group, a carboxyl group, or a C1~ C30 alkyl group, a C1~C30 alkyl sulfinyl group, a C1~C30 alkyl sulfonyl group, a C1~C30 alkyl sulfanyl group, a C1~C12 fluoroalkyl group, a C2~C30 alkenyl group, a C1~C30 alkoxy group, a C1~C12 N-alkylamino group, a C2~C20 N, N-dialkylamino group, a substituted or unsubstituted C1~C30 sulfide group, a C1~C6 N-alkyl sulfamoyl group, a C2~C12 N, N-dialkyl sulfamoyl group, a C3~C30 silyl group, a C3~C20 cycloalkyl group, a C3~C20 hetero cycloalkyl group, a C6~C50 aryl group, and a C2~C50 heteroaryl group, etc. unless otherwise defined. In addition, the same symbols throughout the present specification may have the same meaning unless otherwise specified.

On the other hand, various embodiments of the present disclosure may be combined with any other embodiments unless clearly indicated to the contrary. Hereinafter, embodiments of the present disclosure and effects thereof will be described.

Hereinafter, the present disclosure will be described in detail.

An organic light emitting device according to an embodiment of the present disclosure may include,

a first electrode and a second electrode; an organic material layer interposed between the first electrode and the second electrode; and a capping layer disposed on an outer surface of one or more of the first electrode and the second electrode.

The capping layer satisfies the following Conditions (1) to (3) and includes a compound represented by the following Formula (1).

$$\text{Condition (1) } n(@450nm) \geq 2.50$$

$$\text{Condition (2) } k(@450nm) \leq 0.30$$

$$\text{Condition (3) } k\ (@380\ nm) \geq 0.90$$

(Where n represents a refractive index at each wavelength, and k represents an extinction coefficient at each wavelength)

<Formula 1>

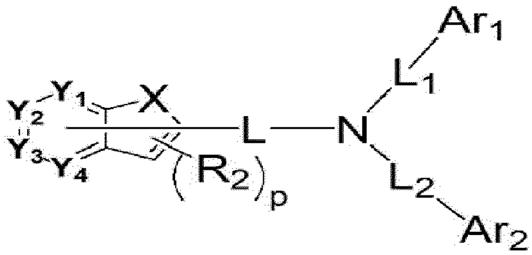

In Formula 1,

X represents O, S, Se, Te, or CRR';
each of R and R' independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy group, a substituted or unsubstituted C1~C30 sulfide, a substituted or unsubstituted C6~C50 aryl group, or a substituted or unsubstituted C2~C50 heteroaryl group, and adjacent R and R' may or may not form a ring by combining with each other,
each of $Y_1$ to $Y_4$ independently represents C, $CR_1$, or N,
$R_1$ independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 of an alkoxy group, a substituted or unsubstituted C1~C30 sulfide group, or a substituted or unsubstituted C6~C50 aryl group, and adjacent $R_1$ may or may not form a ring by combining with each other,
each of $Ar_1$ and $Ar_2$ independently represents a substituted or unsubstituted C6~C50 aryl group, or a substituted or unsubstituted C2~ C50 heteroaryl group,
$R_2$ independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy a group, a substituted or unsubstituted C1~C30 sulfide group, or a substituted or unsubstituted C6~C50 aryl group, or a substituted or unsubstituted C2~C50 heteroaryl group,
each of L, $L_1$, and $L_2$ independently represents a direct bond, a substituted or unsubstituted C6~C50 arylene group, or a substituted or unsubstituted C2~C50 heteroarylene group, and
p represents an integer in a range of 0 to 2.

In addition, as a specific example of the capping layer compound of the present disclosure Formula 1 refers to compounds represented by the following Formula 2:

<Formula 2>

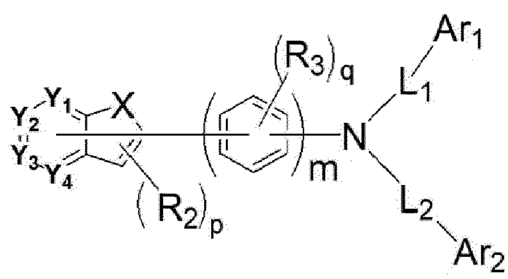

In Formula 2,

X, $Y_1$ to $Y_4$, $Ar_1$, $Ar_2$, $R_2$, $L_1$, $L_2$, and p are the same as defined in Formula 1 above,
$R_3$ is the same as the definition of $R_2$ in Formula 1 (provided that the number of carbon atoms in $R_3$ satisfies the carbon number range defined in L),
q represents an integer in a range of 0 to 4, and
m represents an integer in a range of 1 to 5.

The capping layer compound represented by Formula 2 has a structure in which a fused ring including X formed by fusing a 5-membered cyclic ring and a 6-membered cyclic ring is bonded to the nitrogen atom of an arylamine and linked by a phenylene group, through which the absorption wavelength of the blue region can be minimized, and the refractive index can be improved at the same time.

Furthermore, as a specific exemplary compound of the capping layer compound of the present disclosure, Formula 1 refers to compounds represented by the following Formula 3:

<Formula 3>

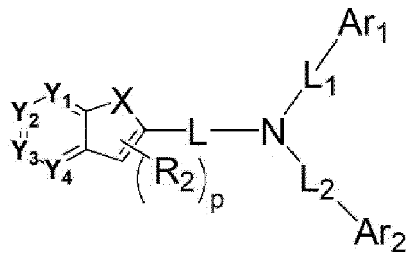

In Formula 3,

X, $Y_1$ to $Y_4$, $Ar_1$, $Ar_2$, $R_2$, L, $L_1$, and $L_2$ are the same as those defined in Formula 1 above, and
p represents 0 or 1.

The capping layer compound represented by Formula 3 has a structure in which a fused ring including X formed by fusing a 5-membered cyclic ring and a 6-membered cyclic ring is bonded to the nitrogen atom of an arylamine, and the nitrogen bonding position is linked to a carbon atom of the 5-membered cyclic ring. Specifically, the nitrogen bonding position is linked to the carbon atom that is closest to X. This structure further increases the refractive index.

Here, when X is O, S, Te, or Se, the position closest to X may mean Position 2 of the fused ring, while when X is CRR', the position may mean Position 6.

In addition, as a specific example of the capping layer compound of the present disclosure Formula 1 refers to compounds represented by the following Formula 4:

<Formula 4>

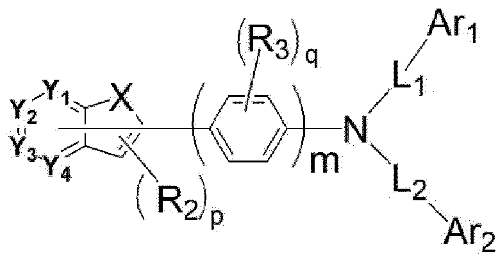

In Formula 4,

X, $Y_1$ to $Y_4$, $Ar_1$, $Ar_2$, $R_2$, $L_1$, $L_2$, and p are the same as those defined in Formula 1 above,
$R_3$ is the same as the definition of $R_2$ in Formula 1 (provided that the number of carbon atoms in $R_3$ satisfies the carbon number range defined in L),
q represents an integer in a range of 0 to 4, and
m represents an integer in a range of 1 to 5.

The capping layer compound represented by Formula 4 has a structure in which a fused ring including X formed by fusing a 5-membered cyclic ring and a 6-membered cyclic ring is bonded to the nitrogen of an arylamine and linked by 1,4-phenylene group of a para bond. This structure increases a refractive index and an absorbable wavelength range

in an ultraviolet region, so that the compound has improved stability against external UV exposure.

In addition, as a specific example of the capping layer compound of the present disclosure Formula 1 refers to compounds represented by the following Formula 5:

<Formula 5>

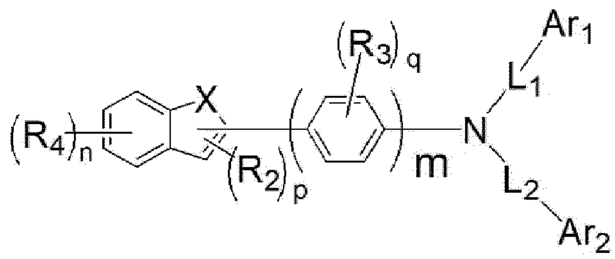

In Formula 5,

X, $Ar_1$, $Ar_2$, $R_2$, $L_1$, and $L_2$ are the same as those defined in Formula 1 above,
$R_3$ independently represents the same as the definition of $R_2$ in Formula 1 (provided that the number of carbon atoms in $R_3$ satisfies the range of carbon atoms defined in L),
$R_4$ independently represents the same as the definition of $R_1$ in Formula 1 above,
p represents 0 or 1,
q represents an integer in a range of 0 to 4,
m represents an integer in a range of 1 to 5, and
n represents an integer in a range of 0 to 4.

In the capping layer compound represented by Formula 5, $Y_1$ to $Y_4$ of the 6-membered cyclic ring are all carbon, the nitrogen of the arylamine is bonded to the fused ring including X formed by fusing the 5-membered cyclic ring and the 6-membered cyclic ring, the nitrogen is linked to a carbon atom of the 5-membered cyclic ring, and the 5-membered cyclic ring and the nitrogen are linked by a 1,4-phenylene group of a para bond. This structure minimizes the twist angle between the core (fused ring) and the linker. Therefore, an excellent molecular arrangement can be achieved, and the refractive index can be improved.

In addition, as a specific example of the capping layer compound of the present disclosure Formula 1 refers to compounds represented by the following Formula 6:

<Formula 6>

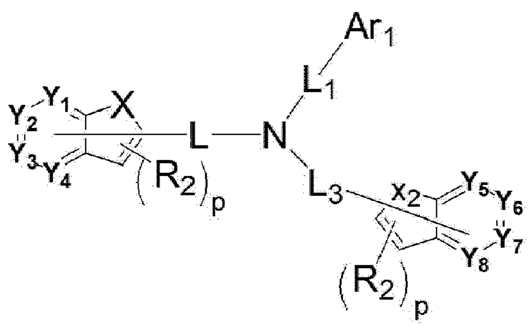

In Formula 6,

X, $Y_1$ to $Y_4$, $Ar_1$, $R_2$, L, $L_1$, and p are the same as those defined in Formula 1 above,
$L_3$ is the same as the definitions of L, $L_1$, and $L_2$ in Formula 1 above,
$X_2$ is the same as the definition of X in Formula 1 and each of $Y_5$ to $Y_8$ independently represents the same as the definitions of $Y_1$ to $Y_4$ in Formula 1 (provided that the carbon number of $Y_5$ to $Y_8$ satisfies the carbon number range defined by $Ar_2$) .

The capping layer compound represented by Formula 6 has a structure in which two fused rings, each formed by fusing a 5-membered cyclic ring and a 6-membered cyclic ring, are linked to the nitrogen of an arylamine, respectively. Since the compound has two or more fused rings, the compound has a high refractive index and minimizes the adsorption of a blue wavelength range.

In addition, as a specific example of the capping layer compound of the present disclosure Formula 1 refers to compounds represented by the following Formula 7:

<Formula 7>

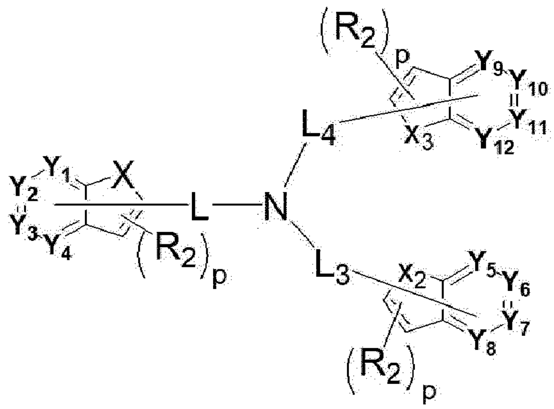

In Formula 7,

each of X, $Y_1$ to $Y_4$, $R_2$, L, and p independently represents the same as those defined in Formula 1 above,
each of $L_3$ and $L_4$ independently represents the same as the definitions of $L_1$ and $L_2$ in Formula 1 above,
each of $X_2$ and $X_3$ independently represents the same as the definition of X in Formula 1, and
each of $Y_5$ to $Y_{12}$ independently represents the same as those of $Y_1$ to $Y_4$ in Formula 1 (provided that the carbon number of $Y_5$ to $Y_{12}$ satisfies the carbon number range defined by $Ar_1$ or $Ar_2$).

The capping layer compound represented by Formula 7 has a structure in which three fused rings, each formed by fusing a 5-membered cyclic ring and a 6-membered cyclic ring, are linked to the nitrogen atoms of an arylamine, respectively. This structure is effective in maximally increasing the refractive index and the absorption intensity for an ultraviolet region.

Meanwhile, in Formulae 1 to 7, X, $X_2$, and $X_3$ may each independently be O or S, minimizing the bond length of heteroatoms, thereby reducing bulky properties.

More specifically, when X is O, a high refractive index can be maintained, and the deposition temperature can be lowered because the molecular weight is reduced. In addition, when X is S, the compound has a high refractive index and has the advantage of forming a stable thin film because the compound has a high glass transition temperature. In particular, in Formula 6 or Formula 7, X and $X_2$ may be different from each other, and in this case it may be more effective in improving efficiency, color purity, and lifetime by maintaining a high refractive index, improving absorption of the ultraviolet region and minimizing absorption of the visible region.

In addition, in Formulae 1 to 7, each of $R_1$ and $R_2$ independently may be selected from hydrogen, deuterium, a methyl group, a methoxy group, a phenyl group, or a combination thereof. Described above minimizes the bulky properties of the ring structure adjacent to the amine, thereby effectively improving the refractive index. More specifically, each of $R_1$ and $R_2$ independently may be selected from hydrogen, a phenyl group, a biphenyl group, or a combination thereof.

In addition, in Formulae 1 to 7, all of L, $L_1$, $L_2$, $L_3$, and $L_4$, which are intermediate linking groups, may not be direct bonds. That is, the fused ring including X, $X_2$, or $X_3$, $Ar_1$, and $Ar_2$ may be bonded to nitrogen by a linking group rather than a direct bond, thereby improving refractive index and absorption intensity.

Also, in Formulae 2, 4, and 5, m may specifically represent 1 to 3, more specifically 2 or 3. That is, the fused ring including X and nitrogen may be linked by a phenylene group, a biphenylene group, or a terphenylene group, and more specifically, may be connected by a 1,4-phenylene group, 1,4-biphenylene group, or 1,4-terphenylene group having a para bond. Through this, absorption in the visible light region can be minimized. In addition, the fused ring including X and nitrogen may be connected by a biphenylene group or a terphenylene group, and more specifically, may be connected by a 1,4-biphenylene group or 1,4-terphenylene group having a para bond. In this case, since it has a higher

refractive index, it may be more effective in improving efficiency.

In addition, in Formulae 1 to 6, $Ar_1$ and $Ar_2$ may be independently selected from a phenyl group, a biphenyl group, a terphenyl group, a naphthyl group, a phenanthrenyl group, a triphenylenyl group, a benzofuran group, a benzothiophene group, or a combination thereof. More specifically, they may include a terphenyl group, a naphthyl group, a benzofuran group, or a benzothiophene group. In this case, the refractive index is increased, and the deposition temperature is lowered. Therefore, the thermal stability of the compound can be effectively improved.

As such, the capping layer compound of the present invention minimizes the bulky characteristic of a substituent, thereby having a high refractive index. In addition, the ability to absorb UV rays is improved, and the refractive index is improved due to an improved intermolecular arrangement characteristicsin a thin film.

In the definitions of Formulae 1 to 4, when one element is expressed as "being substituted", a substituent to replace the element may be hydrogen. However, in the present invention, the substituent may not be limited thereto. Alternatively, any other one among the substituents mentioned above may be used.

The compounds described below are specific examples of the compounds according to the present invention. The examples described below are presented only to help understanding of the present invention, and the scope of the present invention is not limited thereto.

| | | |
|---|---|---|
| 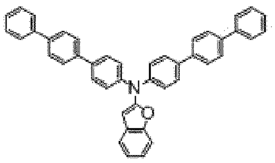 | 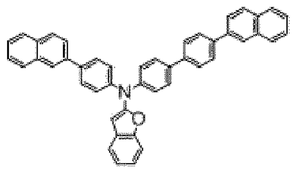 | 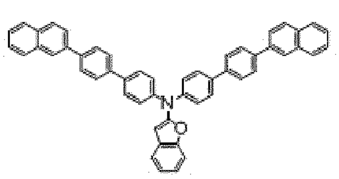 |
| **1** | **2** | **3** |
| 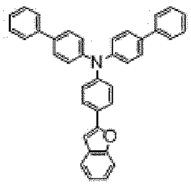 | 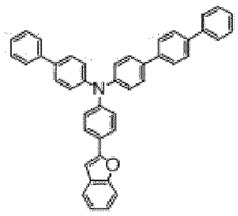 | 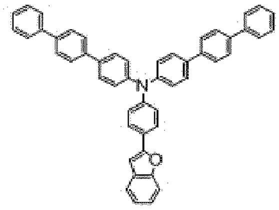 |
| **4** | **5** | **6** |
| 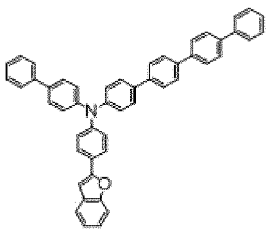 | 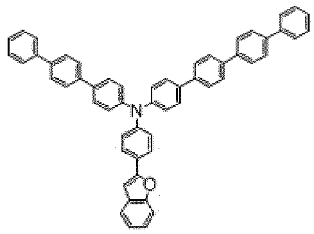 | 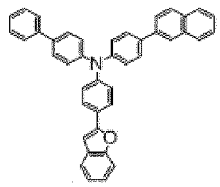 |
| **7** | **8** | **9** |
| 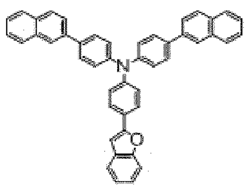 | 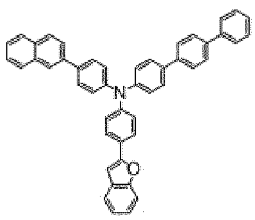 | 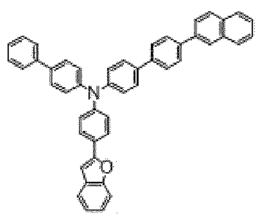 |
| **10** | **11** | **12** |

(continued)

| | | |
|---|---|---|
| 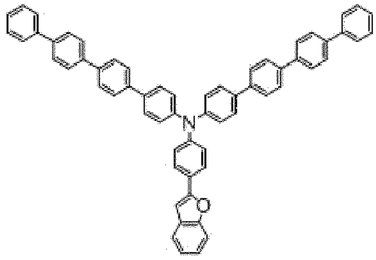 | 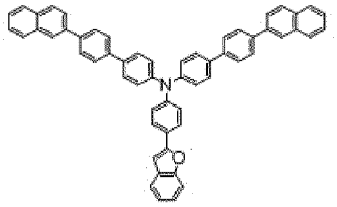 | 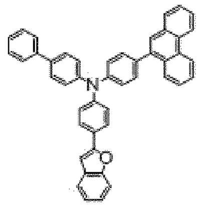 |
| **13** | **14** | **15** |
| 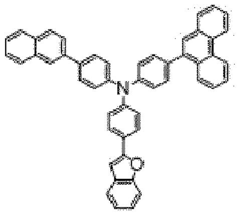 | 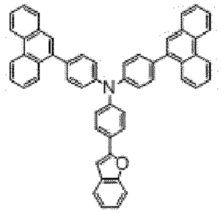 | 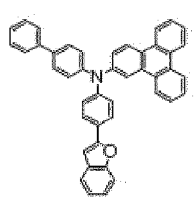 |
| **16** | **17** | **18** |
| 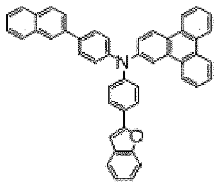 | 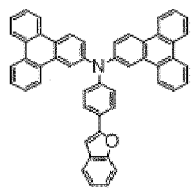 | 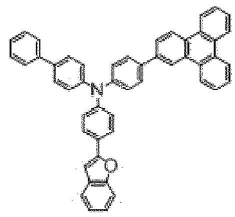 |
| **19** | **20** | **21** |
| 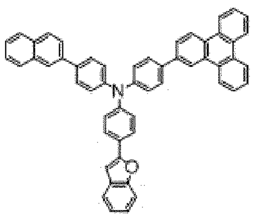 | 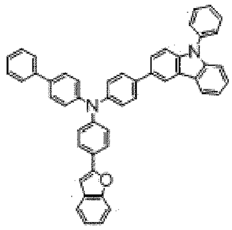 | 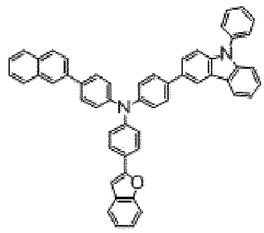 |
| **22** | **23** | **24** |
| 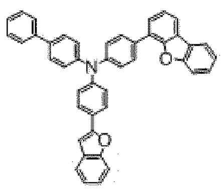 | 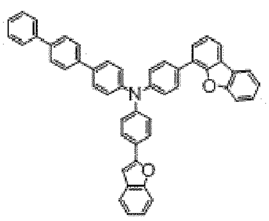 | 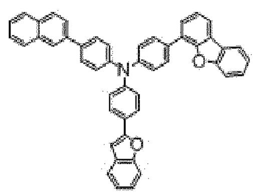 |
| **25** | **26** | **27** |

(continued)

| | | |
|---|---|---|
| 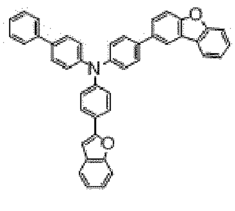 | 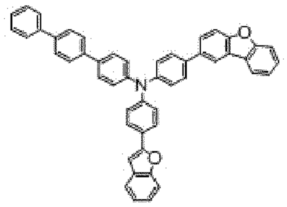 | 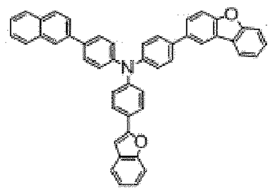 |
| **28** | **29** | **30** |
| 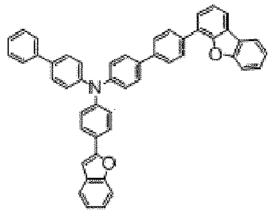 | 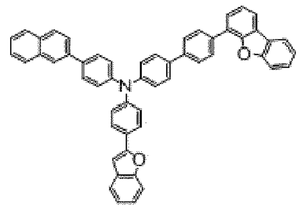 | 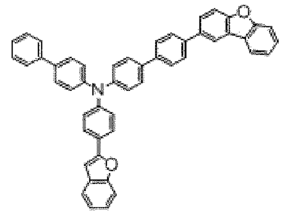 |
| **31** | **32** | **33** |
| 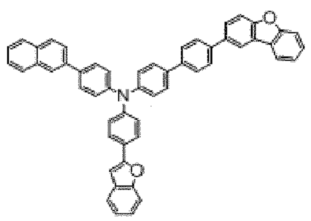 | 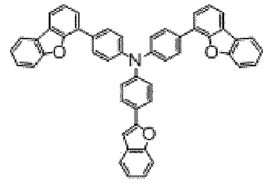 | 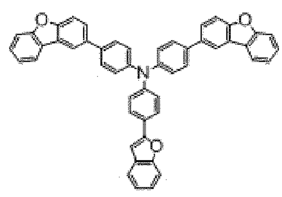 |
| **34** | **35** | **36** |
| 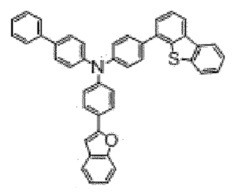 | 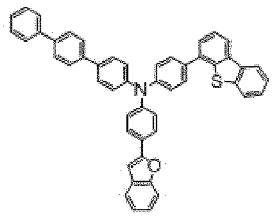 | 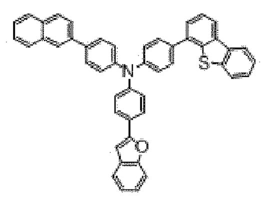 |
| **37** | **38** | **39** |
| 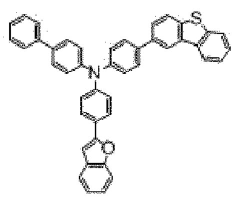 | 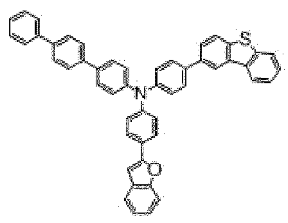 | 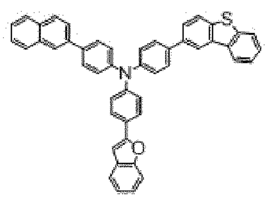 |
| **40** | **41** | **42** |
| 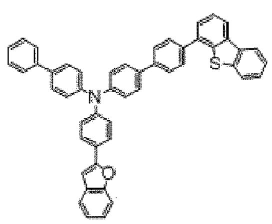 | 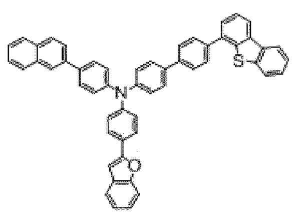 | 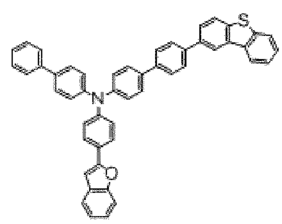 |

(continued)

| 43 | 44 | 45 |
|---|---|---|
| 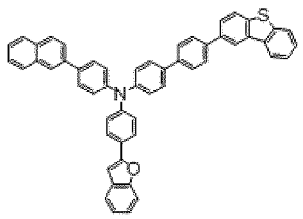 | 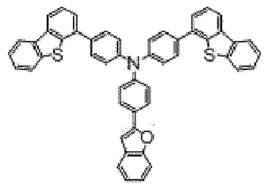 | 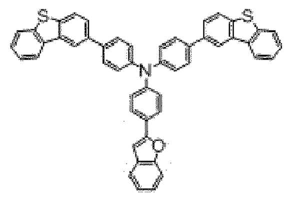 |
| 46 | 47 | 48 |
| 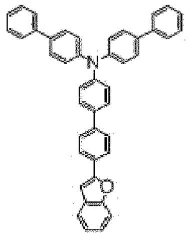 | 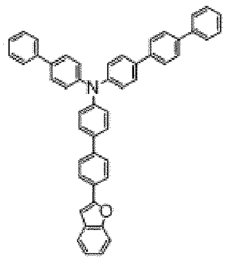 | 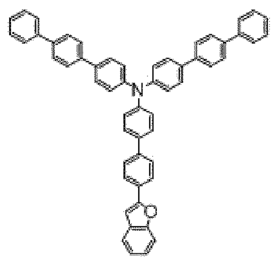 |
| 49 | 50 | 51 |
| 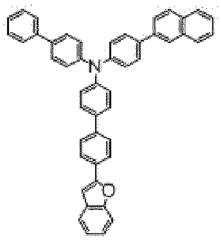 | 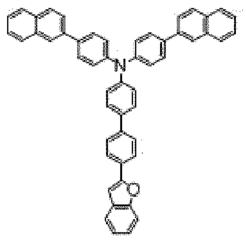 | 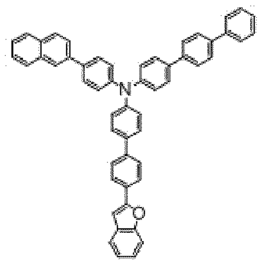 |
| 52 | 53 | 54 |
| 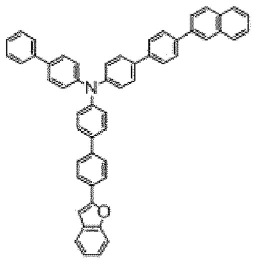 | 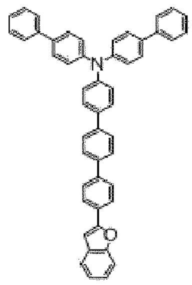 | 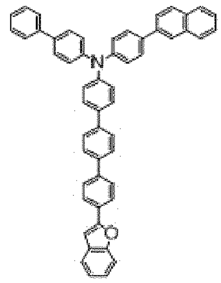 |
| 55 | 56 | 57 |
| 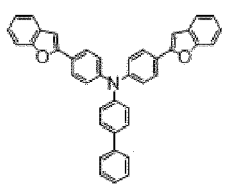 | 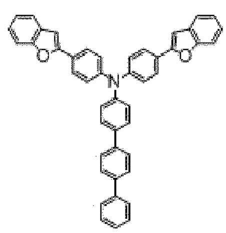 | 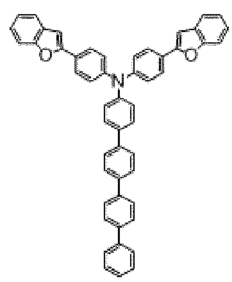 |
| 58 | 59 | 60 |

(continued)

| | | |
|---|---|---|
| 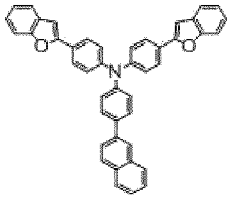 | 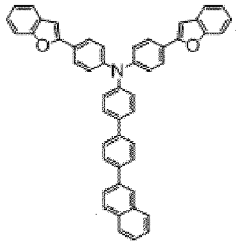 | 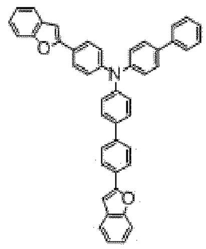 |
| **61** | **62** | **63** |
| 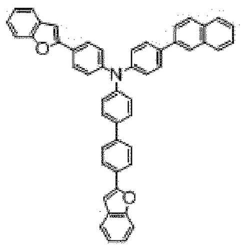 | 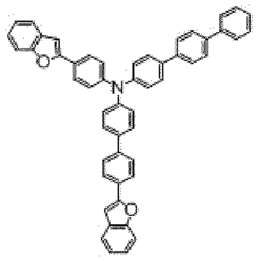 | 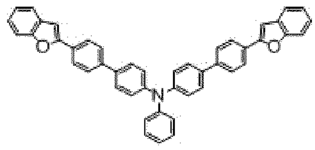 |
| **64** | **65** | **66** |
| 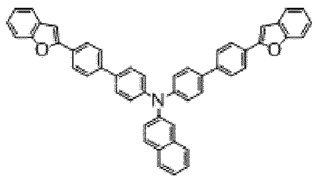 | 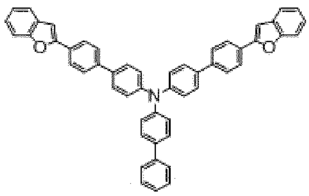 | 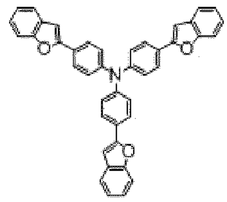 |
| **67** | **68** | **69** |
| 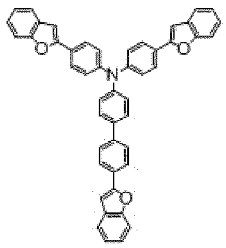 | 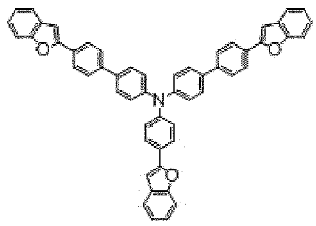 | 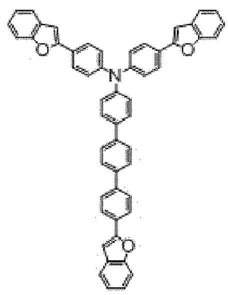 |
| **70** | **71** | **72** |
| 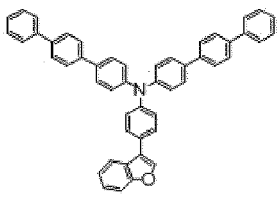 | 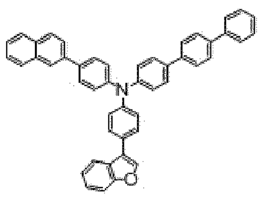 | 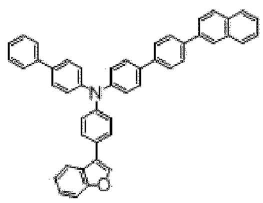 |
| **73** | **74** | **75** |

(continued)

| | | |
|---|---|---|
| 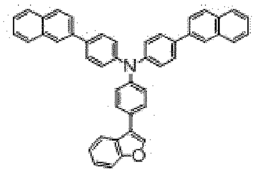 | 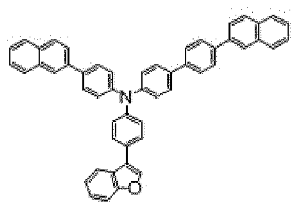 | 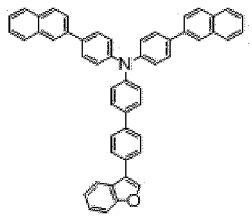 |
| **76** | **77** | **78** |
| 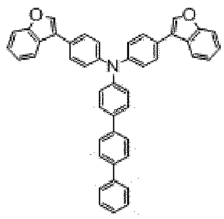 | 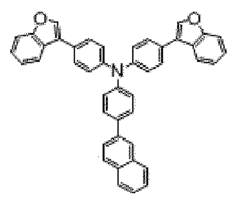 | 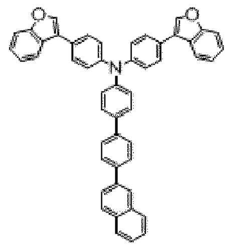 |
| **79** | **80** | **81** |
| 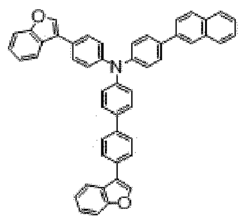 | 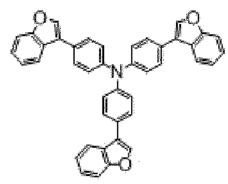 | 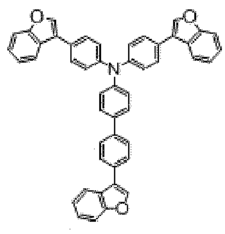 |
| **82** | **83** | **84** |
| 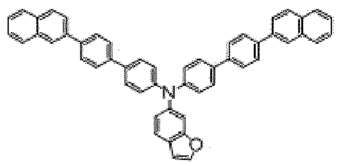 | 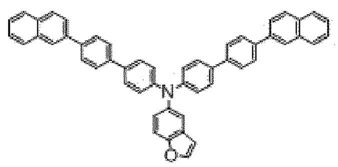 | 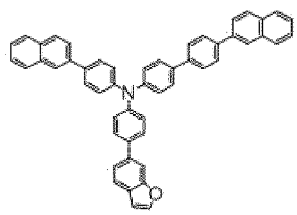 |
| **85** | **86** | **87** |
| 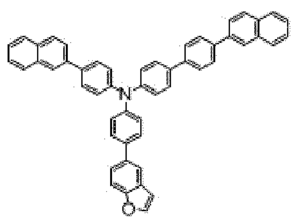 | 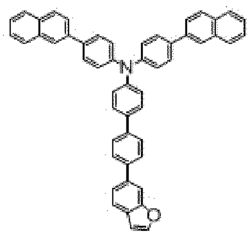 | 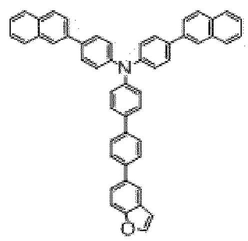 |
| **88** | **89** | **90** |

(continued)

| | | |
|---|---|---|
| 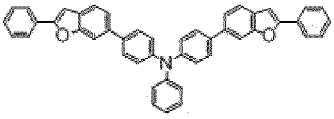 | 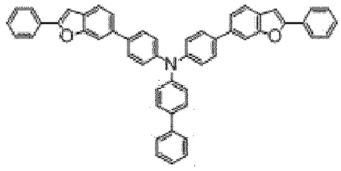 | 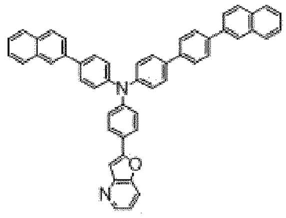 |
| 91 | 92 | 93 |
| 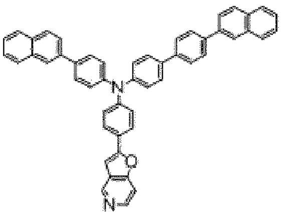 | 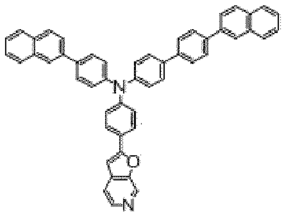 | 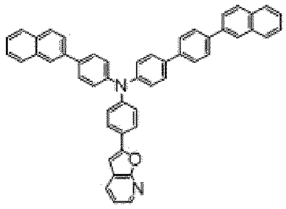 |
| 94 | 95 | 96 |
| 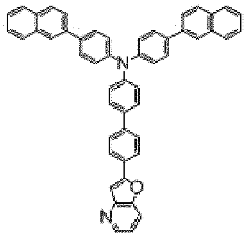 | 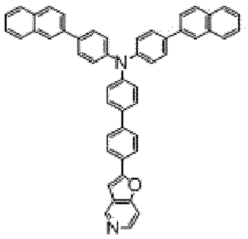 | 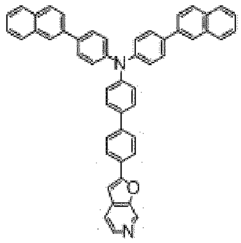 |
| 97 | 98 | 99 |
| 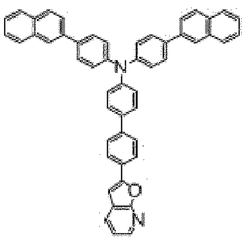 | 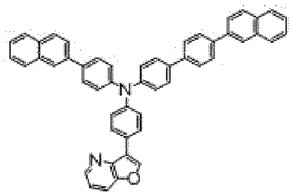 | 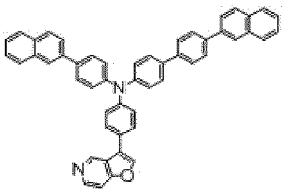 |
| 100 | 101 | 102 |
| 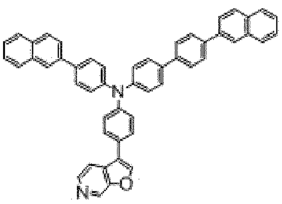 | 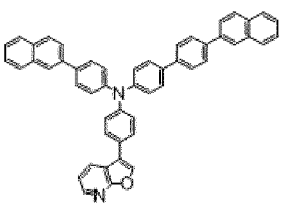 | 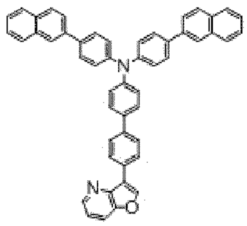 |
| 103 | 104 | 105 |

(continued)

| | | |
|---|---|---|
| 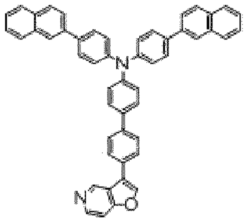 | 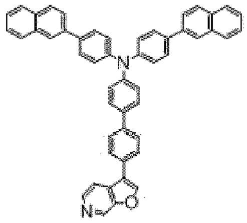 | 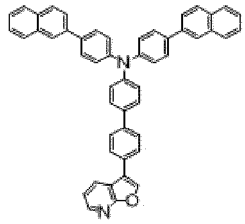 |
| **106** | **107** | **108** |
| 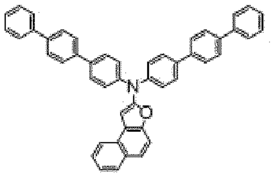 | 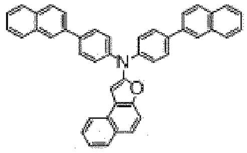 | 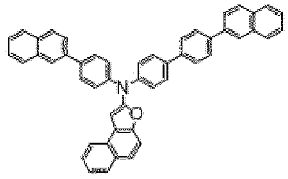 |
| **109** | **110** | **111** |
| 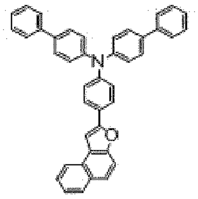 | 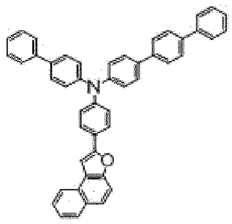 | 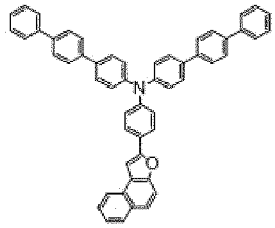 |
| **112** | **113** | **114** |
| 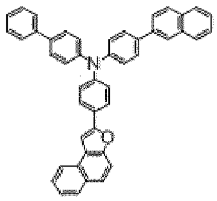 | 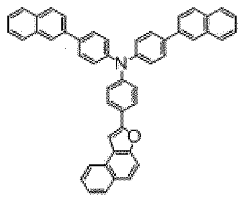 | 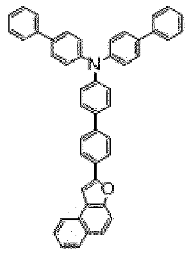 |
| **115** | **116** | **117** |
| 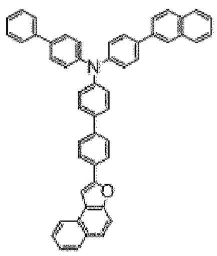 | 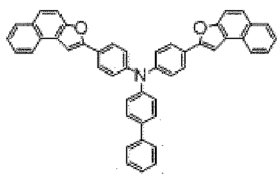 | 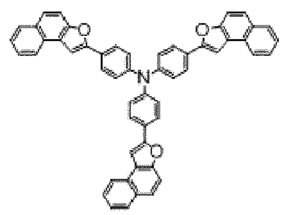 |
| **118** | **119** | **120** |

(continued)

| | | |
|---|---|---|
| 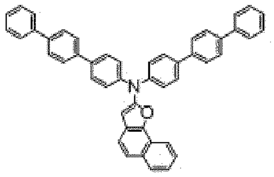 | 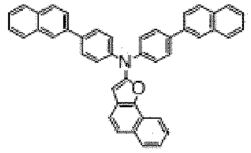 | 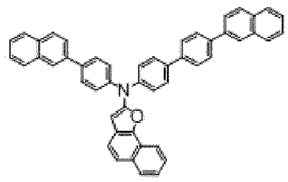 |
| **121** | **122** | **123** |
| 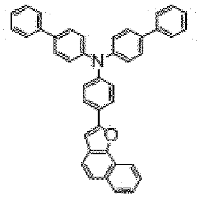 | 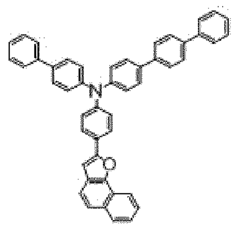 | 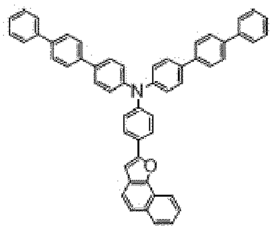 |
| **124** | **125** | **126** |
| 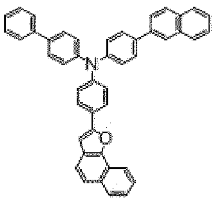 | 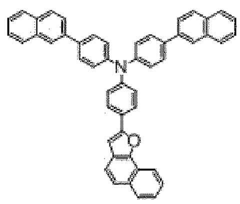 | 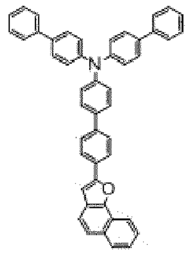 |
| **127** | **128** | **129** |
| 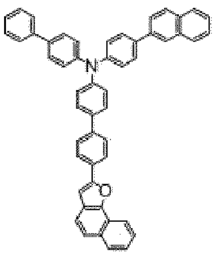 | 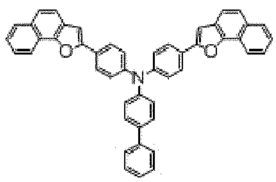 | 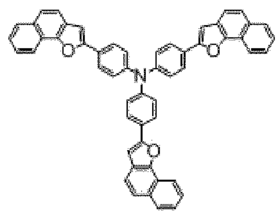 |
| **130** | **131** | **132** |
| 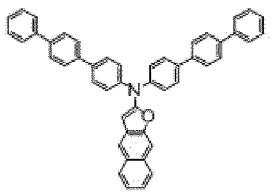 | 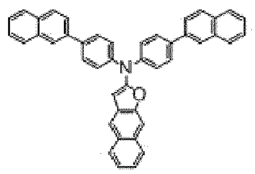 | 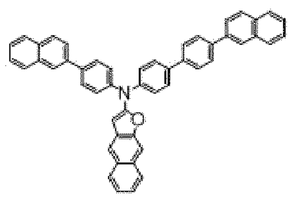 |
| **133** | **134** | **135** |

(continued)

| | | |
|---|---|---|
| 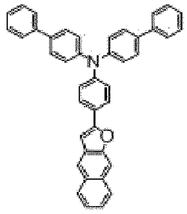 | 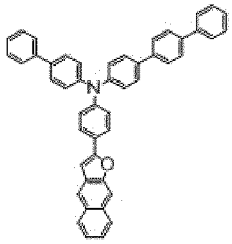 | 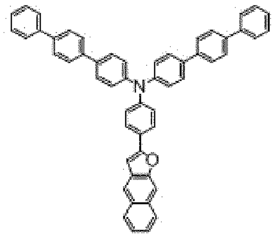 |
| **136** | **137** | **138** |
| 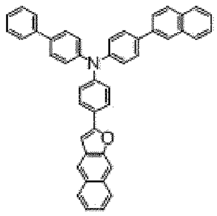 | 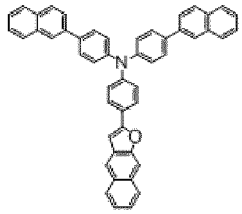 | 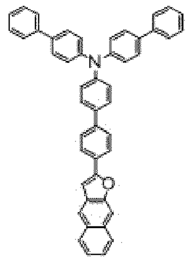 |
| **139** | **140** | **141** |
| 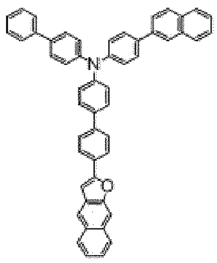 | 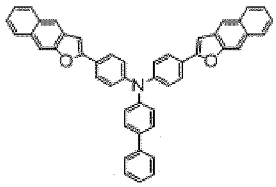 | 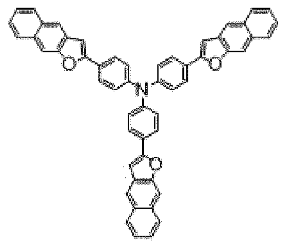 |
| **142** | **143** | **144** |
| 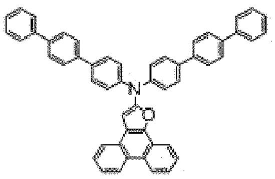 | 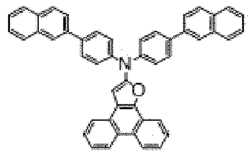 | 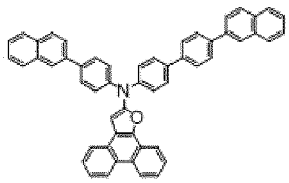 |
| **145** | **146** | **147** |
| 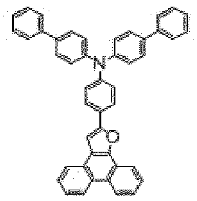 | 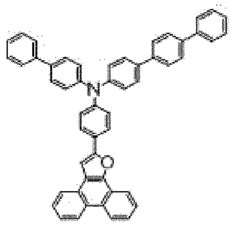 | 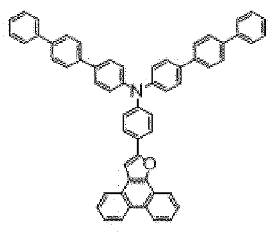 |
| **148** | **149** | **150** |

(continued)

| | | |
|---|---|---|
| 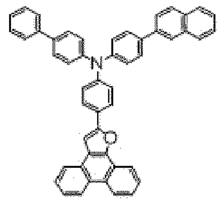 | 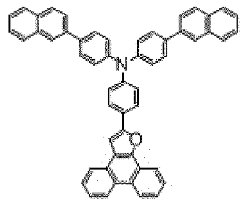 | 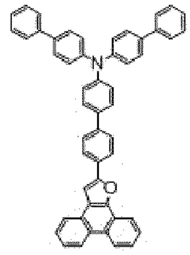 |
| **151** | **152** | **153** |
| 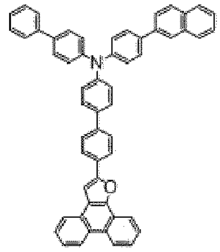 | 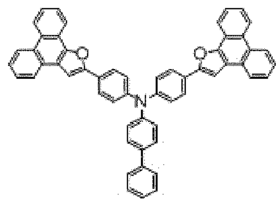 | 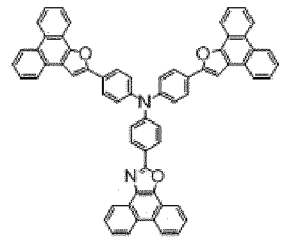 |
| **154** | **155** | **156** |
| 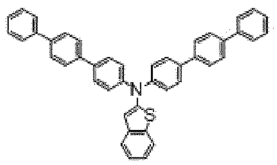 | 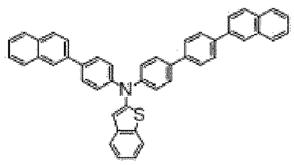 | 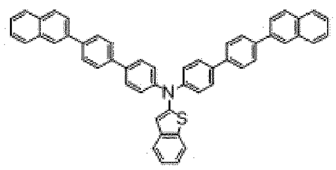 |
| **157** | **158** | **159** |
| 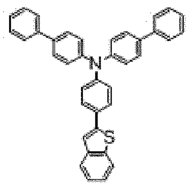 | 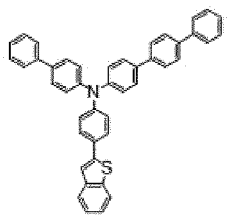 | 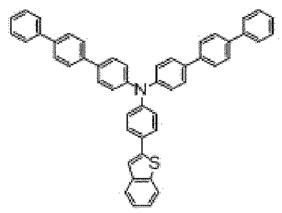 |
| **160** | **161** | **162** |
| 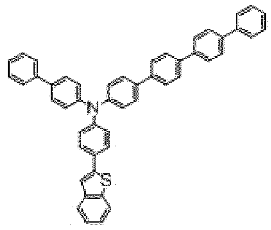 | 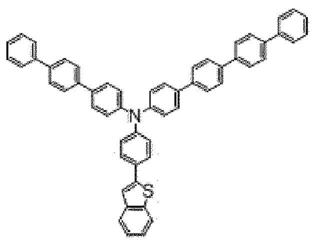 | 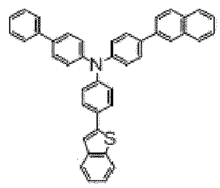 |
| **163** | **164** | **165** |

(continued)

| | | |
|---|---|---|
| 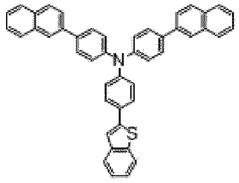 | 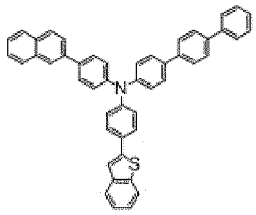 | 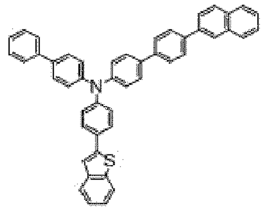 |
| **166** | **167** | **168** |
| 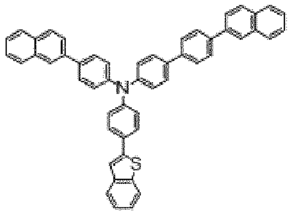 | 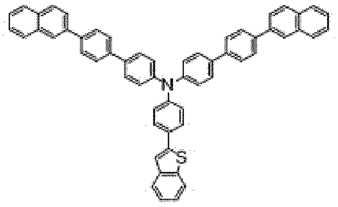 | 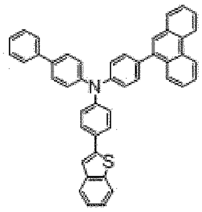 |
| **169** | **170** | **171** |
| 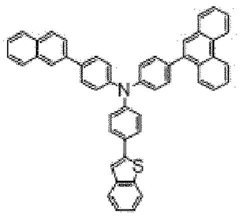 | 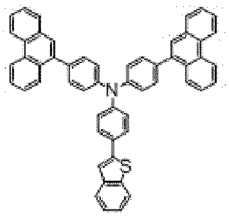 | 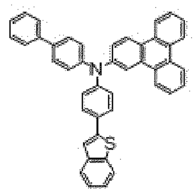 |
| **172** | **173** | **174** |
| 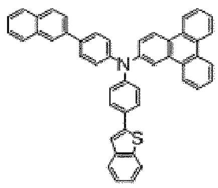 | 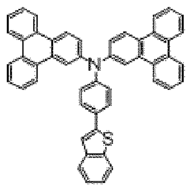 | 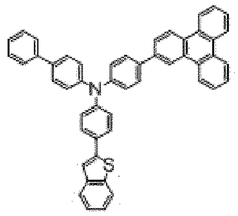 |
| **175** | **176** | **177** |
| 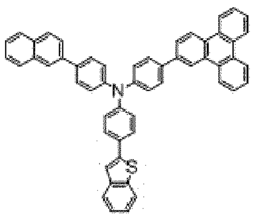 | 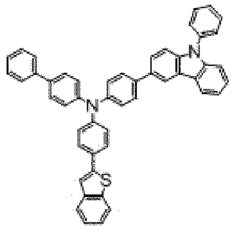 | 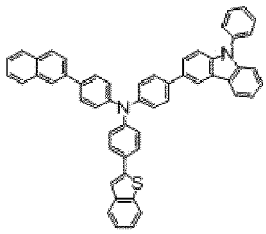 |
| **178** | **179** | **180** |
| 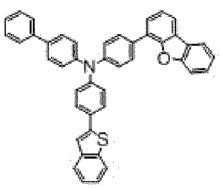 | 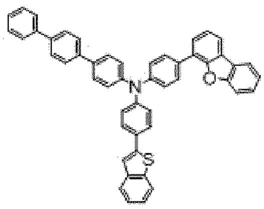 | 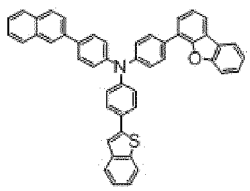 |

(continued)

| 181 | 182 | 183 |
|---|---|---|
| 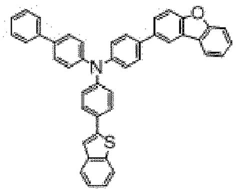 | 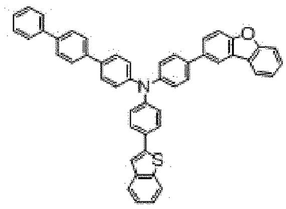 | 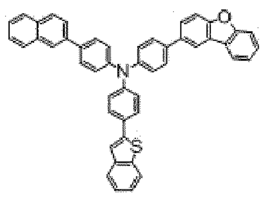 |
| 184 | 185 | 186 |
| 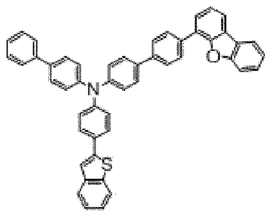 | 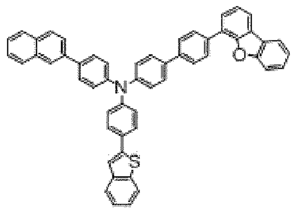 | 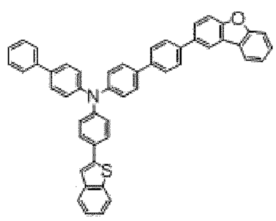 |
| 187 | 188 | 189 |
| 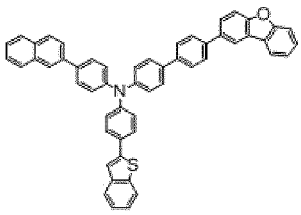 | 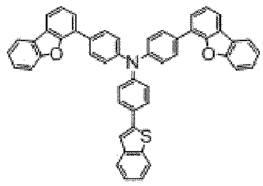 | 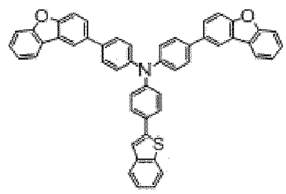 |
| 190 | 191 | 192 |
| 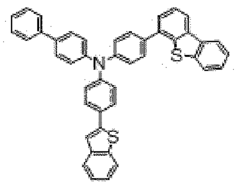 | 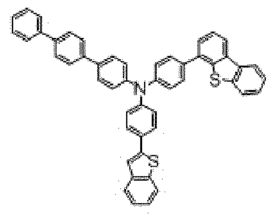 | 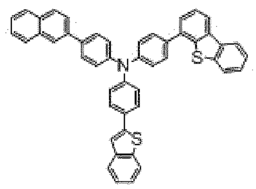 |
| 193 | 194 | 195 |
| 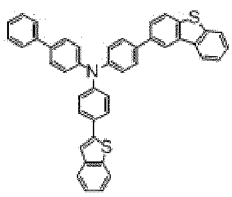 | 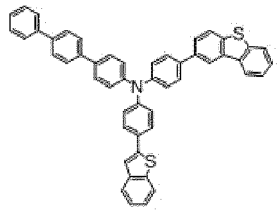 | 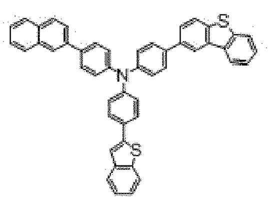 |
| 196 | 197 | 198 |

(continued)

| | | |
|---|---|---|
| 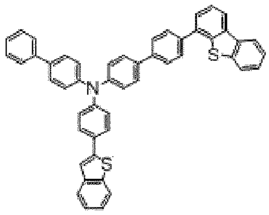 | 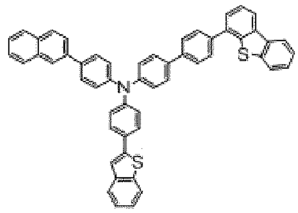 | 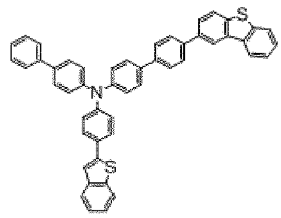 |
| **199** | **200** | **201** |
| 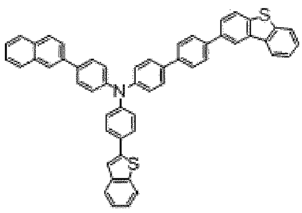 | 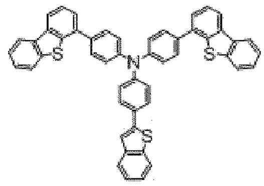 | 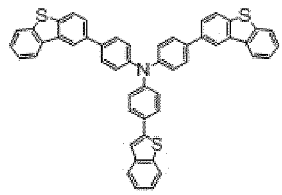 |
| **202** | **203** | **204** |
| 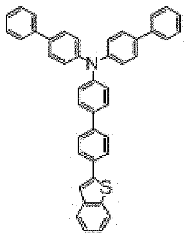 | 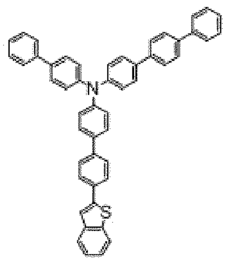 | 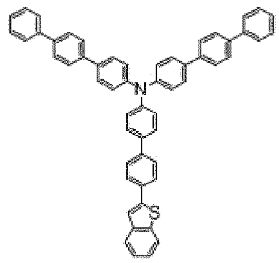 |
| **205** | **206** | **207** |
| 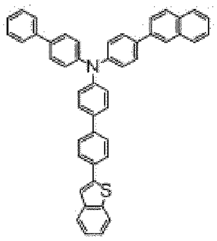 | 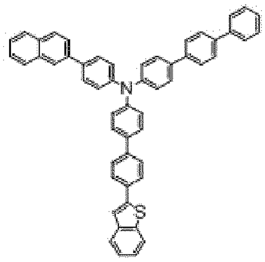 | 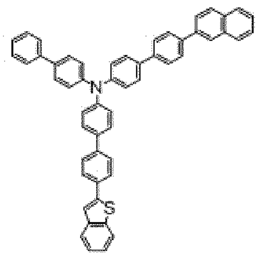 |
| **208** | **209** | **210** |
| 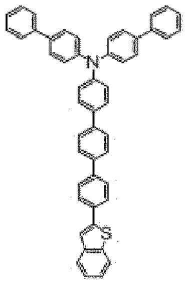 | 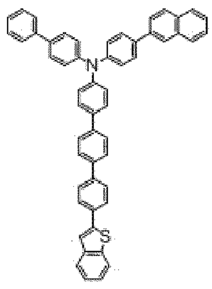 | 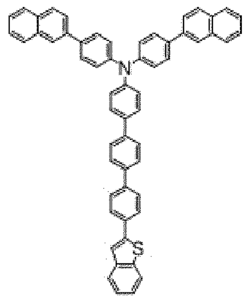 |
| **211** | **212** | **213** |

(continued)

| | | |
|---|---|---|
| 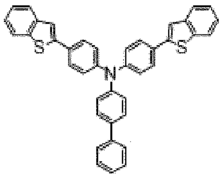 | 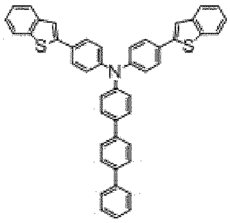 | 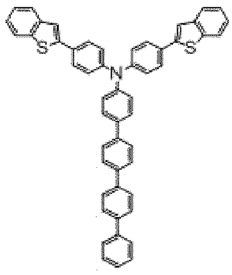 |
| **214** | **215** | **216** |
| 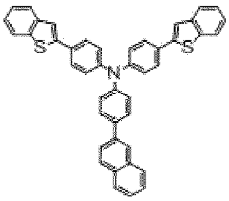 | 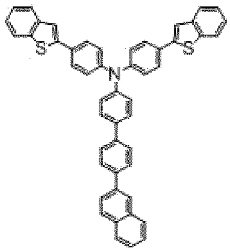 | 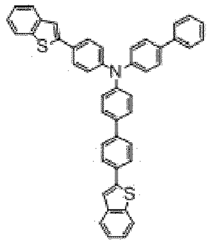 |
| **217** | **218** | **219** |
| 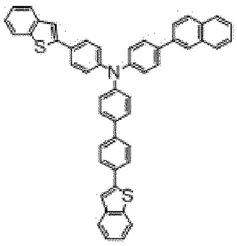 | 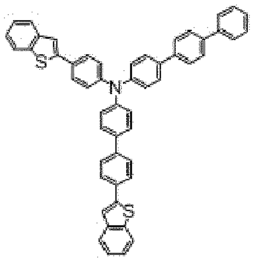 | 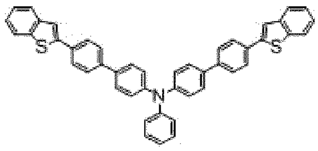 |
| **220** | **221** | **222** |
| 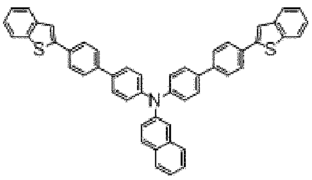 | 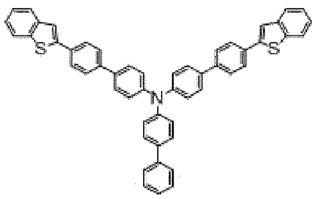 | 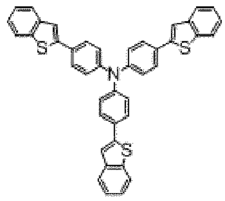 |
| **223** | **224** | **225** |
| 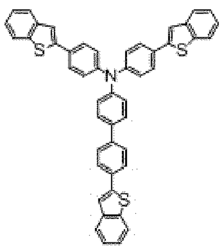 | 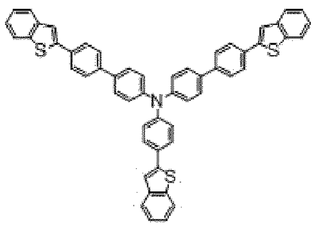 | 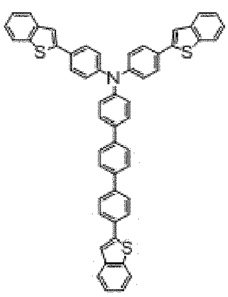 |
| **226** | **227** | **228** |

(continued)

| | | |
|---|---|---|
| 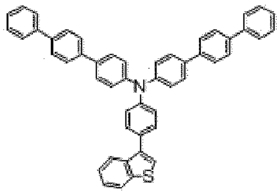 | 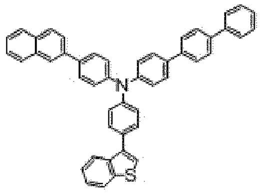 | 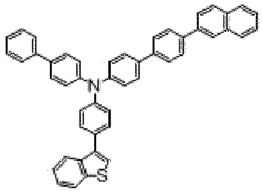 |
| **229** | **230** | **231** |
| 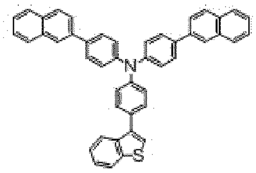 | 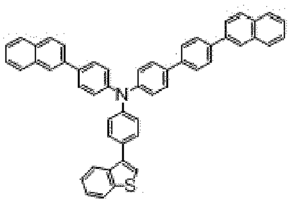 | 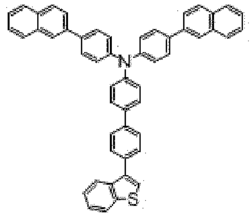 |
| **232** | **233** | **234** |
| 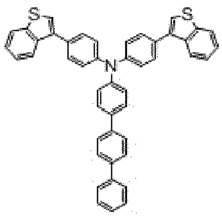 | 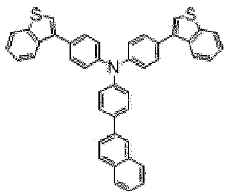 | 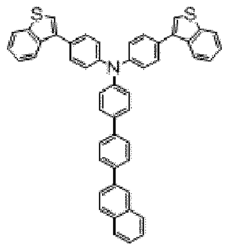 |
| **235** | **236** | **237** |
| 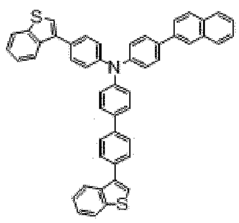 | 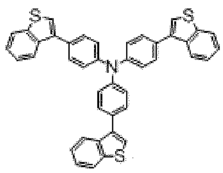 | 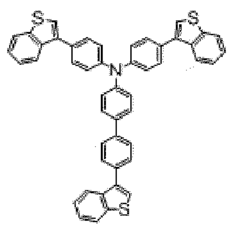 |
| **238** | **239** | **240** |
| 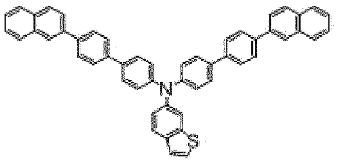 | 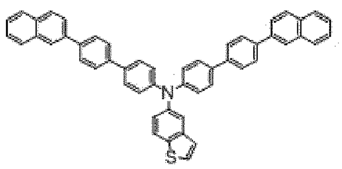 | 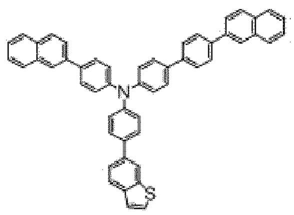 |
| **241** | **242** | **243** |

(continued)

| | | |
|---|---|---|
| 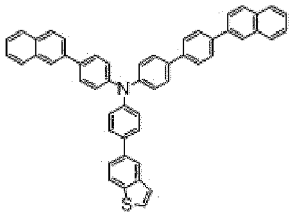 | 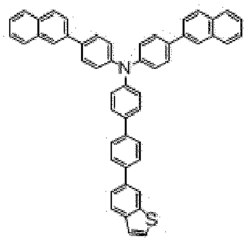 | 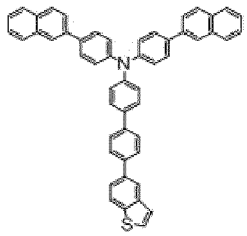 |
| **244** | **245** | **246** |
| 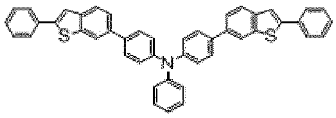 | 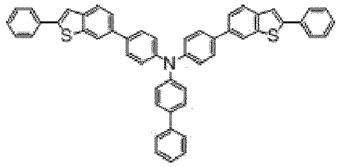 | 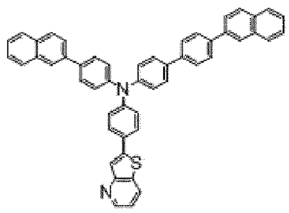 |
| **247** | **248** | **249** |
| 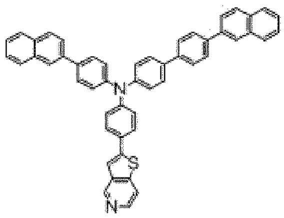 | 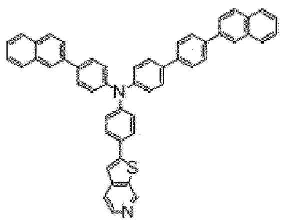 | 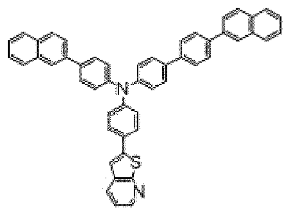 |
| **250** | **251** | **252** |
| 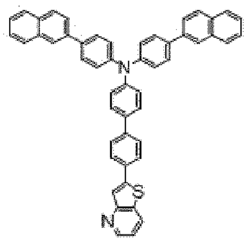 | 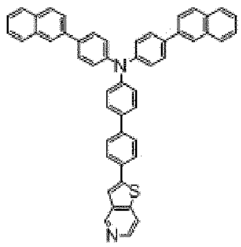 | 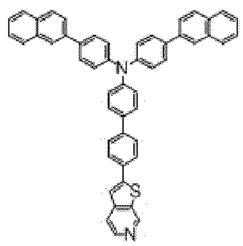 |
| **253** | **254** | **255** |
| 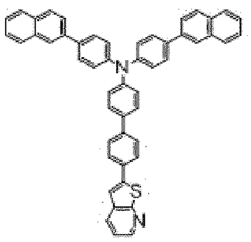 | 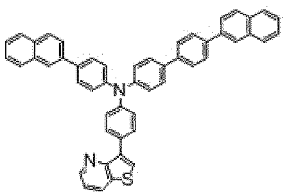 | 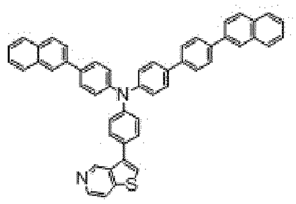 |
| **256** | **257** | **258** |

(continued)

| | | |
|---|---|---|
| 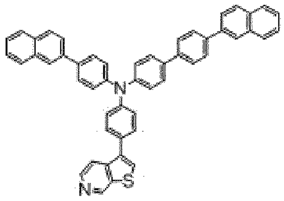 | 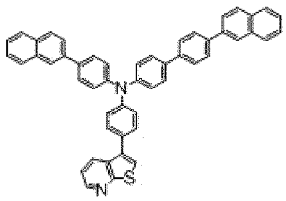 | 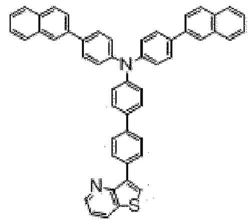 |
| **259** | **260** | **261** |
| 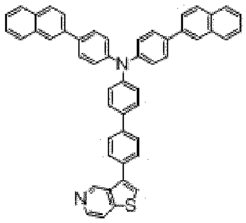 | 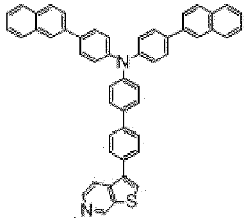 | 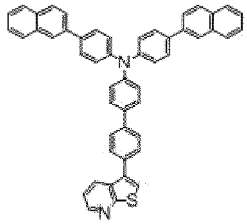 |
| **262** | **263** | **264** |
| 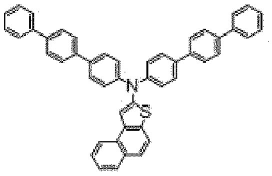 | 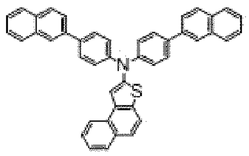 | 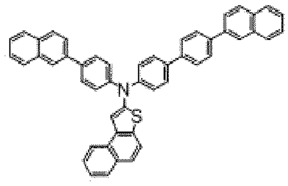 |
| **265** | **266** | **267** |
| 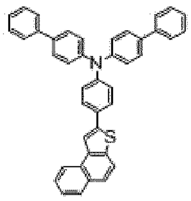 | 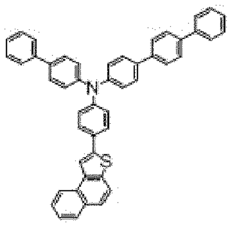 | 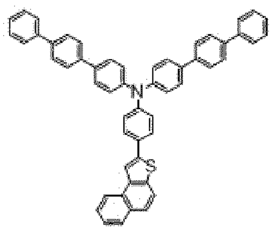 |
| **268** | **269** | **270** |
| 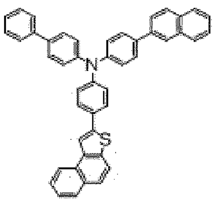 | 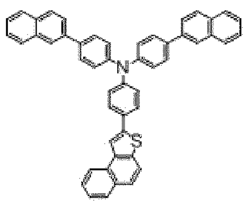 | 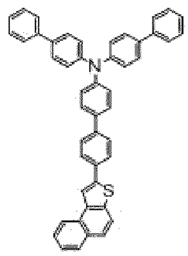 |
| **271** | **272** | **273** |

(continued)

| | | |
|---|---|---|
| 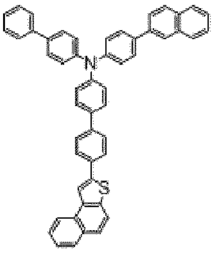 | 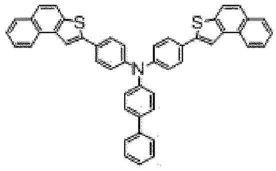 | 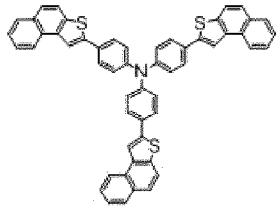 |
| **274** | **275** | **276** |
| 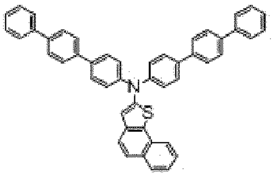 | 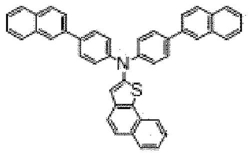 | 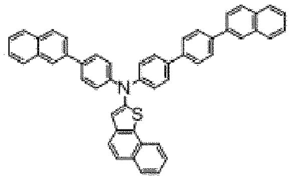 |
| **277** | **278** | **279** |
| 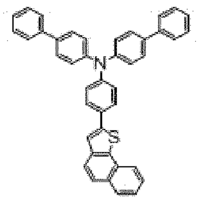 | 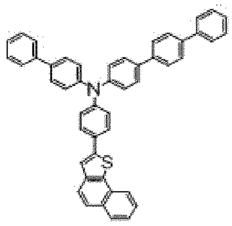 | 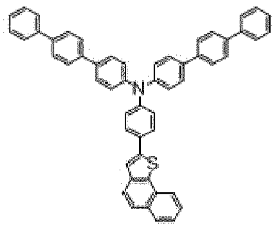 |
| **280** | **281** | **282** |
| 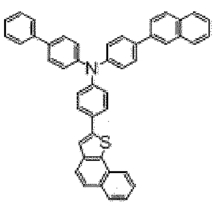 | 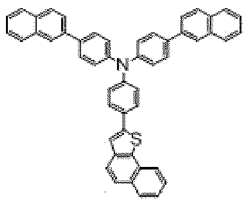 | 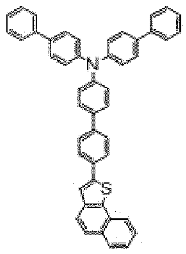 |
| **283** | **284** | **285** |
| 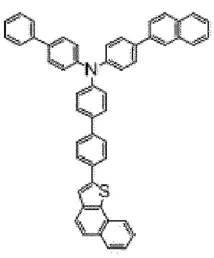 | 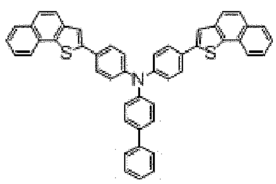 | 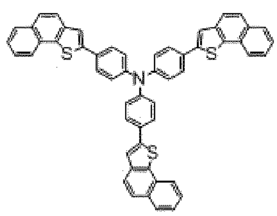 |
| **286** | **287** | **288** |

(continued)

| | | |
|---|---|---|
| 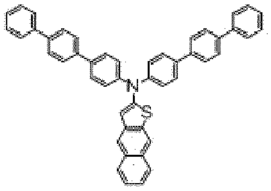 | 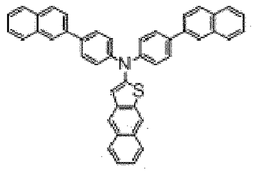 | 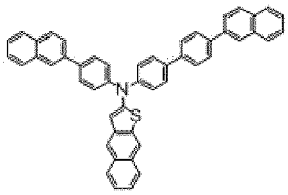 |
| **289** | **290** | **291** |
| 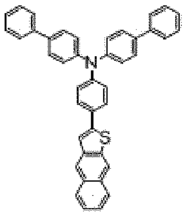 | 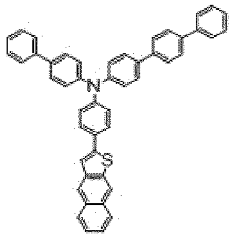 | 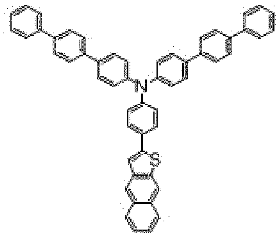 |
| **292** | **293** | **294** |
| 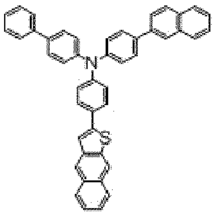 | 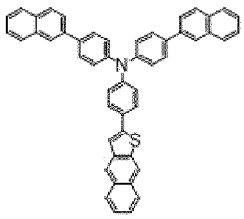 | 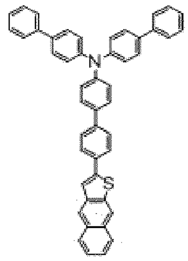 |
| **295** | **296** | **297** |
| 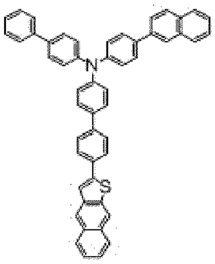 | 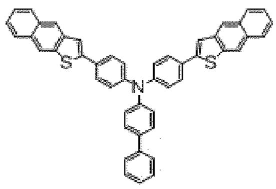 | 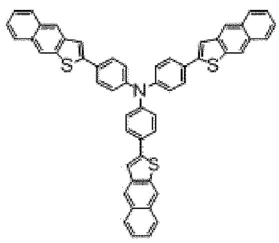 |
| **298** | **299** | **300** |
| 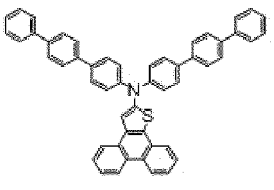 | 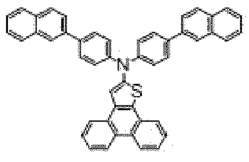 | 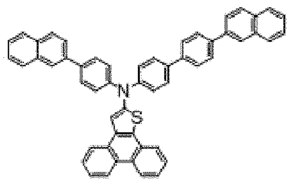 |
| **301** | **302** | **303** |

(continued)

| | | |
|---|---|---|
| 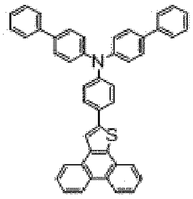 | 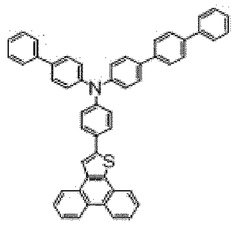 | 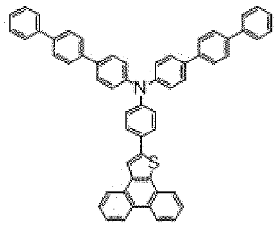 |
| 304 | 305 | 306 |
| 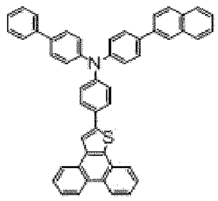 | 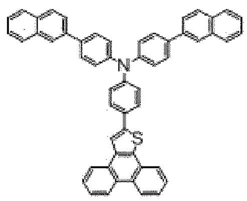 | 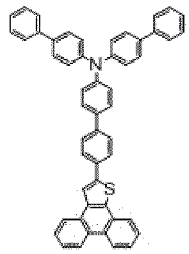 |
| 307 | 308 | 309 |
| 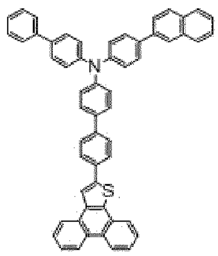 | 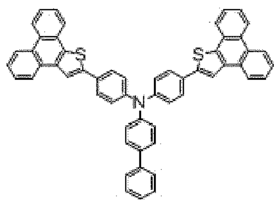 | 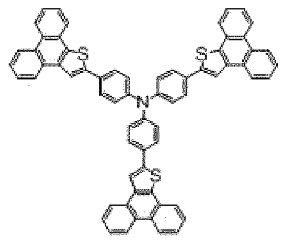 |
| 310 | 311 | 312 |
| 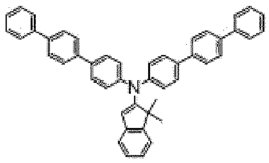 | 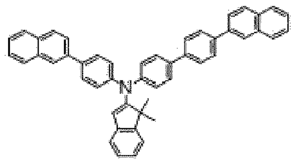 | 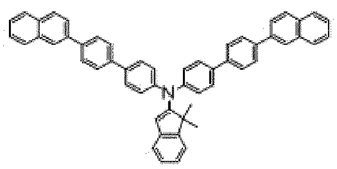 |
| 313 | 314 | 315 |
| 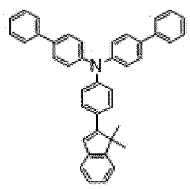 | 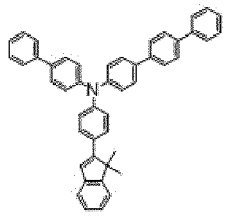 | 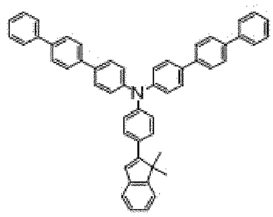 |
| 316 | 317 | 318 |

(continued)

| | | |
|---|---|---|
| 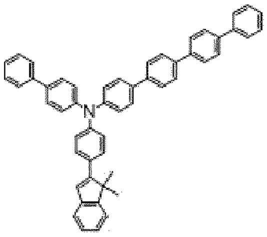 | 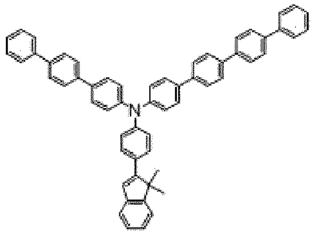 | 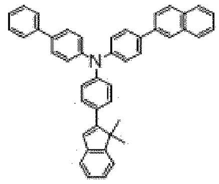 |
| **319** | **320** | **321** |
| 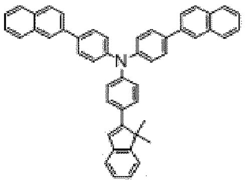 | 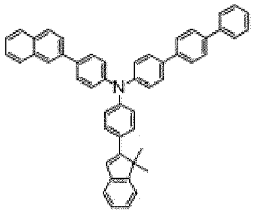 | 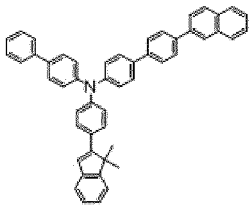 |
| **322** | **323** | **324** |
| 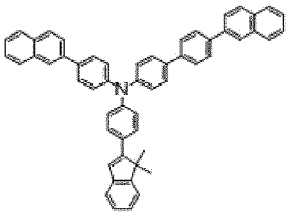 | 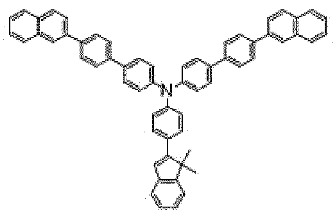 | 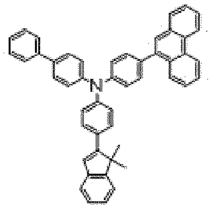 |
| **325** | **326** | **327** |
| 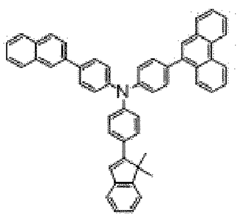 | 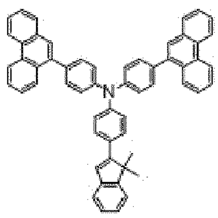 | 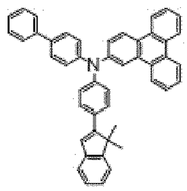 |
| **328** | **329** | **330** |
| 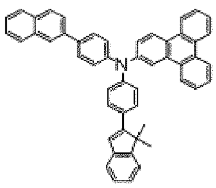 | 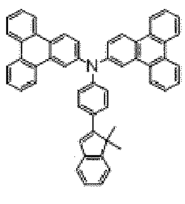 | 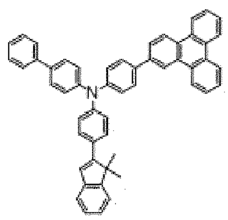 |
| **331** | **332** | **333** |

(continued)

| | | |
|---|---|---|
| 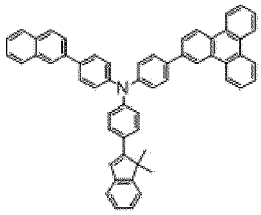 | 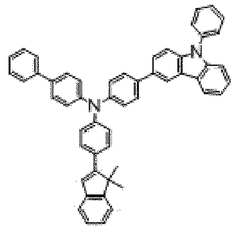 | 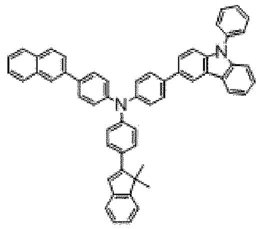 |
| **334** | **335** | **336** |
| 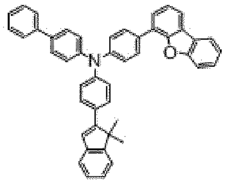 | 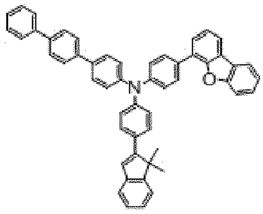 | 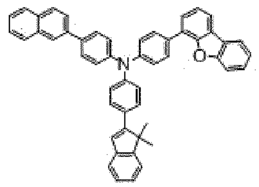 |
| **337** | **338** | **339** |
| 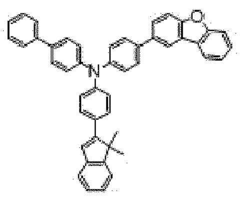 | 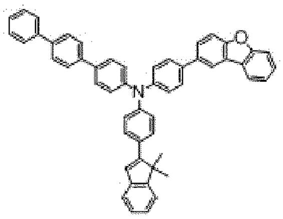 | 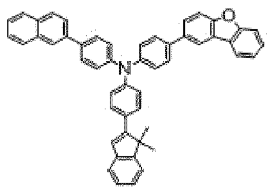 |
| **340** | **341** | **342** |
| 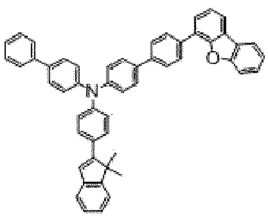 | 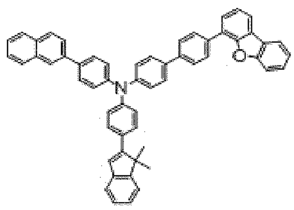 | 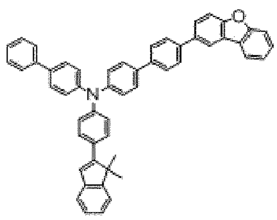 |
| **343** | **344** | **345** |
| 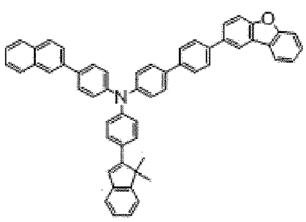 | 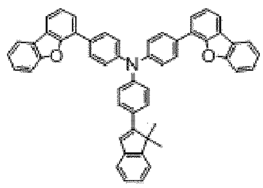 | 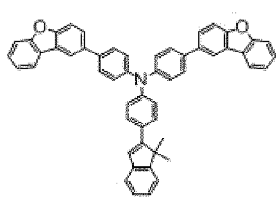 |
| **346** | **347** | **348** |
| 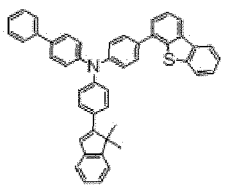 | 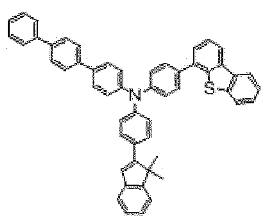 | 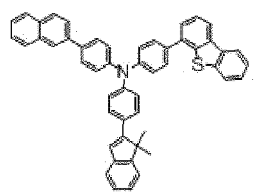 |

(continued)

| 349 | 350 | 351 |
|---|---|---|
| 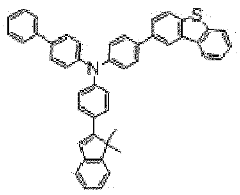 | 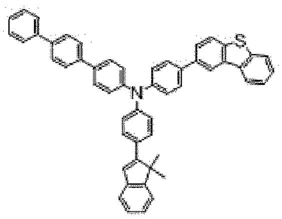 | 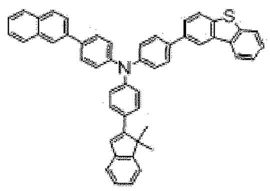 |
| **352** | **353** | **354** |
| 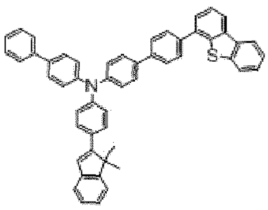 | 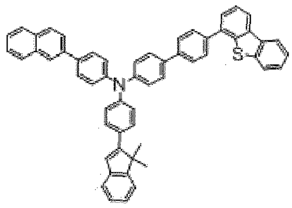 | 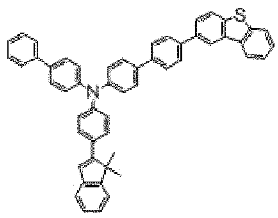 |
| **355** | **356** | **357** |
| 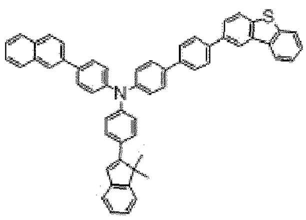 | 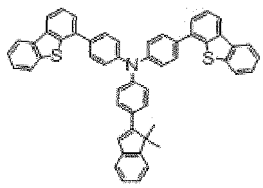 | 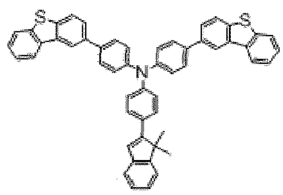 |
| **358** | **359** | **360** |
| 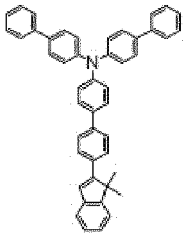 | 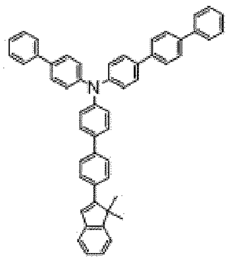 | 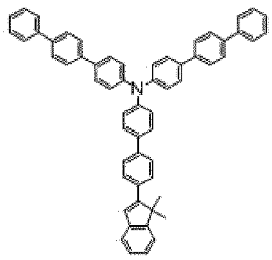 |
| **361** | **362** | **363** |
| 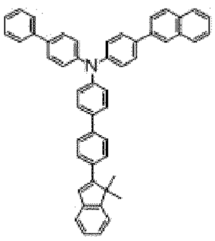 | 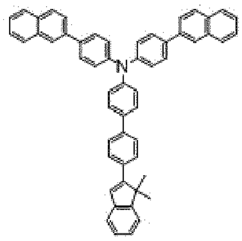 | 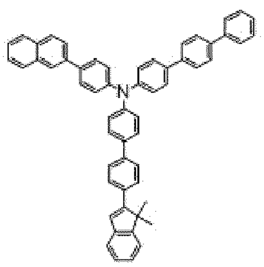 |
| **364** | **365** | **366** |

(continued)

| | | |
|---|---|---|
| 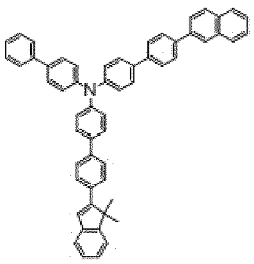 | 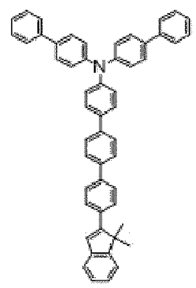 | 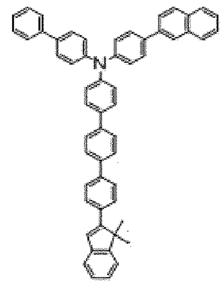 |
| **367** | **368** | **369** |
| 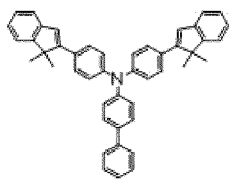 | 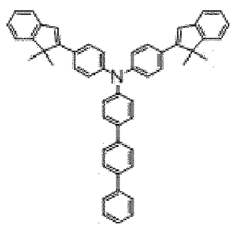 | 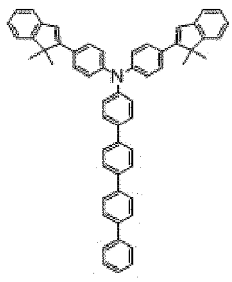 |
| **370** | **371** | **372** |
| 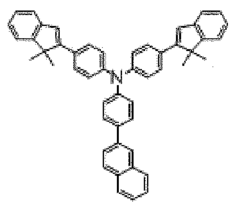 | 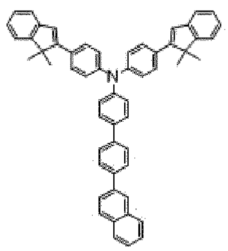 | 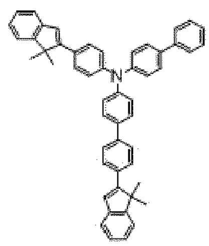 |
| **373** | **374** | **375** |
| 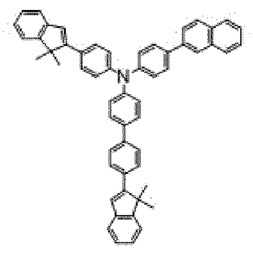 | 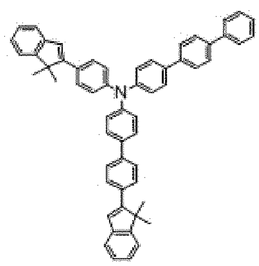 | 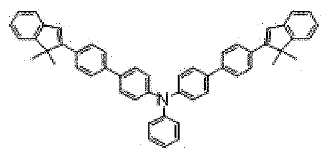 |
| **376** | **377** | **378** |
| 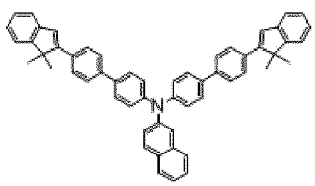 | 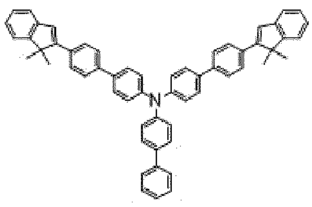 | 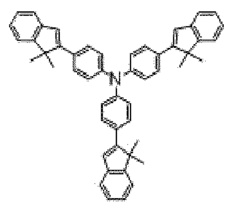 |
| **379** | **380** | **381** |

(continued)

| | | |
|---|---|---|
| 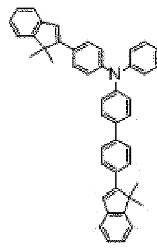 | 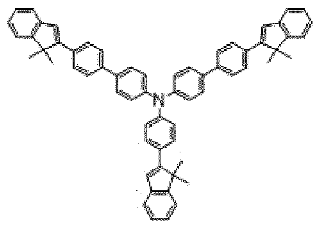 | 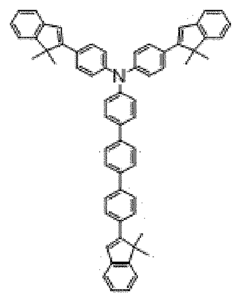 |
| 382 | 383 | 384 |
| 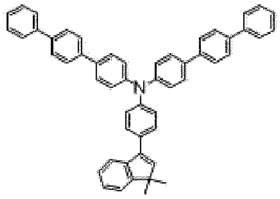 | 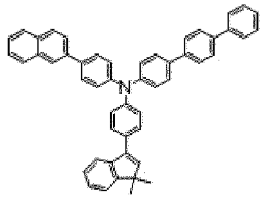 | 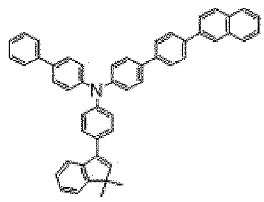 |
| 385 | 386 | 387 |
| 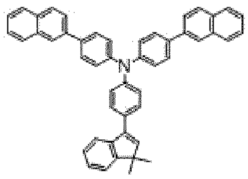 | 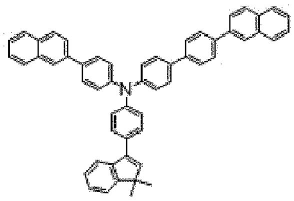 | 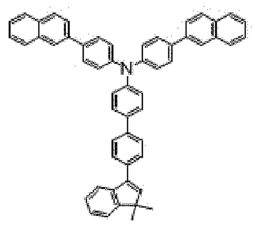 |
| 388 | 389 | 390 |
| 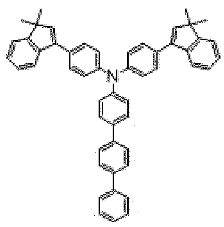 | 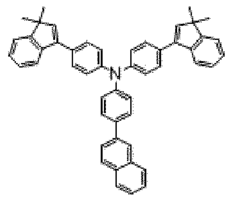 | 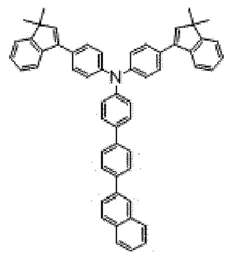 |
| 391 | 392 | 393 |
| 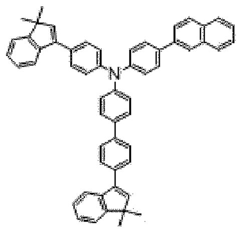 | 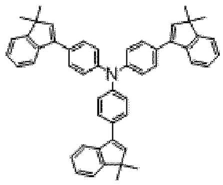 | 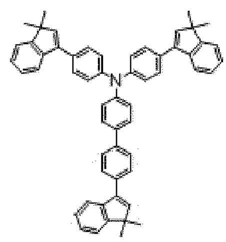 |
| 394 | 395 | 396 |

(continued)

| | | |
|---|---|---|
| 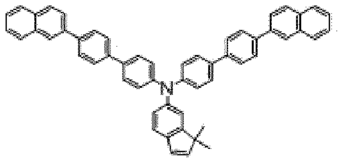 | 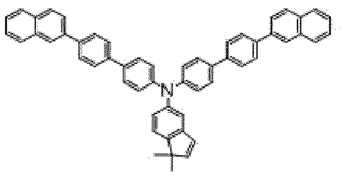 | 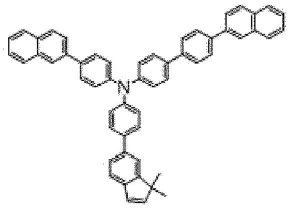 |
| **397** | **398** | **399** |
| 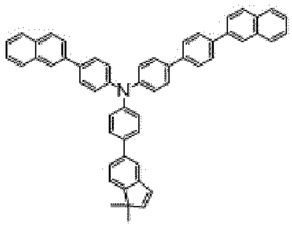 | 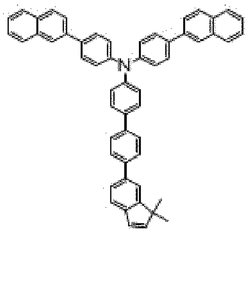 | 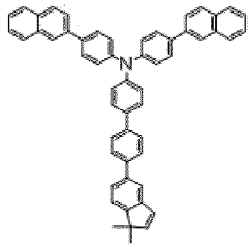 |
| **400** | **401** | **402** |
| 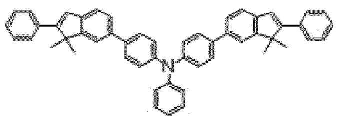 | 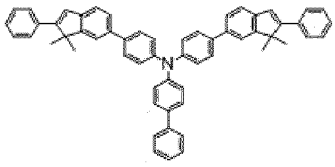 | 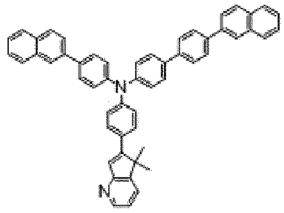 |
| **403** | **404** | **405** |
| 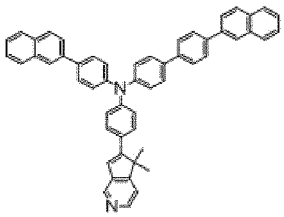 | 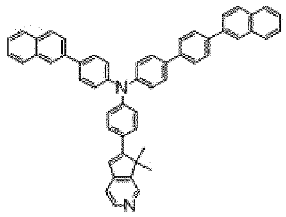 | 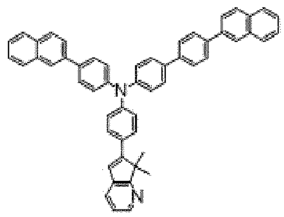 |
| **406** | **407** | **408** |
| 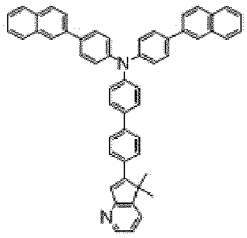 | 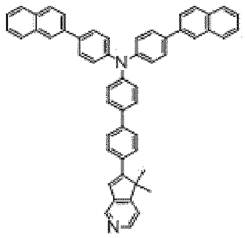 | 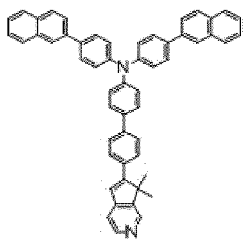 |
| **409** | **410** | **411** |

(continued)

| | | |
|---|---|---|
| 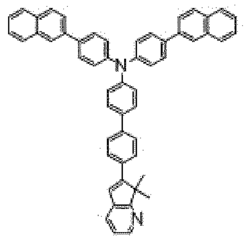 | 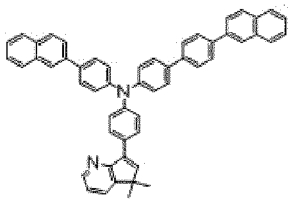 | 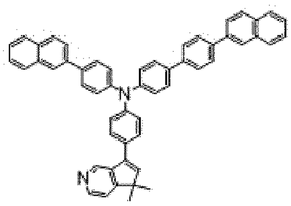 |
| **412** | **413** | **414** |
| 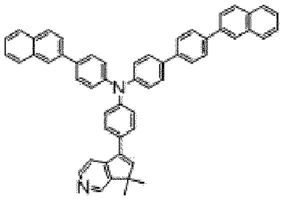 | 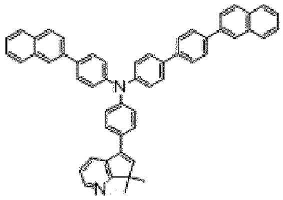 | 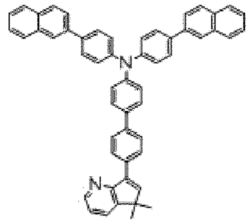 |
| **415** | **416** | **417** |
| 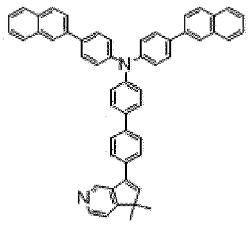 | 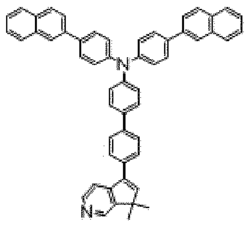 | 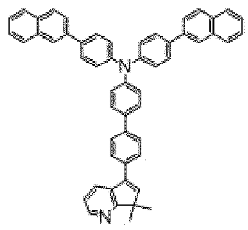 |
| **418** | **419** | **420** |
| 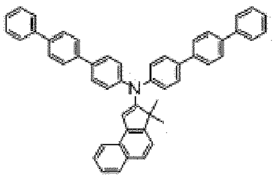 | 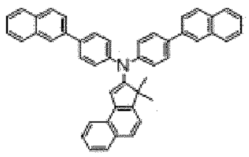 | 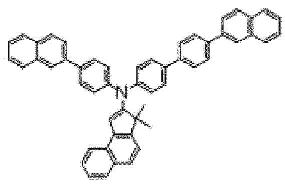 |
| **421** | **422** | **423** |
| 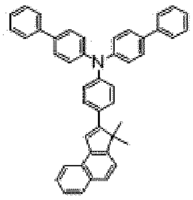 | 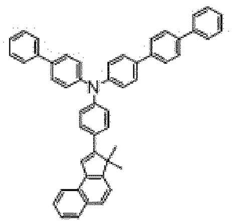 | 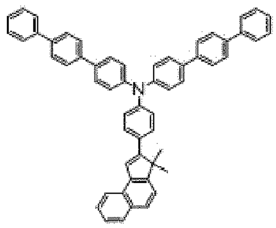 |
| **424** | **425** | **426** |

(continued)

| | | |
|---|---|---|
| 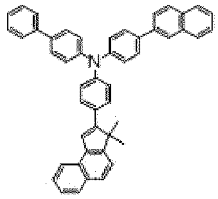 | 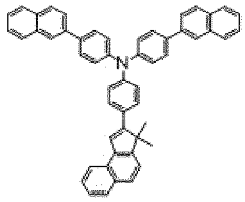 | 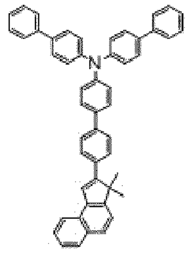 |
| **427** | **428** | **429** |
| 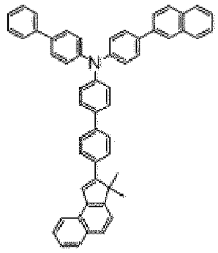 | 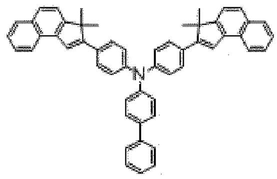 | 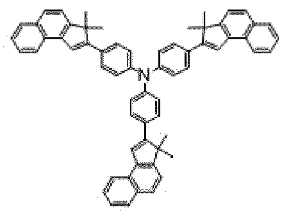 |
| **430** | **431** | **432** |
| 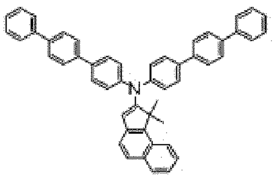 | 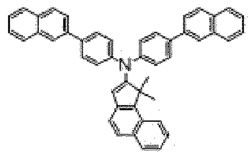 | 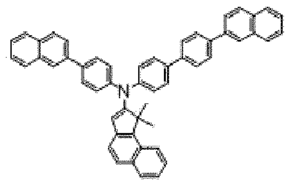 |
| **433** | **434** | **435** |
| 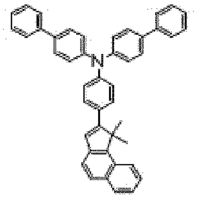 | 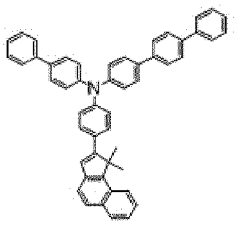 | 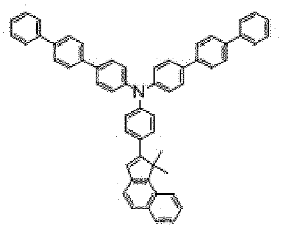 |
| **436** | **437** | **438** |
| 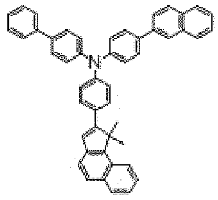 | 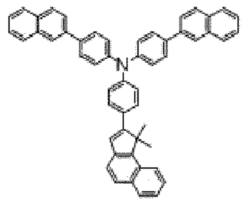 | 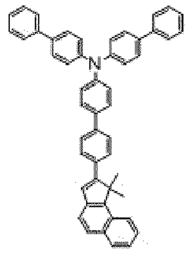 |
| **439** | **440** | **441** |

(continued)

| | | |
|---|---|---|
| 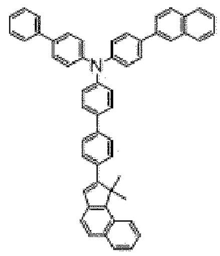 | 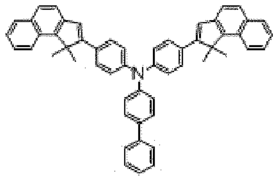 | 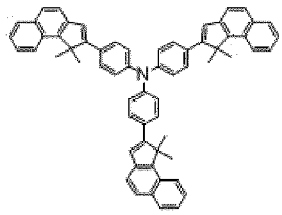 |
| 442 | 443 | 444 |
| 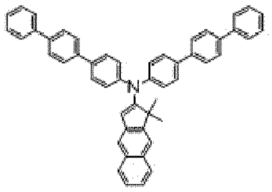 | 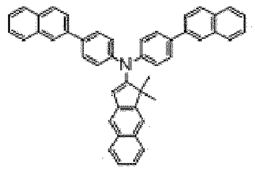 | 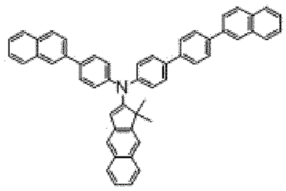 |
| 445 | 446 | 447 |
| 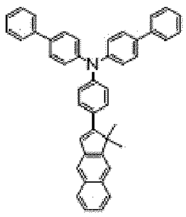 | 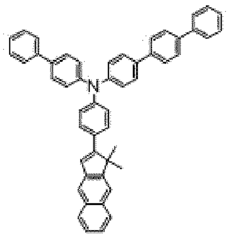 | 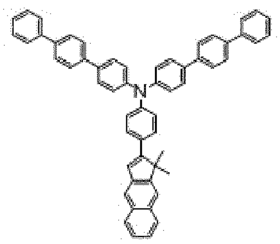 |
| 448 | 449 | 450 |
| 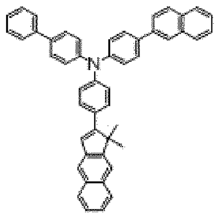 | 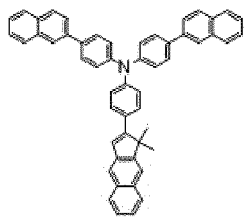 | 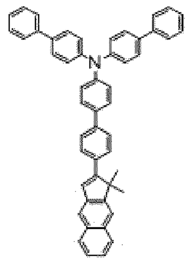 |
| 451 | 452 | 453 |
| 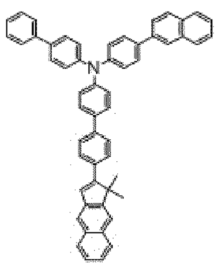 | 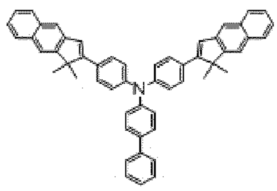 | 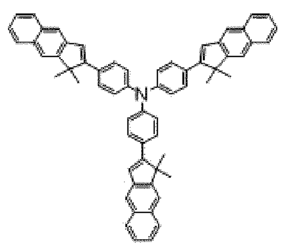 |
| 454 | 455 | 456 |

(continued)

| | | |
|---|---|---|
| 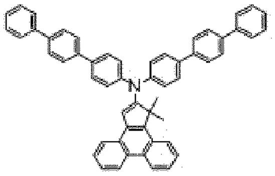 | 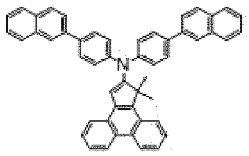 | 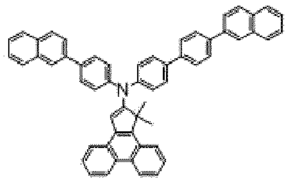 |
| **457** | **458** | **459** |
| 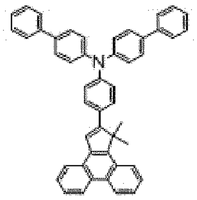 | 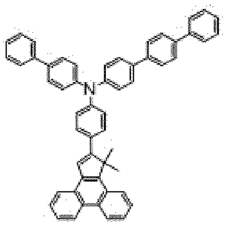 | 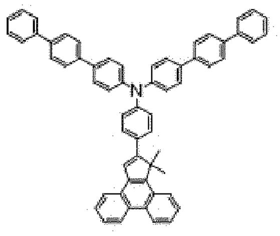 |
| **460** | **461** | **462** |
| 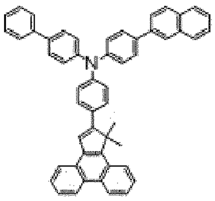 | 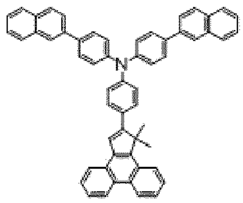 | 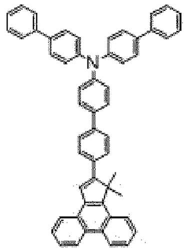 |
| **463** | **464** | **465** |
| 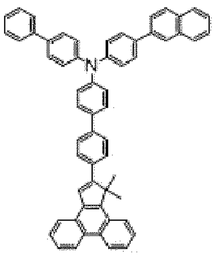 | 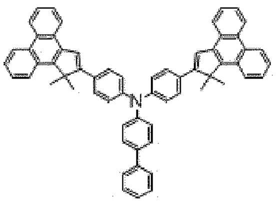 | 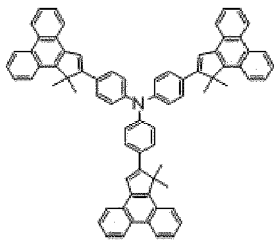 |
| **466** | **467** | **468** |
| 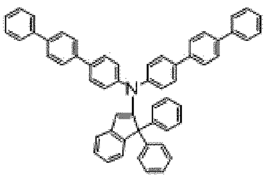 | 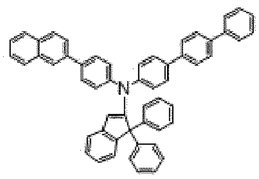 | 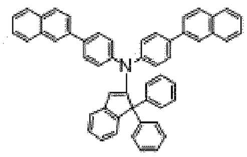 |
| **469** | **470** | **471** |

(continued)

| | | |
|---|---|---|
| 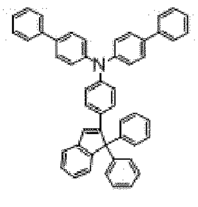 | 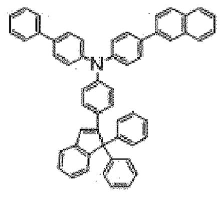 | 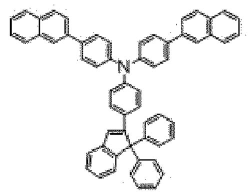 |
| 472 | 473 | 474 |
| 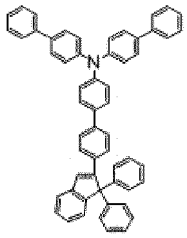 | 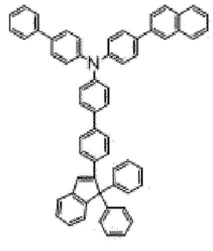 | 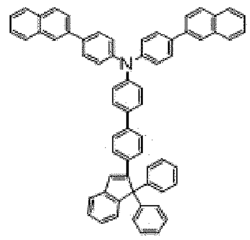 |
| 475 | 476 | 477 |
| 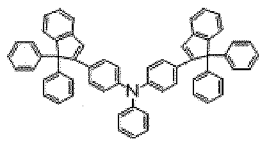 | 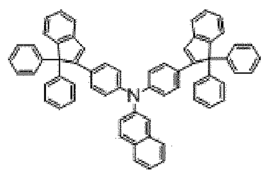 | 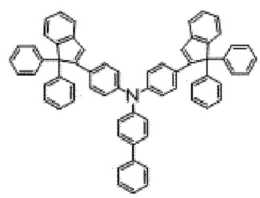 |
| 478 | 479 | 480 |
| 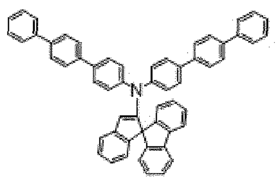 | 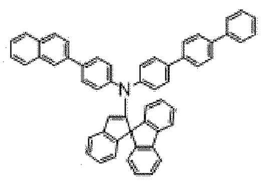 | 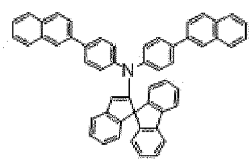 |
| 481 | 482 | 483 |
| 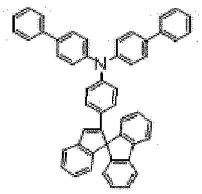 | 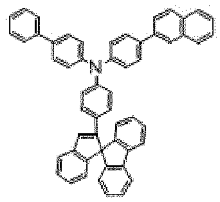 | 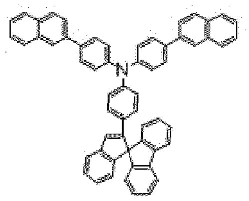 |
| 484 | 485 | 486 |

(continued)

| | | |
|---|---|---|
| 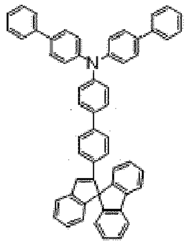 | 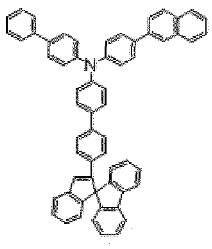 | 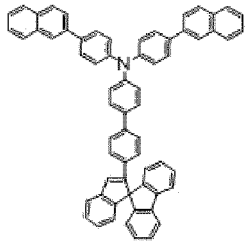 |
| **487** | **488** | **489** |
| 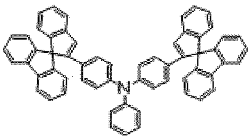 | 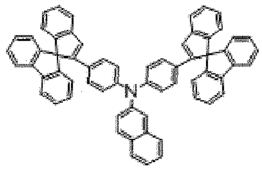 | 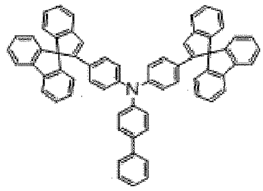 |
| **490** | **491** | **492** |
| 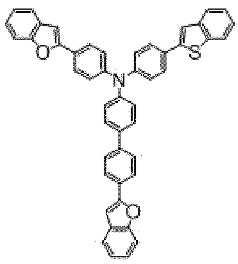 | 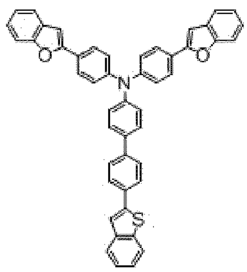 | 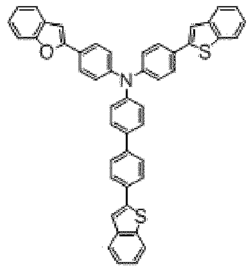 |
| **493** | **494** | **495** |
| 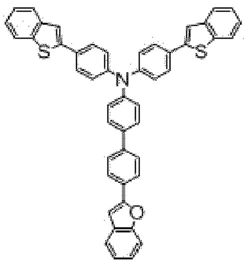 | 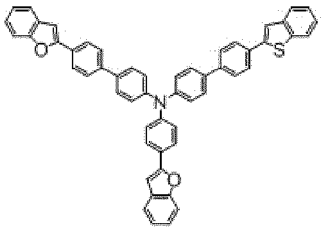 | 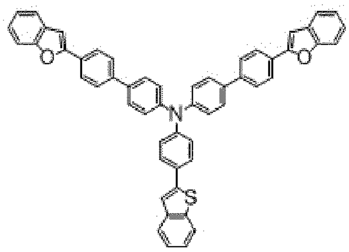 |
| **496** | **497** | **498** |
| 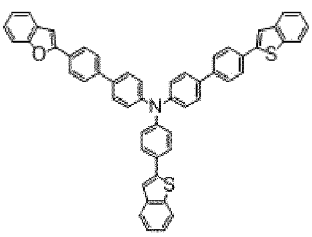 | 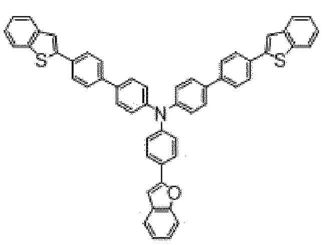 | 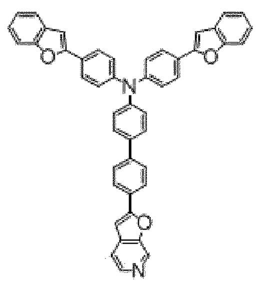 |
| **499** | **500** | **501** |

(continued)

| | | |
|---|---|---|
| 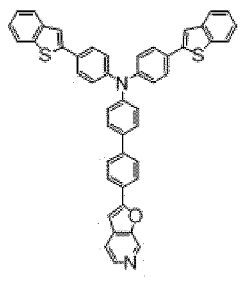 | 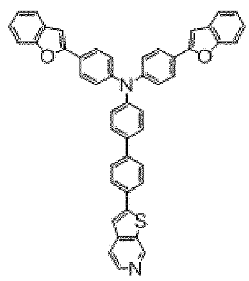 | 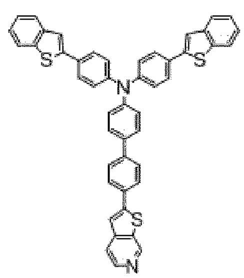 |
| **502** | **503** | **504** |

An embodiment of the capping layer compound of the present invention may be synthesized by an amination reaction, and a schematic synthesis reaction scheme is as follows. The following reaction scheme exemplifies the case of having two fused rings in which no N atoms are present, but the present invention is not limited thereto. In the fused rings, one or more N atoms may be present. In addition, the compound can be synthesized through the following reaction scheme in the case where three or more rings are fused.

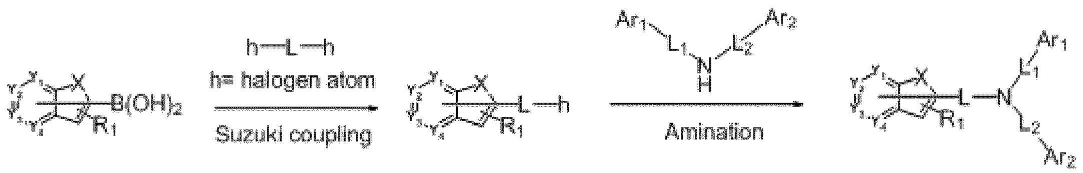


According to one embodiment of the present invention, an organic light emitting device include a first electrode, a second electrode, an organic material layer interposed between the first electrode and the second electrode, and the capping layer disposed on an outer surface of either the first electrode or the second electrode.

Specifically, the capping layer may have a thickness of 300 to 1000 Å.

In addition, the capping layer may have a refractive index of 2.50 or higher at a 450 nm wavelength, an extinction coefficient (k) at a 450 nm wavelength of 0.30 or less, specifically 0.10 or less. The capping layer may have an extinction coefficient (k) at a 380 nm wavelength of 0.90 or more, preferably 1.00 or more.

Here, among both surfaces of the first electrode or the second electrode, the surface adjacent to the organic material layer interposed between the first electrode and the second electrode is referred to as the inner surface, and a surface not adjacent to the organic material layer is referred to as an outer surface. That is, when the capping layer is disposed on the outer surface of the first electrode, the first electrode is interposed between the capping layer and the organic material layer, while when the capping layer is disposed on the outer surface of the second electrode, the second electrode is interposed between the capping layer and the organic material layer.

According to one embodiment of the present disclosure, the organic light emitting device may include one or more various organic material layers disposed between the first electrode and the second electrode. The capping layer may be formed on an outer surface of at least one of the first and the second electrode. That is, the capping layer may be formed on both the outer surface of the first electrode and the outer surface of the second electrode or may be formed only on the outer surface of the first electrode or the outer surface of the second electrode.

In addition, the capping layer may contain the capping layer compound according to the present invention. The capping layer may contain only one compound or contain two or more compounds, selected from among the capping layer compounds of the present invention. The capping layer compound(s) may be used in combination with a known compound.

Meanwhile, the organic material layer may generally include a hole transport layer, a light emitting layer, and an electron transport layer constituting the light emitting unit but may not be limited thereto.

More specifically, the organic light emitting device, according to an embodiment of the present disclosure, may include one or more organic material layers such as a hole injection layer (HIL), a hole transport layer (HTL), and a light emitting layer (HTL), an electron transport layer (ETL), and an electron injection layer (EIL) that constitute a light emitting unit between the first electrode (i.e., anode) and the second electrode (i.e., cathode).

FIG. 1 is a cross-sectional view schematically illustrating an organic light emitting device according to an embodiment of the present disclosure. The organic light emitting device, according to the exemplary embodiment of the

present disclosure, may be prepared as illustrated in FIG. 1.

Referring to FIG. 1, the organic light emitting device includes a substrate 100, a first electrode 1000, a hole injection layer 200, a hole transport layer 300, a light emitting layer 400, an electron transport layer 500, an electron injection layer 600, a second electrode 2000, and a capping layer 3000 that are stacked in this order from the bottom.

The substrate 100 may use a substrate commonly used in organic light emitting devices, and in particular, it may be a transparent glass substrate or a flexible plastic substrate having excellent mechanical strength, thermal stability, transparency, surface smoothness, ease of handling, and waterproof properties.

The first electrode 1000 is used as a hole injection electrode for injecting holes in the organic light emitting device. The first electrode 1000 is made of a material having a low work function to enable hole injection. Specifically, the first electrode 1000 is made of a transparent material such as indium tin oxide (ITO), indium zinc oxide (IZO), or graphene.

The hole injection layer 200 may be formed by depositing a hole injection layer material on an upper part of the first electrode 1000 by a vacuum deposition method, a spin coating method, a casting method, a Langmuir-Blodget (LB) method, or the like. When the hole injection layer 200 is formed by a vacuum deposition method, the deposition conditions vary depending on the compound used as a material of the hole injection layer 200, the structure and thermal characteristics of the desired hole injection layer 200, and the like. However, in general, the conditions are appropriately set to fall within a temperature range of 50°C to 500°C, a vacuum degree range of 10-8 to 10-3 torr, a deposition rate range of 0.01 to 100 Å/sec, and a layer thickness range of 10 Å to 5 μm. In addition, an electron generating layer may be optionally deposited on the surface of the hole injection layer 200 if necessary. A conventional material may be used as the material for the electron generating layer. For example, HATCN may be used.

Next, the hole transport layer 300 may be formed by depositing a hole transport layer material on the hole injection layer 200 by a using a vacuum deposition method, a spin coating method, a casting method, a LB method, or the like. When the hole transport layer 300 is formed by the vacuum deposition method, the deposition condition may vary depending on the compound to be used but may be generally selected within almost the same condition range as the hole injection layer 200 is formed. The hole transport layer 300 may be formed using a known compound. The hole transport layer 300 may have one or more layers, and although not illustrated in FIG. 1, a light emitting auxiliary layer may be additionally formed on the hole transport layer 300.

The light emitting layer 400 may be formed by depositing a light emitting layer material on the hole transport layer 300 or the light emitting auxiliary layer by a method such as a vacuum deposition method, a spin coating method, a casting method, an LB method, or the like. When the emission layer 400 is formed by the vacuum deposition method, the deposition condition may vary depending on the compound to be used. However, the conditions may be selected from the same ranges described in connection with the hole injection layer 200. As the light emitting material, a known compound may be used as a host or a dopant.

On the other hand, when a phosphorescent dopant is used together for the light emitting material, a hole blocking material (HBL) may be deposited on the light emitting layer 400 by a vacuum deposition method or a spin coating method to prevent triplet excitons or holes from diffusing into the electron transport layer 500. The hole blocking material that can be used is not particularly limited, and an arbitrary existing material may be selected and used. Examples of the hole blocking material include oxadiazole derivatives, triazole derivatives, phenanthroline derivatives, and hole blocking materials described in Japanese Patent Application Publication No. H11-329734(A1). Representatively, Balq(bis(8-hyde) hydroxy-2-methylquinolinolnato)-aluminum biphenoxide), phenanthrolines-based compounds (for example, bathocuproine (BCP) available from UDC) may be used. The light emitting layer 400 of the present invention may include at least one blue light emitting layer.

The electron transport layer 500 is formed on the light emitting layer 400 by a vacuum deposition method, a spin coating method, a casting method, or the like. The deposition conditions for the electron transport layer 500 vary depending on the compound used. However, the conditions may be selected from the same ranges described in connection with the hole injection layer 200.

The electron injection layer 600 may be formed by depositing an electron injection layer material on the electron transport layer 500. It may be formed by a vacuum deposition method, a spin coating method, a casting method, or the like.

The organic material layers such as the hole injection layer 200, the hole transport layer 300, the light emitting layer 400, and the electron transport layer 500 of the organic light emitting device may be prepared using a known material but is not limited thereto.

The second electrode 2000 is used as an electron injection electrode, and may be formed on the electron injection layer 600 by a method such as a vacuum deposition method or a sputtering method. Various metals may be used as a material of the second electrode 2000. Specific examples of the material include, but are not limited to aluminum, gold, silver, and magnesium.

Aside from the organic light emitting device having the above-described structure including the capping layer 3000, the first electrode 1000, the hole injection layer 200, the hole transport layer 300, the light emitting layer 400, the electron transport layer 500, the electron injection layer 600, the second electrode 2000, and the capping layer 300, the

compound of the present invention can be used for various other organic light emitting devices. The organic light emitting device may further include one or two intermediate layers if necessary.

Meanwhile, the thickness of each organic material layer formed according to the present disclosure may be adjusted according to a required degree, specifically 10 to 1,000 nm, and more specifically 20 to 150 nm.

The capping layer 3000 may be formed on the outer surface on which the hole injection layer 200 is not formed among both surfaces of the first electrode 1000. In addition, among both surfaces of the second electrode 2000, an outer surface where the electron injection layer 600 is not formed may also be formed but is not limited thereto. The capping layer 3000 may be formed by a deposition process, and the capping layer 3000 may have a thickness of 100 to 2,000 Å, more specifically, 300 to 1,000 Å. Through such thickness adjustment, it is possible to prevent the transmittance of the capping layer 3000 from decreasing.

In addition, although not illustrated in FIG. 1, according to one embodiment of the present invention, an organic material layer having various functions may be additionally formed between the capping layer 3000 and the first electrode 1000 or between the capping layer 3000 and the second electrode 2000. Alternatively, an organic material layer having various functions may be additionally formed on the upper surface (outer surface) of the capping layer 3000, but the position of the organic material layer may not be limited thereto.

Hereinafter, an organic light emitting device including a capping layer according to an embodiment of the present invention will be described in detail with reference to preparation examples and embodiments of the present invention. The preparation examples and embodiments described below are presented only for illustrative purposes and the scope of the present invention is not limited to the preparation examples and embodiments.

Synthesis Example 1: Synthesis of compound 493

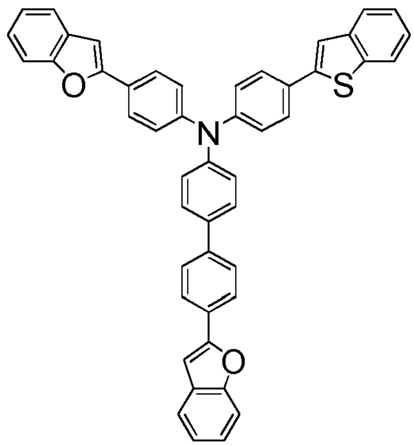

In a round bottom flask, 2.0g of 2-(4'-bromobiphenyl-4-yl)benzofuran, 4.0g of 4-(benzo[b]thiophen-2-yl)-N-(4-(benzofuran-2-yl)phenyl)aniline, 1.0 g of t-BuONa, 0.3 g of $Pd_2(dba)_3$, and 0.3 ml of $(t\text{-}Bu)_3P$ were dissolved in 100 ml of toluene and stirred under reflux. The reaction was examined through Thin Layer Chromatography (TLC), water was added, and the reaction was finished. An organic material layer was extracted with the use of methylene chloride (MC), filtered under reduced pressure, and recrystallized to obtain 3.2 g of Compound 493 (yield 64%).

m/z: 685.2075 (100.0%), 686.2109 (51.9%), 687.2143 (13.2%), 687.2033 (4.5%), 688.2067 (2.3%), 688.2176 (2.2%)

Synthesis Example 2: Synthesis of compound 495

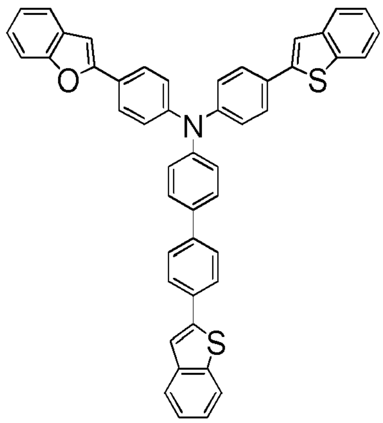

In the same manner, as in Synthesis Example 1, compound 495 was synthesized using 2-(4'-bromobiphenyl-4-yl)benzo[b]thiophene instead of 2-(4'-bromobiphenyl-4-yl)benzofuran. (Yield 62%)
m/z: 701.1847 (100.0%), 702.1881 (51.9%), 703.1914 (13.2%), 703.1805 (9.0%), 704.1839 (4.7%), 704.1948 (2.2%), 702.1841 (1.6%), 705.1872 (1.2%)

Synthesis Example 3: Synthesis of compound 497

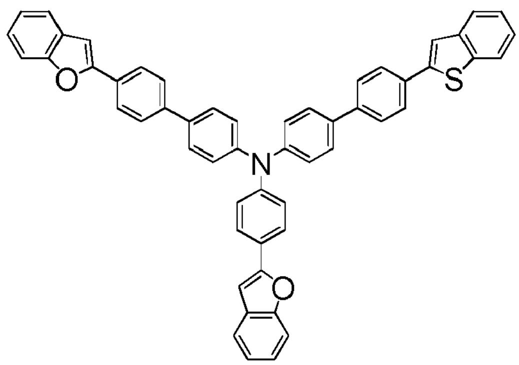

In the same manner, as in Synthesis Example 1, 2-(4-bromophenyl)benzofuran and N-(4'-(benzo[b]thiophen-2-yl)biphenyl-4-yl)-4'-(benzofuran-2-yl)biphenyl-4-amine was used to synthesize compound 497 instead of 2-(4'-bromobiphenyl-4-yl)benzofuran and 4-(benzo[b]thiophen-2-yl)-N-(4-(benzofuran-2-yl)phenyl)aniline. (Yield 60%)
m/z: 761.2389 (100.0%), 762.2422 (58.4%), 763.2456 (16.7%), 763.2346 (4.5%), 764.2489 (3.1%), 764.2380 (2.6%)

Synthesis Example 4: Synthesis of compound 499

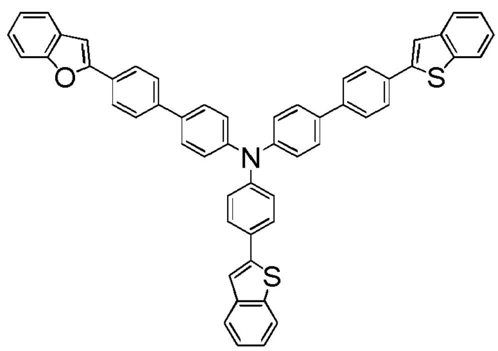

In the same manner, as in Synthesis Example 1, 2-(4-bromophenyl)benzo[b]thiophene and N-(4'-(benzo[b]thiophen-2-yl)biphenyl-4-yl)-4'-(benzofuran-2-yl)biphenyl-4-amine was used to synthesize compound 499 instead of 2-(4'-bromobiphenyl-4-yl)benzofuran and 4-(benzo[b]thiophen-2-yl)-N-(4-(benzofuran-2-yl)phenyl)aniline. (Yield 60%)
m/z: 777.2160 (100.0%), 778.2194 (58.4%), 779.2227 (16.7%), 779.2118 (9.0%), 780.2152 (5.3%), 780.2261 (3.1%), 778.2154 (1.6%), 781.2185 (1.5%)

Synthesis Example 5: Synthesis of compound 504

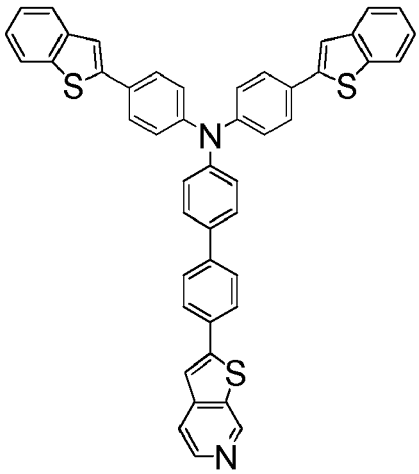

In the same manner, as in Synthesis Example 1, 2-(4'-bromobiphenyl-4-yl)thieno[2,3-c]pyridine and bis(4-(benzo[b]thiophen-2-yl)phenyl)amine was used to synthesize compound 504 instead of 2-(4'-bromobiphenyl-4-yl)benzofuran and 4-(benzo[b]thiophen-2-yl)-N-(4-(benzofuran-2-yl)phenyl)aniline. (Yield 58%)
m/z: 718.1571 (100.0%), 719.1605 (50.8%), 720.1529 (13.6%), 720.1638 (12.6%), 721.1563 (6.9%), 719.1565 (2.4%), 721.1672 (2.1%), 722.1596 (1.7%), 720.1599 (1.2%)

Preparation of organic light emitting devices

An organic light emitting device was prepared according to the structure illustrated in FIG. 1. The organic light emitting device includes a substrate 100, an anode (hole injection electrode 1000), a hole injection layer 200, a hole transport layer 300, a light emitting layer 400, an electron transport layer 500, an electron injection layer 600, a cathode (electron injection electrode 2000), and a capping layer 3000 that are stacked in this order from the bottom.

The compounds that can be used for the organic material layers interposed between the electrodes of the organic light emitting device of the present disclosure are shown in Table 1 below.

【Table 1】

| | | |
|---|---|---|
| 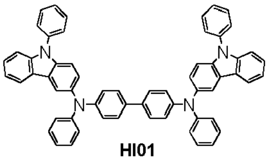 HI01 | 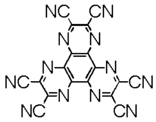 HATCN | 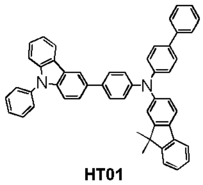 HT01 |
| 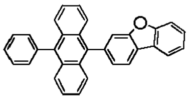 BH01 | 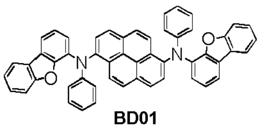 BD01 | 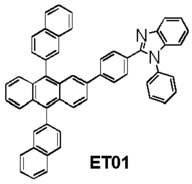 ET01 |
| 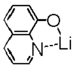 Liq | | |

<Example 1> Preparation of organic light emitting devices

The indium tin oxide (ITO) substrate on which the reflective layer containing silver (Ag) was formed was washed with distilled water with ultrasonic. After washing with distilled water, ultrasonic washing was performed with a solvent such as isopropyl alcohol, acetone, or methanol and dried. Then, HI01 with a thickness of 600 Å as a hole injection layer, HATCN with a thickness of 50 Å as a charge generating layer, and HT01 with a thickness of 500 Å as a hole transport layer were respectively deposited on the top of the ITO substrate. As a light emitting layer, dopant BD01 was doped into host BH01 at 3 wt% and deposited to a thickness of 250 Å. Then, a mixture of ET01 and Liq (1:1, wt./wt.) was deposited to a thickness of 300 Å as an electron transport layer and then deposited to a thickness of LiF 10 Å to form an electron injection layer. Then, MgAg was deposited to a thickness of 15 nm to form an anode, and the compound prepared in Synthesis Example 1 was deposited to a thickness of 600 Å as a capping layer on the anode. An organic light emitting device was prepared by encapsulating the device in a glove box.

<Examples 2 to 5> Preparation of organic light emitting devices

Organic light emitting devices were manufactured in the same manner as in Example 1 except that the compounds prepared in Preparation Examples 2 to 5 were used in Examples 2 and 5, respectively, to form the capping layer.

<Comparative Examples 1 to 5> Preparation of organic light emitting devices

Organic light emitting devices were manufactured in the same manner as in Example 1 except that the compounds of Ref.1 to Ref.5 listed in Table 2 were used in Comparative Examples 1 and 4, respectively, to form the capping layer.

【Table 2】

| | | |
|---|---|---|
| 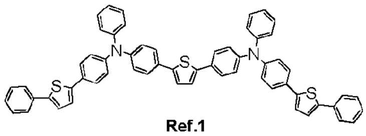 Ref.1 | 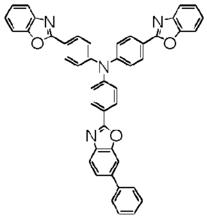 Ref.2 | 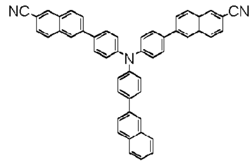 Ref.3 |
| 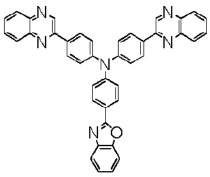 Ref.4 | 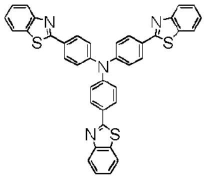 Ref.5 | |

<Experimental Example 1> Performance evaluation of organic light emitting devices

Electrons and holes were injected by applying a voltage using a Kiethley 2400 source measurement unit, and the luminance was measured using a Konica Minolta spectroradiometer (CS-2000) when light is emitted. To evaluate the performance of each of the organic light emitting devices of Examples 1 to 5 and Comparative Examples 1 to 5, the current density and luminance with respect to the applied voltage under atmospheric pressure were measured, and the results are shown in Table 3.

[Table 3]

| | Op. V | mA/cm2 | Cd/A | CIEx | CIEy | LT97 |
|---|---|---|---|---|---|---|
| Example 1 | 3.45 | 10 | 8.93 | 0.143 | 0.045 | 180 |
| Example 2 | 3.45 | 10 | 9.10 | 0.143 | 0.045 | 187 |
| Example 3 | 3.45 | 10 | 9.33 | 0.143 | 0.044 | 192 |
| Example 4 | 3.45 | 10 | 9.51 | 0.143 | 0.044 | 197 |
| Example 5 | 3.45 | 10 | 9.62 | 0.143 | 0.044 | 200 |
| Comparative Example 1 | 3.48 | 10 | 6.20 | 0.138 | 0.068 | 100 |
| Comparative Example 2 | 3.46 | 10 | 7.05 | 0.130 | 0.047 | 110 |
| Comparative Example 3 | 3.46 | 10 | 7.22 | 0.138 | 0.057 | 140 |
| Comparative Example 4 | 3.47 | 10 | 6.03 | 0.139 | 0.060 | 150 |
| Comparative Example 5 | 3.46 | 10 | 6.75 | 0.139 | 0.048 | 105 |

When comparing the examples of this present disclosure with Comparative Examples 1 to 5, it can be seen that the efficiency, color purity, and lifetime of the organic light emitting device are all improved when all the conditions of a refractive index of 2.50 or more at a wavelength of 450nm, an extinction coefficient (k) of 0.90 or more at a 380 nm wavelength, an extinction coefficient of 0.30 or less at a 450 nm wavelength are satisfied.

<Experimental Example 2> Evaluation of a refractive index and an extinction coefficient

Using the compounds of Examples 1 to 5 and Comparative Compounds 1 (Ref. 1) to Comparative Compound 5 (Ref. 5), respectively, a deposition film 60 nm on a silicon substrate was prepared by using vacuum deposition equipment. An ellipsometer device (J.A.Woollam Co.Inc, M-2000X) was used to measure the refractive index at a wavelength of 450 nm and the extinction coefficient at a wavelength of 380 nm and 430 nm. The results are shown in Table 4 below.

[Table 4]

| | Comparative Compound 1 (Ref.1) | Comparative Compound 2 (Ref.2) | Comparative Compound 3 (Ref.3) | Comparative Compound 4 (Ref.4) | Comparative Compound 5 (Ref.5) | Compound 493 | Compound 495 | Compound 497 | Compound 499 | Compound 504 |
|---|---|---|---|---|---|---|---|---|---|---|
| n@450nm | 2.52 | 2.51 | 2.64 | 2.81 | 2.44 | 2.50 | 2.52 | 2.57 | 2.59 | 2.54 |
| k@380nm | 0..72 | 0.72 | 0.90 | 1.04 | 0.71 | 1.15 | 1.18 | 1.19 | 1.21 | 1.22 |
| k@450nm | 0.33 | 0.11 | 0.33 | 0.45 | 0.12 | 0.01 | 0.01 | 0.01 | 0.01 | 0.01 |

As shown in Table 4, the compounds according to the present disclosure exhibit a high refractive index of 2.50 or higher at a wavelength of 450 nm, and at the same time have a high extinction coefficient of 0.90 or more, specifically 1.00 or more, at a wavelength of 380 nm. It can be seen that the coefficient has a small value in the range of 0.30 or less , specifically 0.10 or less at a wavelength of 450 nm.

## Claims

1. An organic light emitting device comprising:

   a first electrode and a second electrode;
   an organic material layer interposed between the first electrode and the second electrode; and
   a capping layer disposed on an outer surface of one or more of the first electrode and the second electrode, wherein the capping layer satisfies the following conditions (1) to (3) and includes a compound represented by the following Formula (1).

$$\text{condition (1) } n(@450\text{nm}) \geq 2.50$$

$$\text{condition (2) } k(@450\text{nm}) \leq 0.30$$

$$\text{condition (3) } k(@380\text{ nm}) \geq 0.90$$

(wherein n represents a refractive index at each wavelength, and k represents an extinction coefficient at each wavelength)

<Formula 1>

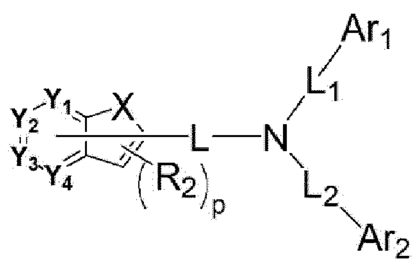

in Formula 1,

X represents O, S, Se, Te, or CRR';
each of R and R' independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy group, a substituted or unsubstituted C1~C30 sulfide, a substituted or unsubstituted C6~C50 aryl group, or a substituted or unsubstituted C2~C50 heteroaryl group, and adjacent R and R' may or may not form a ring by bonding with each other, each of $Y_1$ to $Y_4$ independently represents C, $CR_1$ or N,
$R_1$ independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 of an alkoxy group, a substituted or unsubstituted C1~C30 sulfide group, or a substituted or unsubstituted C6~C50 aryl group, and adjacent $R_1$ may or may not form a ring by bonding with each other, each of $Ar_1$ and $Ar_2$ independently represents a substituted or unsubstituted C6~C50 aryl group, or a substituted or unsubstituted C2~ C50 heteroaryl group,
$R_2$ independently represents hydrogen, deuterium, halogen, a nitro group, a nitrile group, a substituted or unsubstituted C1~C30 alkyl group, a substituted or unsubstituted C2~C30 alkenyl group, a substituted or unsubstituted C1~C30 alkoxy a group, a substituted or unsubstituted C1~C30 sulfide group, or a substituted or

unsubstituted C6~C50 aryl group, or a substituted or unsubstituted C2~C50 heteroaryl group,
each of L, $L_1$, and $L_2$ independently represents a direct bond, a substituted or unsubstituted C6~C50 arylene group, or a substituted or unsubstituted C2~C50 heteroarylene group, and
p represents an integer in a range of 0 to 2.

**2.** The organic light emitting device of claim 1, wherein Formula 1 refers to compounds represented by the following Formula 2:

<Formula 2>

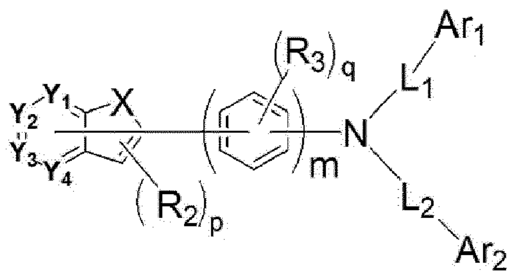

in Formula 2,

X, $Y_1$ to $Y_4$, $Ar_1$, $Ar_2$, $R_2$, $L_1$, $L_2$, and p are the same as defined in Formula 1 above,
$R_3$ is the same as the definition of $R_2$ in Formula 1 (provided that the number of carbon atoms in $R_3$ satisfies the carbon number range defined in L),
q represents an integer in a range of 0 to 4, and m represents an integer in a range of 1 to 5).

**3.** The organic light emitting device of claim 1, wherein
Formula 1 refers to compounds represented by the following Formula 3:

<Formula 3>

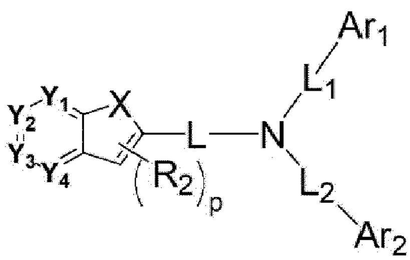

(In Formula 3,

X, $Y_1$ to $Y_4$, $Ar_1$, $Ar_2$, $R_2$, L, $L_1$, and $L_2$ are the same as defined in Formula 1 above, and
p represents 0 or 1).

**4.** The organic light emitting device of claim 1, wherein
Formula 1 refers to compounds represented by the following Formula 4:

<Formula 4>

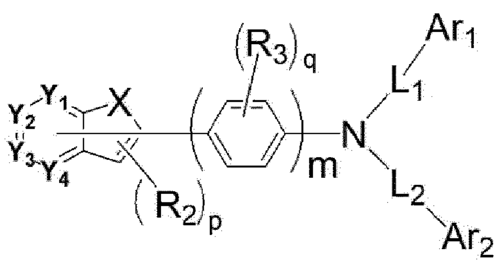

(In Formula 4,

X, $Y_1$ to $Y_4$, $Ar_1$, $Ar_2$, $R_2$, $L_1$, $L_2$, and p are the same as those defined in Formula 1 above,
$R_3$ is the same as the definition of $R_2$ in Formula 1 (provided that the number of carbon atoms in $R_3$ satisfies the carbon number range defined in L),
q represents an integer in a range of 0 to 4, and
m represents an integer in a range of 1 to 5).

**5.** The organic light emitting device of claim 1, wherein
Formula 1 refers to compounds represented by the following Formula 5:

<Formula 5>

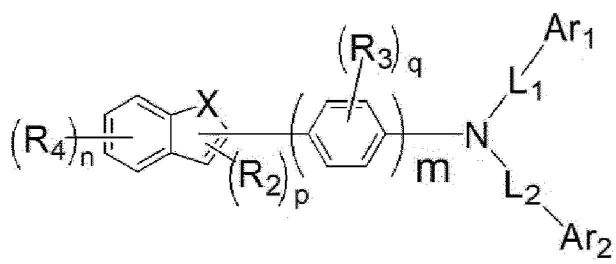

(In Formula 5,

X, $Ar_1$, $Ar_2$, $R_2$, $L_1$, and $L_2$ are the same as those defined in Formula 1 above,
$R_3$ independently is the same as the definition of $R_2$ in Formula 1 (provided that the number of carbon atoms in $R_3$ satisfies the range of carbon atoms defined in L),
$R_4$ independently is the same as the definition of $R_1$ in Formula 1 above,
p represents 0 or 1,
q represents an integer in a range of 0 to 4,
m represents an integer in a range of 1 to 5, and
n represents an integer in a range of 0 to 4).

**6.** The organic light emitting device of claim 1, wherein
Formula 1 refers to compounds represented by the following Formula 6:

<Formula 6>

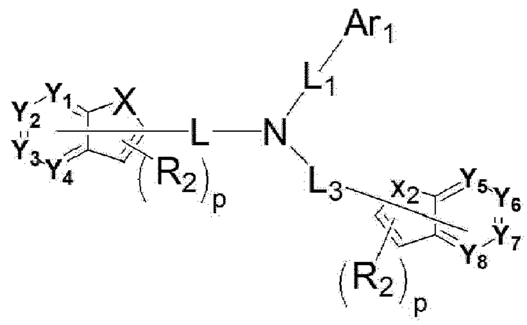

(In Formula 6,

X, $Y_1$ to $Y_4$, $Ar_1$, $R_2$, L, $L_1$, and p are the same as those defined in Formula 1 above,
$L_3$ is the same as the definitions of L, $L_1$, and $L_2$ in Formula 1 above,
$X_2$ is the same as the definition of X in Formula 1, and
each of $Y_5$ to $Y_8$ independently is the same as the definitions of $Y_1$ to $Y_4$ in Formula 1 (provided that the carbon number of $Y_5$ to $Y_8$ satisfies the carbon number range defined by $Ar_2$).

**7.** The organic light emitting device of claim 1, wherein
Formula 1 refers to compounds represented by the following Formula 7:

<Formula 7>

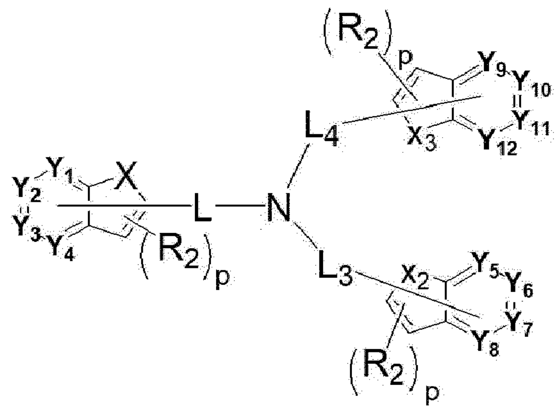

(In Formula 7,

each of X, $Y_1$ to $Y_4$, $R_2$, L, and p independently is the same as those defined in Formula 1 above,
each of $L_3$ and $L_4$ independently is the same as the definitions of $L_1$ and $L_2$ in Formula 1 above,
each of $X_2$ and $X_3$ independently is the same as the definition of X in Formula 1, and
each of $Y_5$ to $Y_{12}$ independently is the same as those of $Y_1$ to $Y_4$ in Formula 1 (provided that the carbon number of $Y_5$ to $Y_{12}$ satisfies the carbon number range defined by $Ar_1$ or $Ar_2$)).

**8.** The organic light emitting device of claim 6 or 7, wherein X and $X_2$ are different from each other.

**9.** The organic light emitting device of claim 1, wherein each of $R_1$ and $R_2$ independently is selected from hydrogen, deuterium, a methyl group, a methoxy group, a phenyl group, or a combination thereof.

**10.** The organic light emitting device of claim 9, wherein each of $R_1$ and $R_2$ independently is selected from hydrogen, a phenyl group, a biphenyl group, or a combination thereof.

**11.** The organic light emitting device of claim 1, wherein L, $L_1$, and $L_2$ are all not a direct bond.

**12.** The organic light emitting device of claim 2, wherein m is 1 to 3.

**13.** The organic light emitting device of claim 1, wherein each of $Ar_1$ and $Ar_2$ independently is selected from a phenyl group, a biphenyl group, a terphenyl group, a naphthyl group, a phenanthrenyl group, a triphenylenyl group, a benzofuran group, a benzothiophene group, or a combination thereof.

**14.** The organic light emitting device of claim 1, wherein Formula 1 including any one of the following compounds:

| | | |
|---|---|---|
| 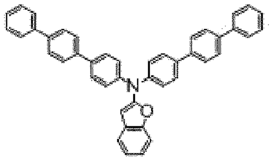 | 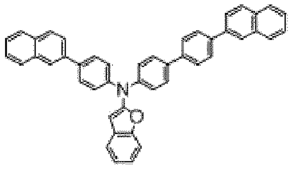 | 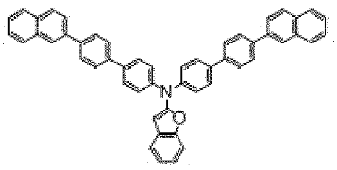 |
| **1** | **2** | **3** |
| 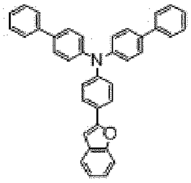 | 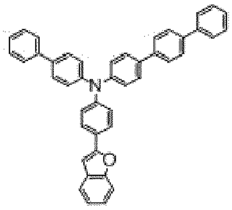 | 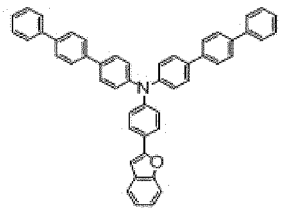 |
| **4** | **5** | **6** |
| 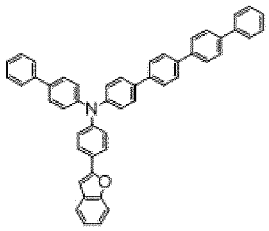 | 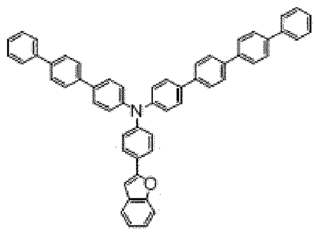 | 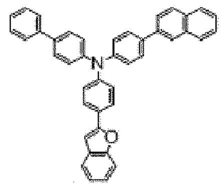 |
| **7** | **8** | **9** |
| 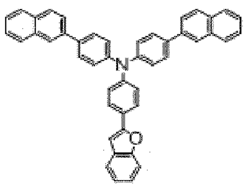 | 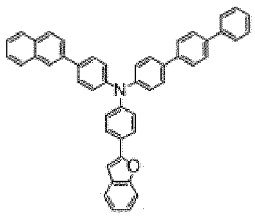 | 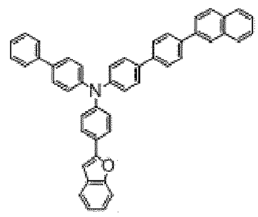 |
| **10** | **11** | **12** |

(continued)

| | | |
|---|---|---|
| 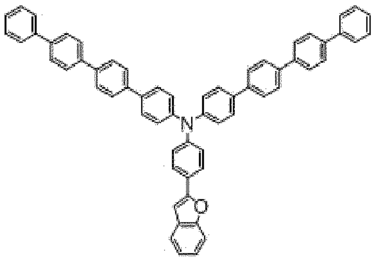 | 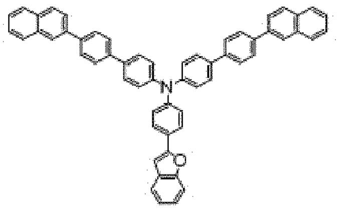 | 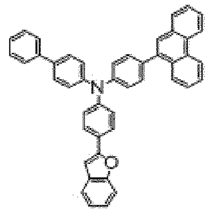 |
| **13** | **14** | **15** |
| 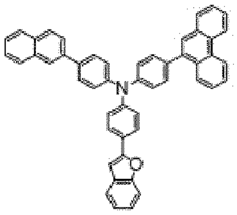 | 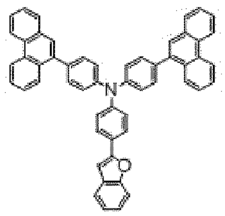 | 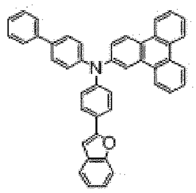 |
| **16** | **17** | **18** |
| 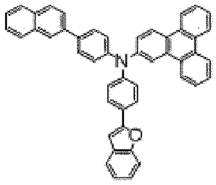 | 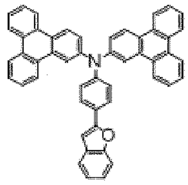 | 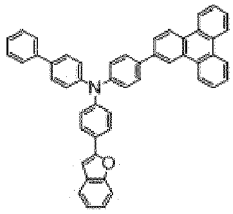 |
| **19** | **20** | **21** |
| 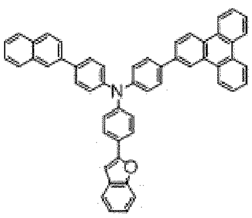 | 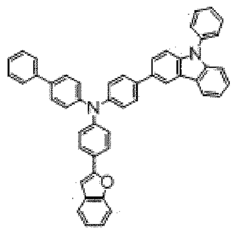 | 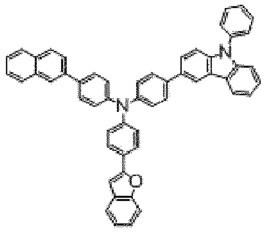 |
| **22** | **23** | **24** |
| 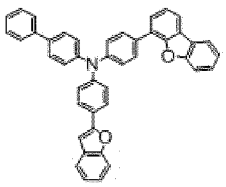 | 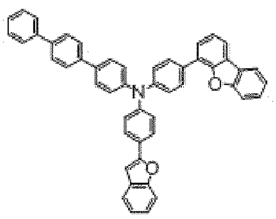 | 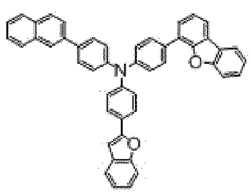 |
| **25** | **26** | **27** |

(continued)

| | | |
|---|---|---|
| 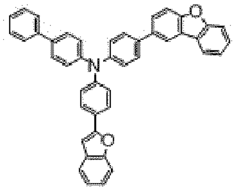 | 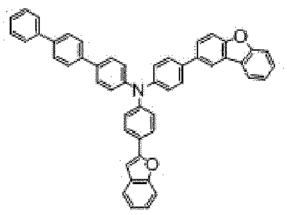 | 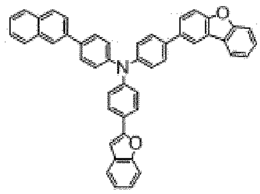 |
| 28 | 29 | 30 |
| 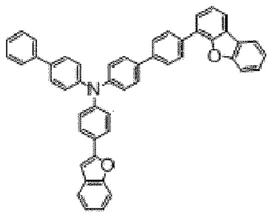 | 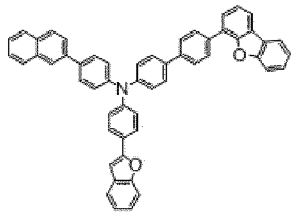 | 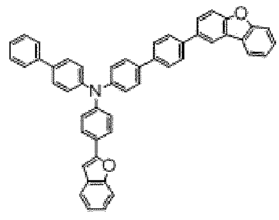 |
| 31 | 32 | 33 |
| 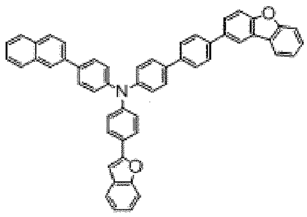 | 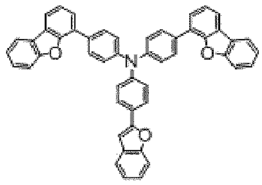 | 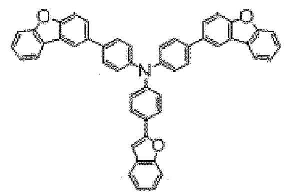 |
| 34 | 35 | 36 |
| 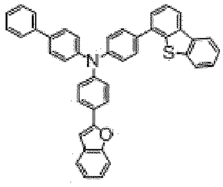 | 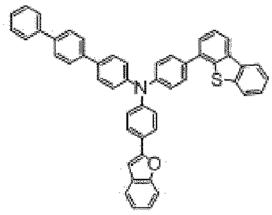 | 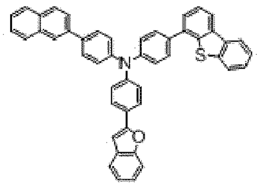 |
| 37 | 38 | 39 |
| 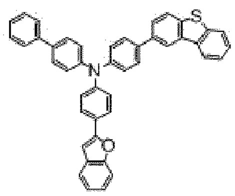 | 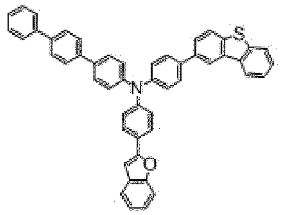 | 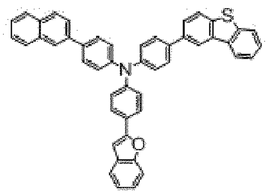 |
| 40 | 41 | 42 |

(continued)

| | | |
|---|---|---|
| 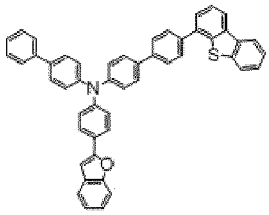 | 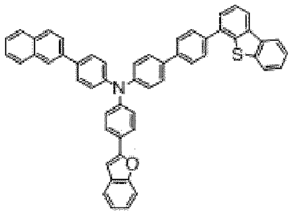 | 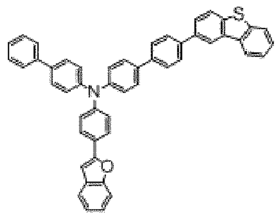 |
| **43** | **44** | **45** |
| 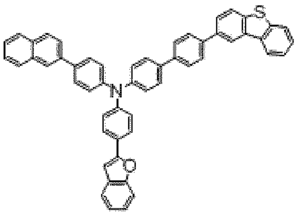 | 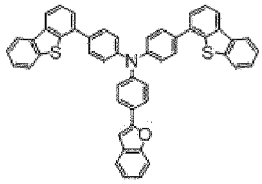 | 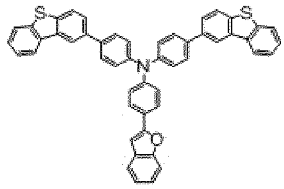 |
| **46** | **47** | **48** |
| 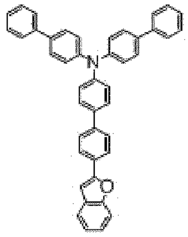 | 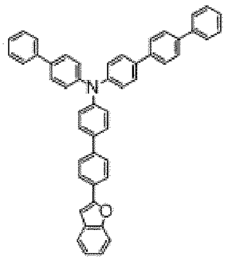 | 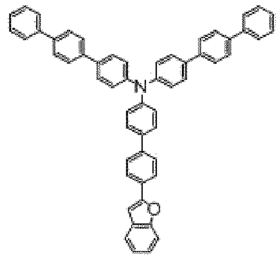 |
| **49** | **50** | **51** |
| 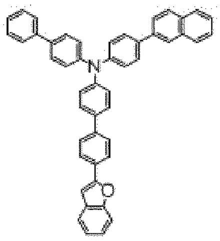 | 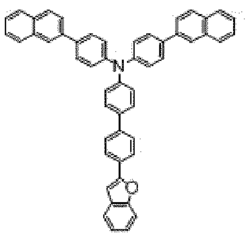 | 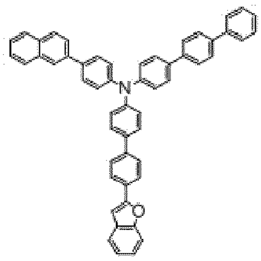 |
| **52** | **53** | **54** |
| 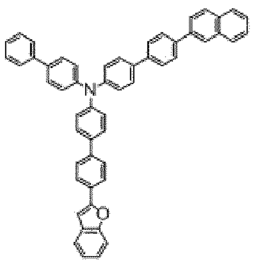 | 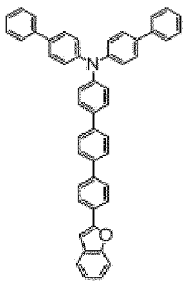 | 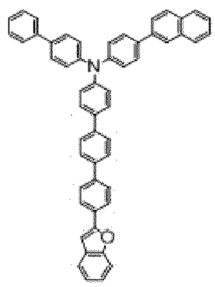 |
| **55** | **56** | **57** |

(continued)

| | | |
|---|---|---|
| 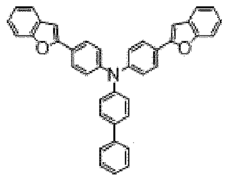 | 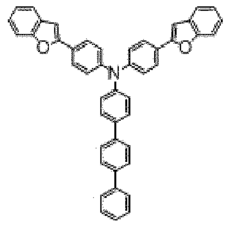 | 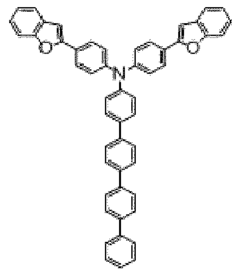 |
| **58** | **59** | **60** |
| 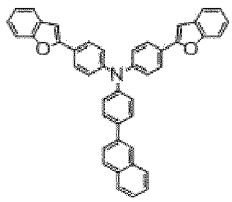 | 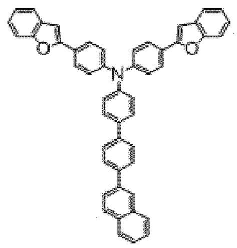 | 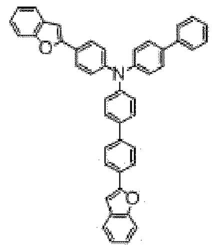 |
| **61** | **62** | **63** |
| 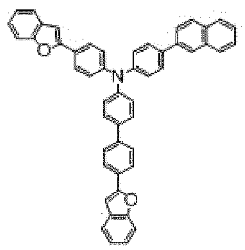 | 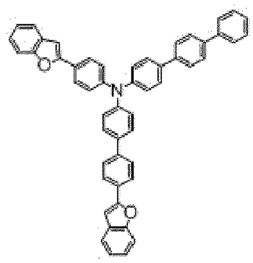 | 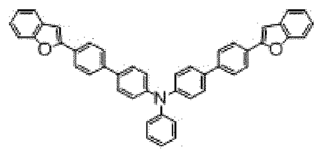 |
| **64** | **65** | **66** |
| 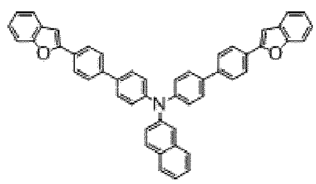 | 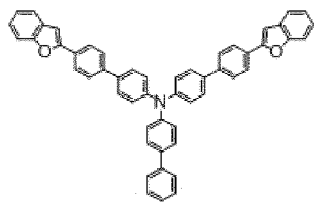 | 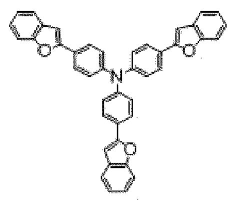 |
| **67** | **68** | **69** |
| 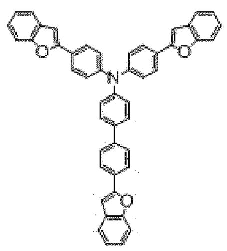 | 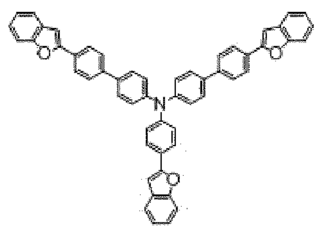 | 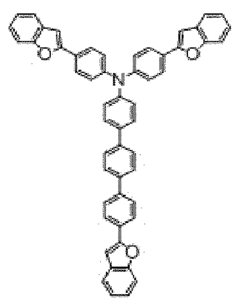 |
| **70** | **71** | **72** |

(continued)

| | | |
|---|---|---|
| 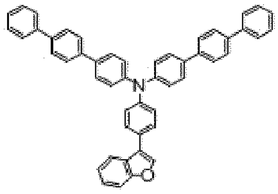 | 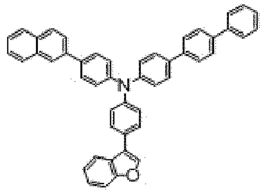 | 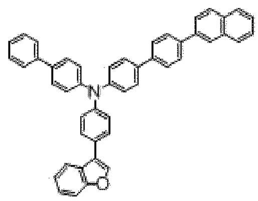 |
| **73** | **74** | **75** |
| 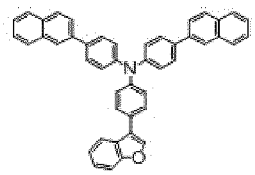 | 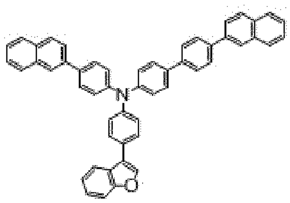 | 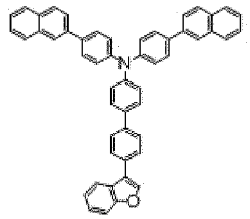 |
| **76** | **77** | **78** |
| 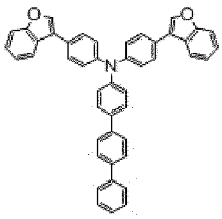 | 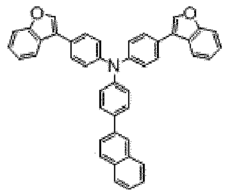 | 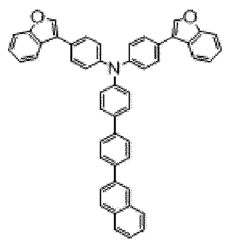 |
| **79** | **80** | **81** |
| 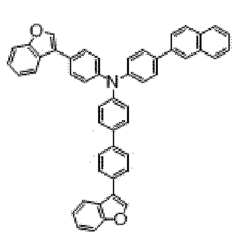 | 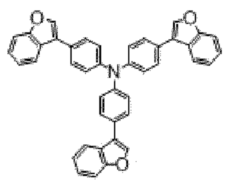 | 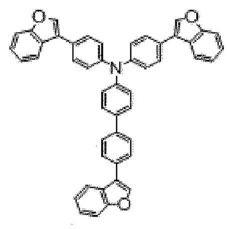 |
| **82** | **83** | **84** |
| 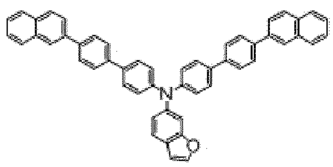 | 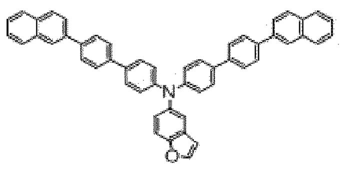 | 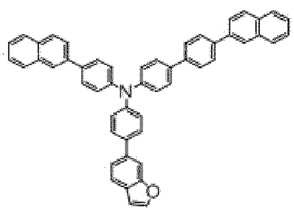 |
| **85** | **86** | **87** |

(continued)

| | | |
|---|---|---|
| 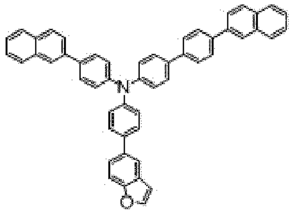 | 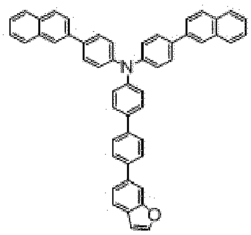 | 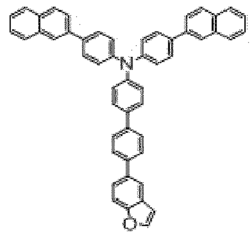 |
| **88** | **89** | **90** |
| 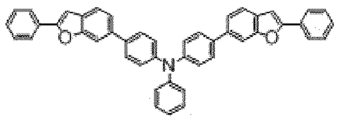 | 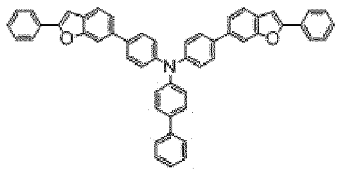 | 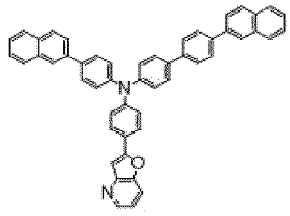 |
| **91** | **92** | **93** |
| 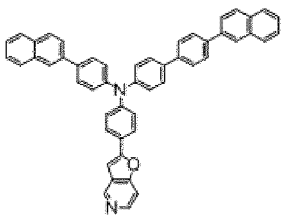 | 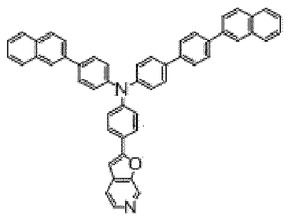 | 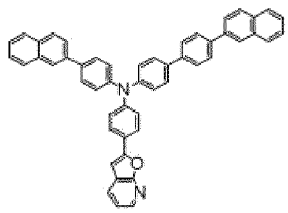 |
| **94** | **95** | **96** |
| 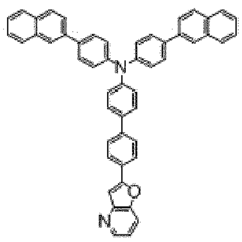 | 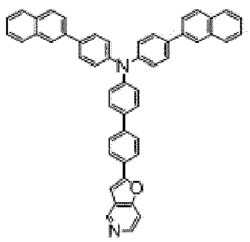 | 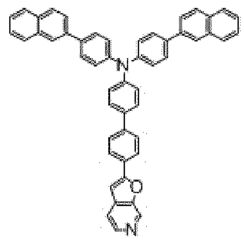 |
| **97** | **98** | **99** |
| 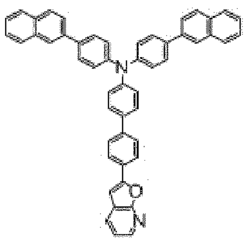 | 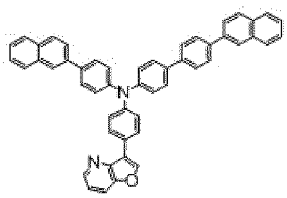 | 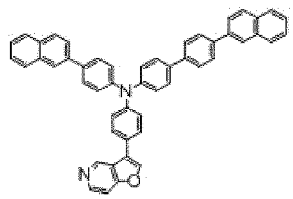 |
| **100** | **101** | **102** |

(continued)

| | | |
|---|---|---|
| 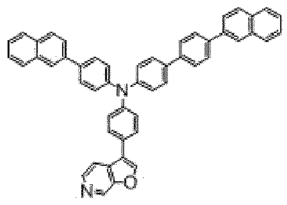 | 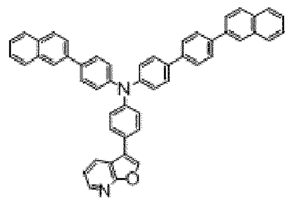 | 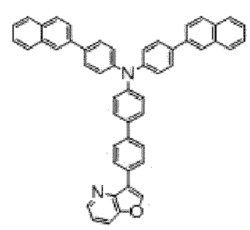 |
| **103** | **104** | **105** |
| 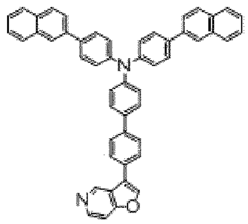 | 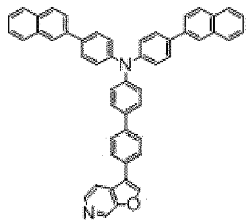 | 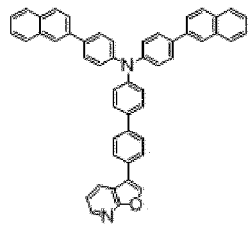 |
| **106** | **107** | **108** |
| 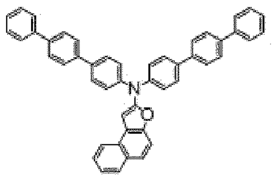 | 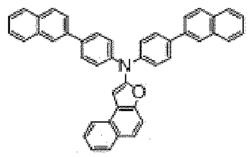 | 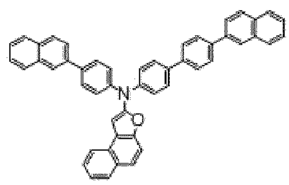 |
| **109** | **110** | **111** |
| 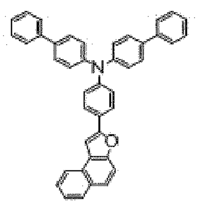 | 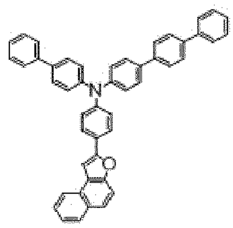 | 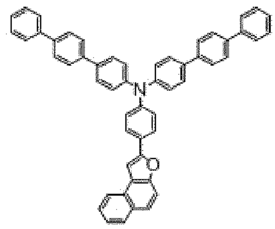 |
| **112** | **113** | **114** |
| 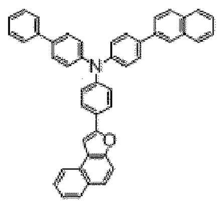 | 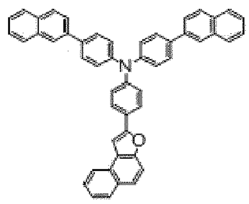 | 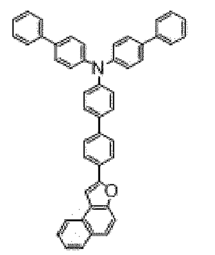 |
| **115** | **116** | **117** |

(continued)

| | | |
|---|---|---|
| 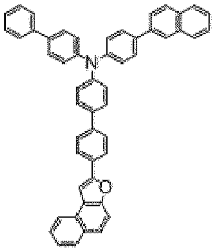 | 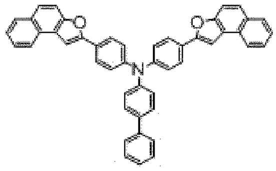 | 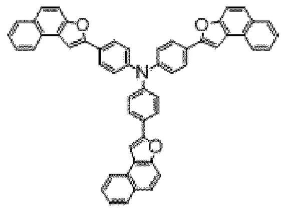 |
| **118** | **119** | **120** |
| 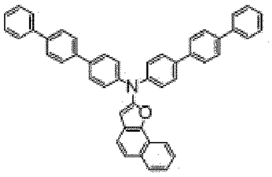 | 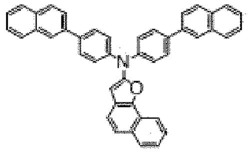 | 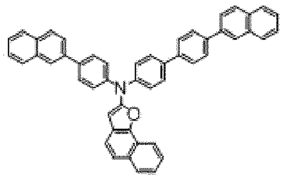 |
| **121** | **122** | **123** |
| 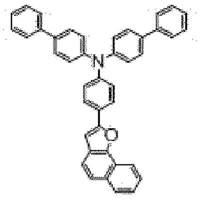 | 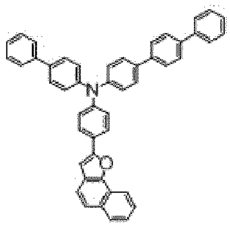 | 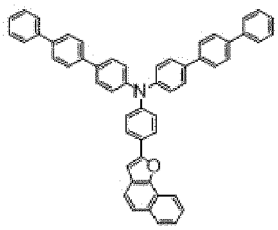 |
| **124** | **125** | **126** |
| 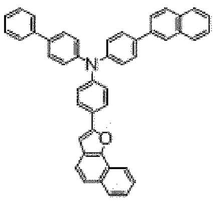 | 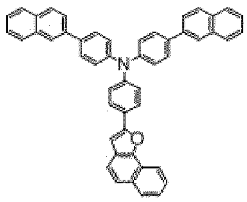 | 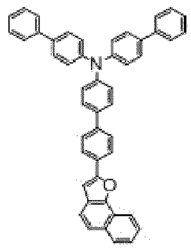 |
| **127** | **128** | **129** |
| 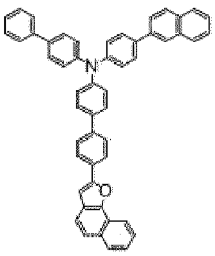 | 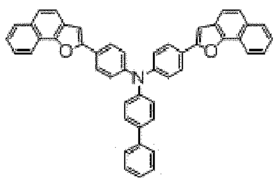 | 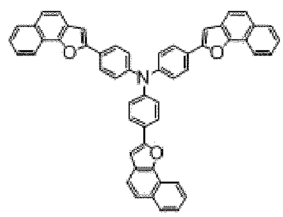 |
| 130 | 131 | 132 |

(continued)

| | | |
|---|---|---|
| 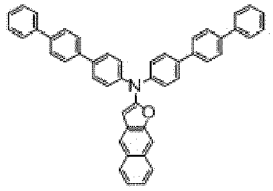 | 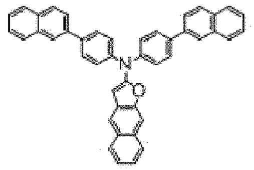 | 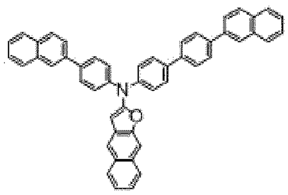 |
| **133** | **134** | **135** |
| 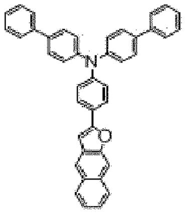 | 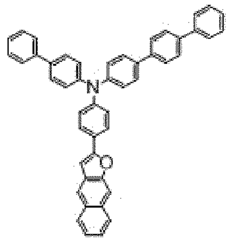 | 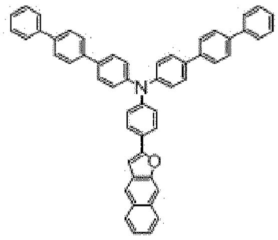 |
| **136** | **137** | **138** |
| 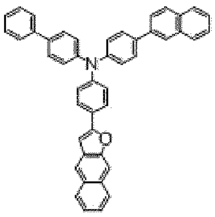 | 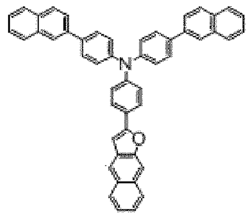 | 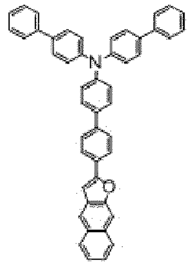 |
| **139** | **140** | **141** |
| 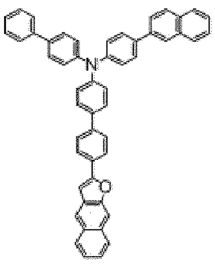 | 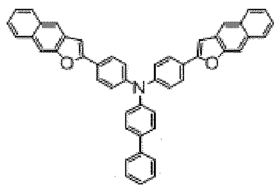 | 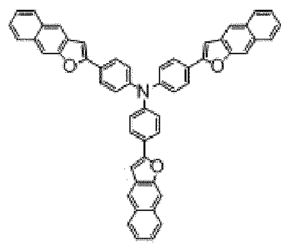 |
| **142** | **143** | **144** |
| 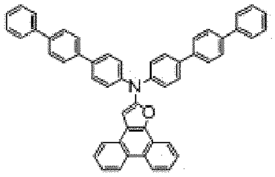 | 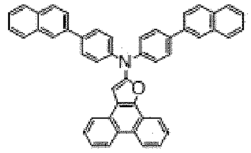 | 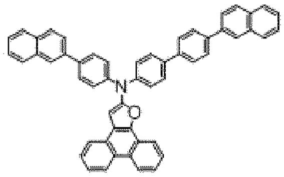 |
| **145** | **146** | **147** |

(continued)

| | | |
|---|---|---|
| 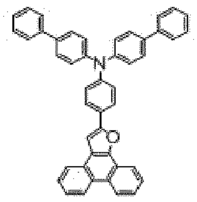 | 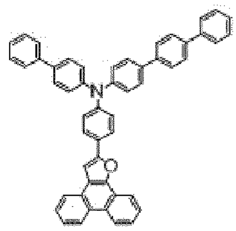 | 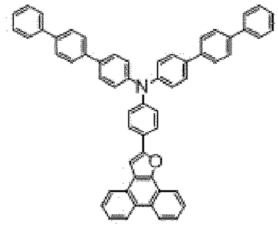 |
| **148** | **149** | **150** |
| 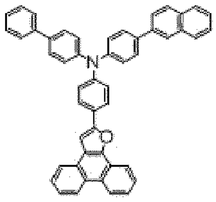 | 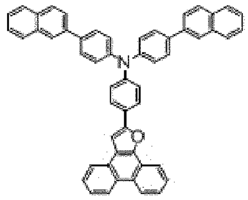 | 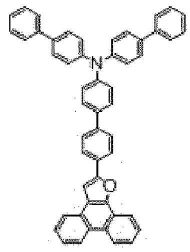 |
| **151** | **152** | **153** |
| 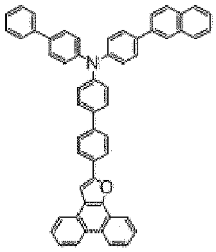 | 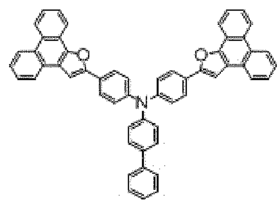 | 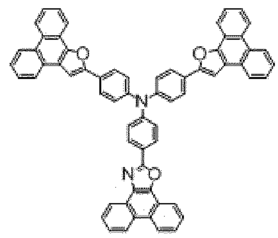 |
| **154** | **155** | **156** |
| 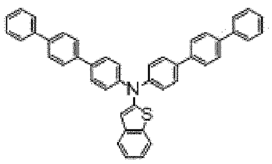 | 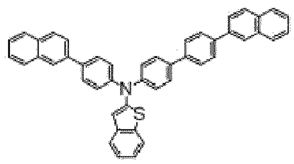 | 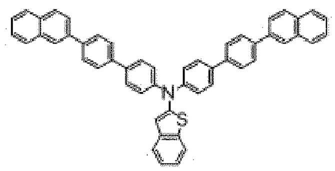 |
| **157** | **158** | **159** |
| 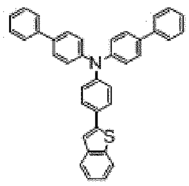 | 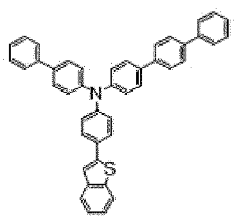 | 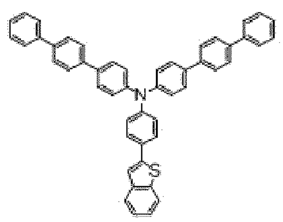 |
| **160** | **161** | **162** |

(continued)

| | | |
|---|---|---|
| 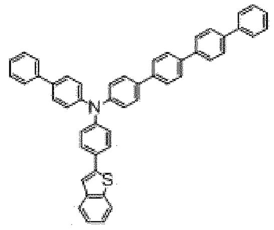 | 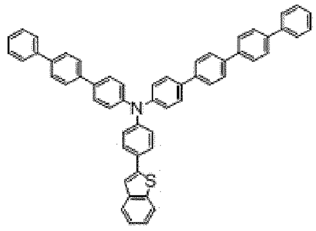 | 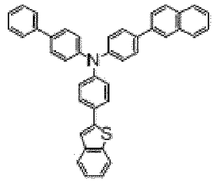 |
| **163** | **164** | **165** |
| 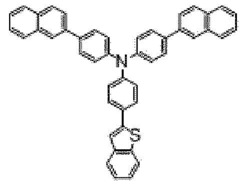 | 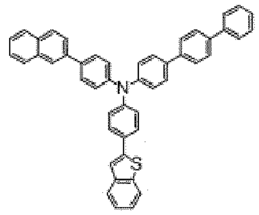 | 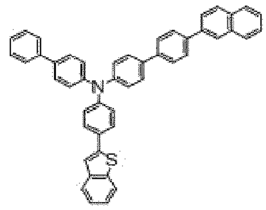 |
| **166** | **167** | **168** |
| 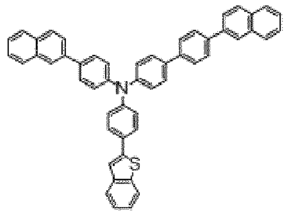 | 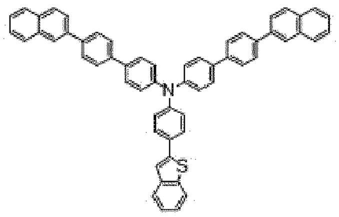 | 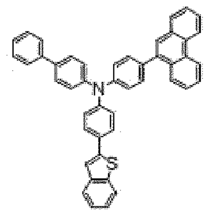 |
| **169** | **170** | **171** |
| 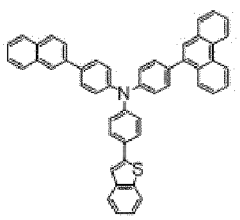 | 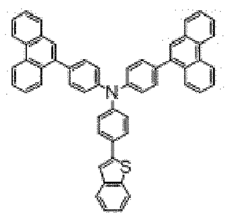 | 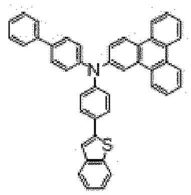 |
| **172** | **173** | **174** |
| 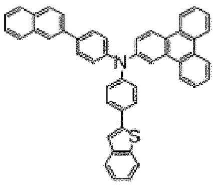 | 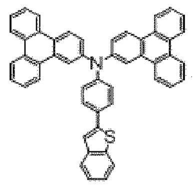 | 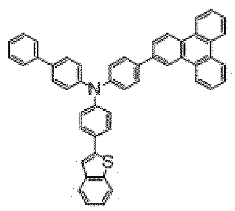 |
| **175** | **176** | **177** |

(continued)

| | | |
|---|---|---|
| 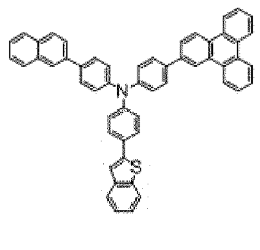 | 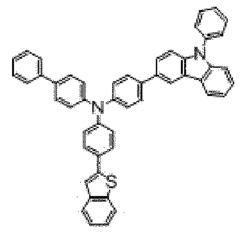 | 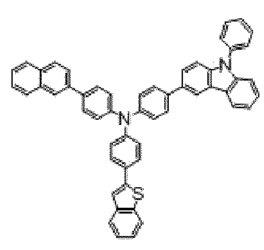 |
| **178** | **179** | **180** |
| 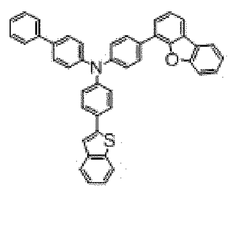 | 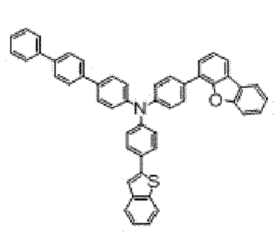 | 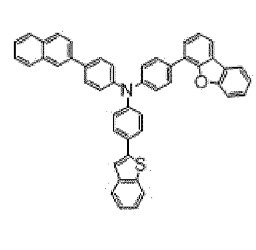 |
| **181** | **182** | **183** |
| 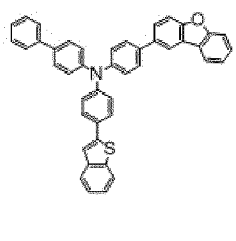 | 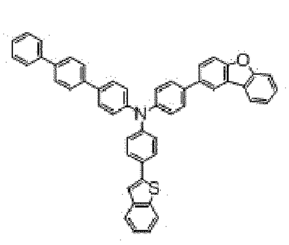 | 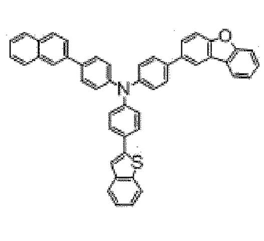 |
| **184** | **185** | **186** |
| 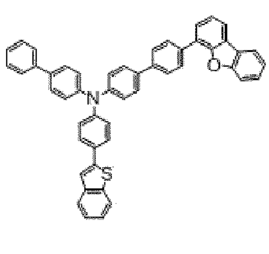 | 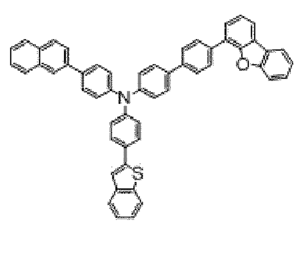 | 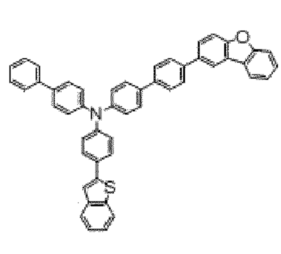 |
| **187** | **188** | **189** |
| 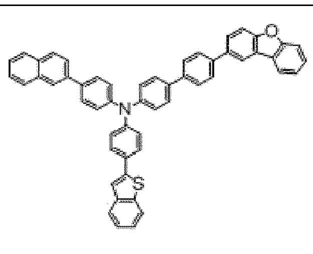 | 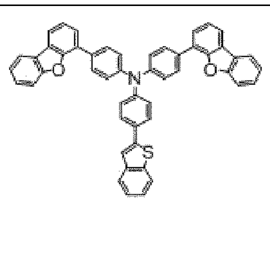 | 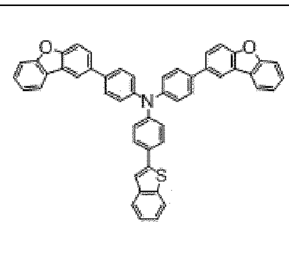 |
| **190** | **191** | **192** |

(continued)

| | | |
|---|---|---|
| 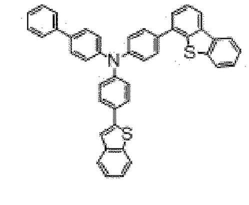 | 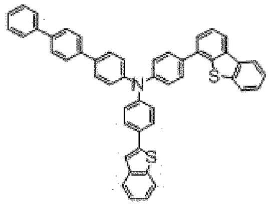 | 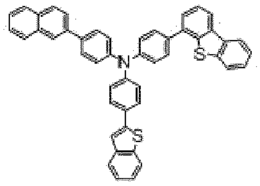 |
| **193** | **194** | **195** |
| 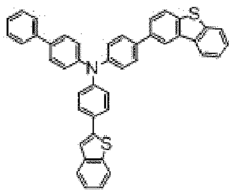 | 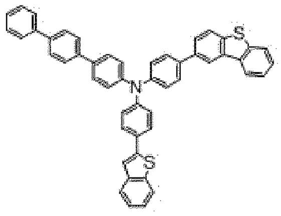 | 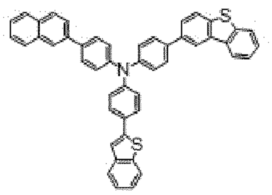 |
| **196** | **197** | **198** |
| 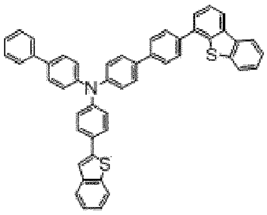 | 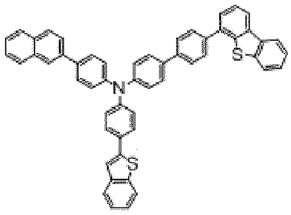 | 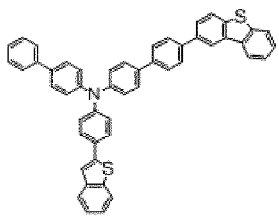 |
| **199** | **200** | **201** |
| 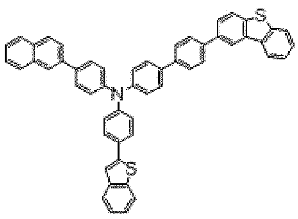 | 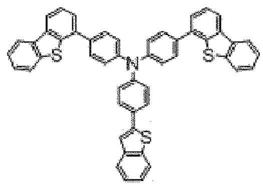 | 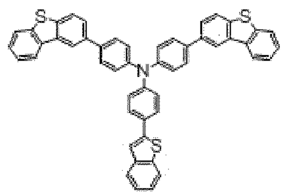 |
| **202** | **203** | **204** |
| 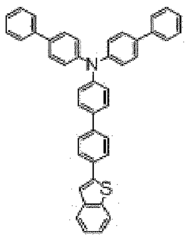 | 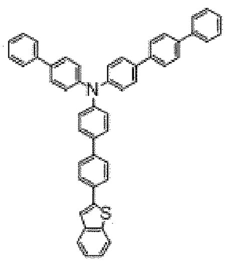 | 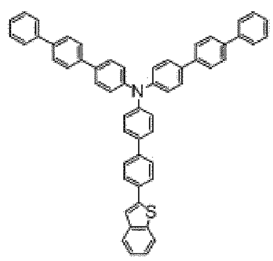 |
| **205** | **206** | **207** |

(continued)

| | | |
|---|---|---|
| 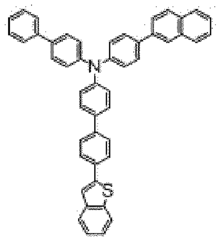 | 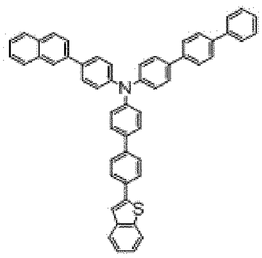 | 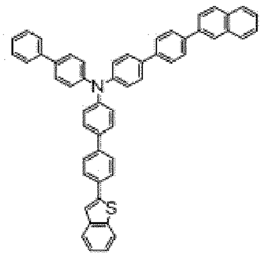 |
| **208** | **209** | **210** |
| 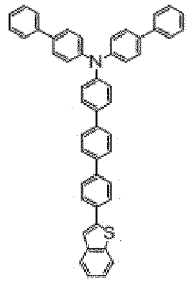 | 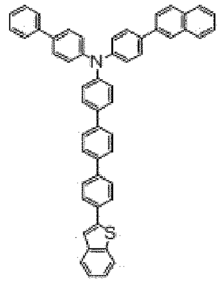 | 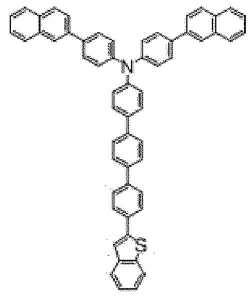 |
| **211** | **212** | **213** |
| 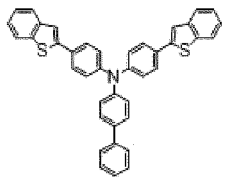 | 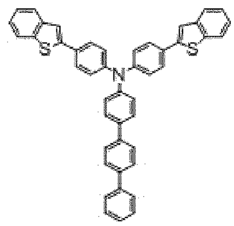 | 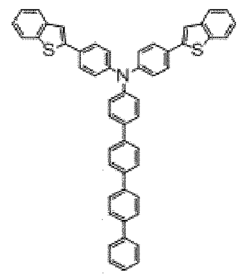 |
| **214** | **215** | **216** |
| 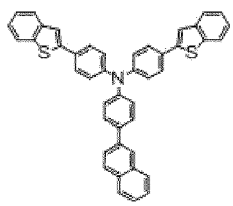 | 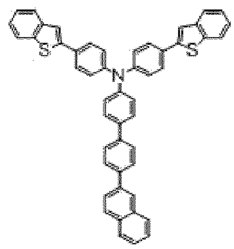 | 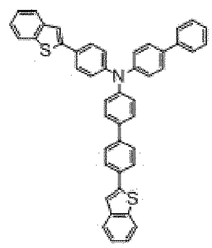 |
| **217** | **218** | **219** |
| 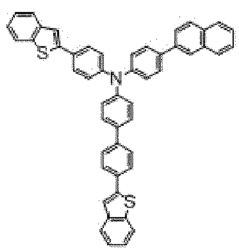 | 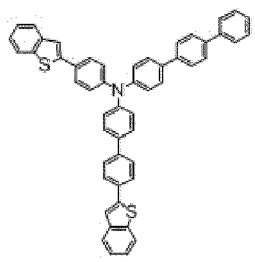 | 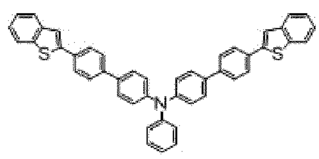 |
| **220** | **221** | **222** |

(continued)

| | | |
|---|---|---|
| 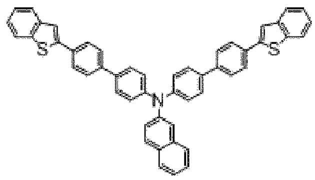 | 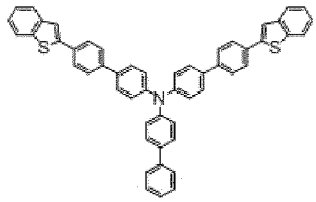 | 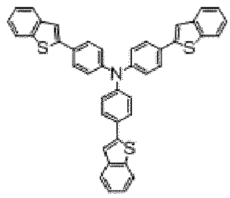 |
| **223** | **224** | **225** |
| 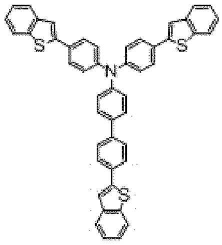 | 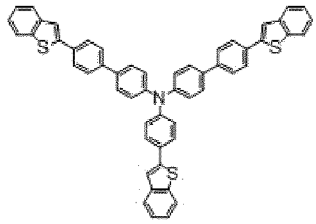 | 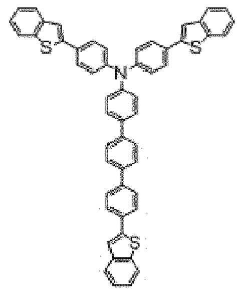 |
| **226** | **227** | **228** |
| 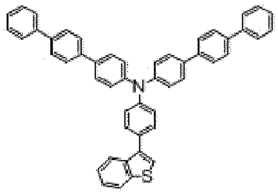 | 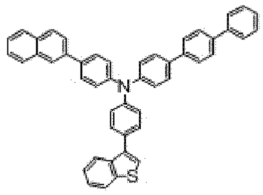 | 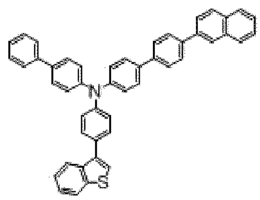 |
| **229** | **230** | **231** |
| 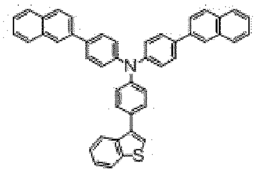 | 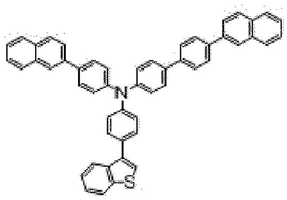 | 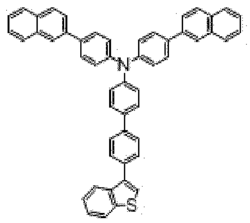 |
| **232** | **233** | **234** |
| 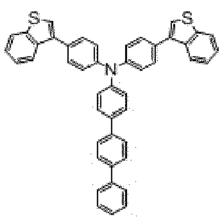 | 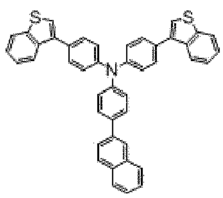 | 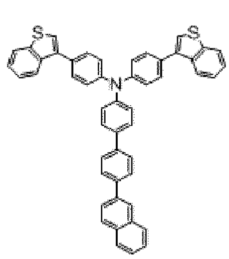 |
| **235** | **236** | **237** |

(continued)

| | | |
|---|---|---|
| 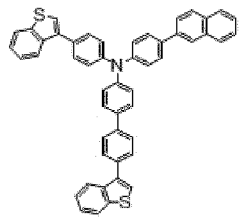 | 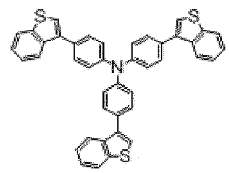 | 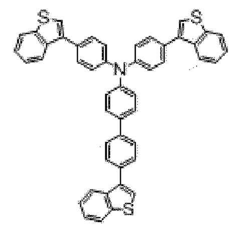 |
| **238** | **239** | **240** |
| 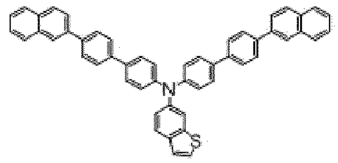 | 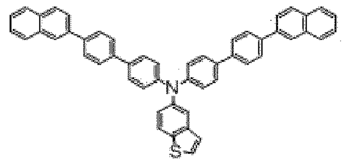 | 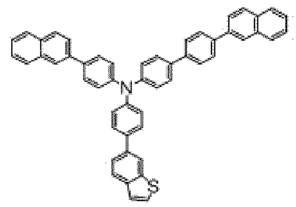 |
| **241** | **242** | **243** |
| 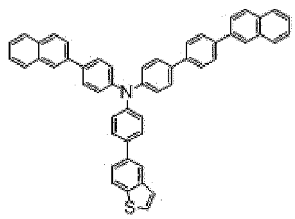 | 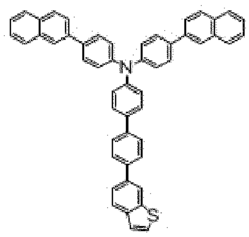 | 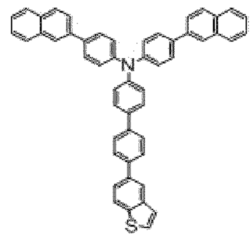 |
| **244** | **245** | **246** |
| 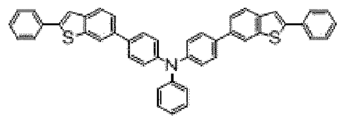 | 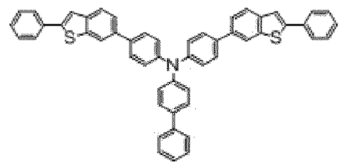 | 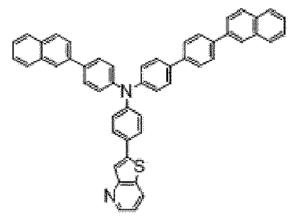 |
| **247** | **248** | **249** |
| 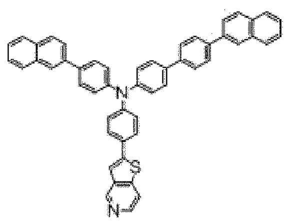 | 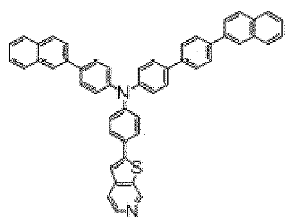 | 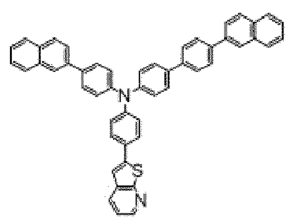 |
| **250** | **251** | **252** |

(continued)

| | | |
|---|---|---|
| 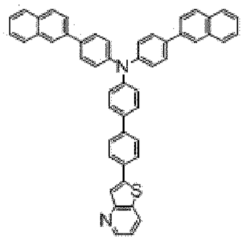 | 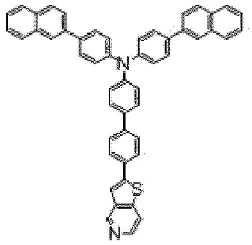 | 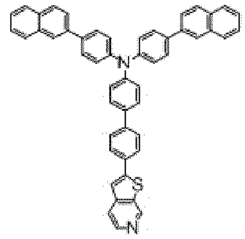 |
| **253** | **254** | **255** |
| 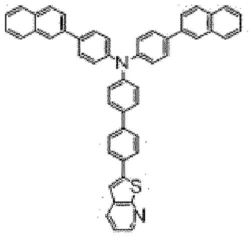 | 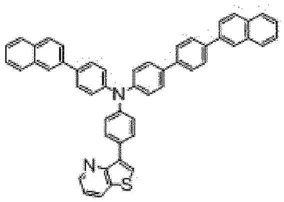 | 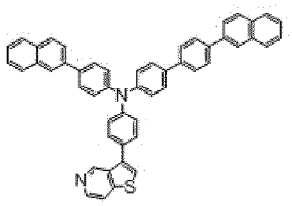 |
| **256** | **257** | **258** |
| 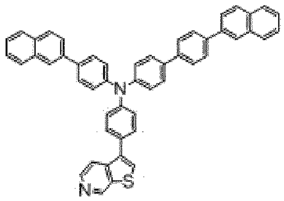 | 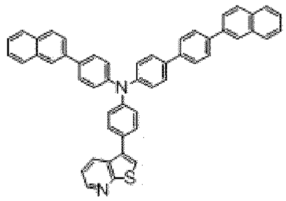 | 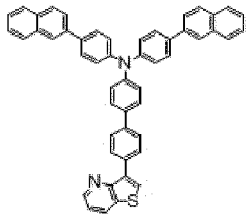 |
| **259** | **260** | **261** |
| 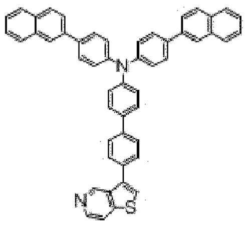 | 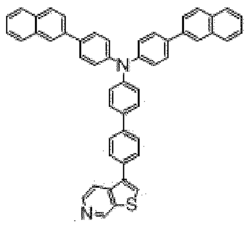 | 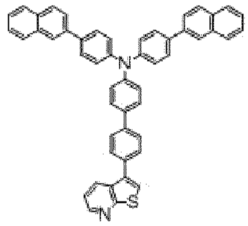 |
| **262** | **263** | **264** |
| 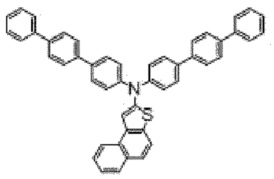 | 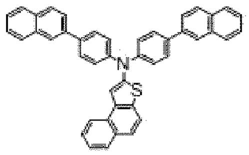 | 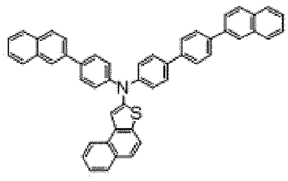 |
| **265** | **266** | **267** |

(continued)

| | | |
|---|---|---|
| 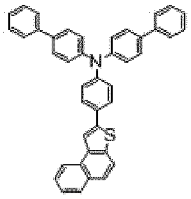 | 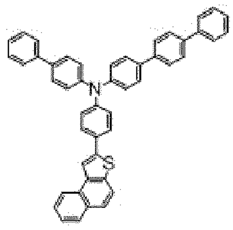 | 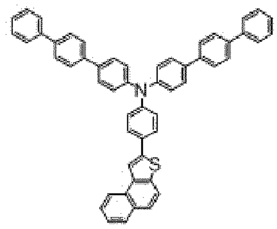 |
| **268** | **269** | **270** |
| 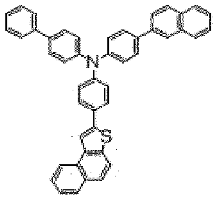 | 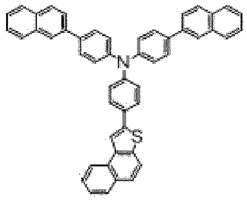 | 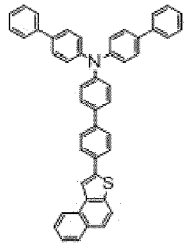 |
| **271** | **272** | **273** |
| 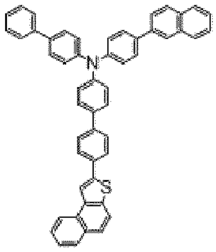 | 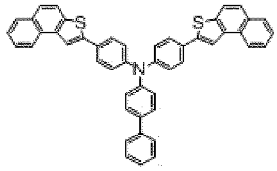 | 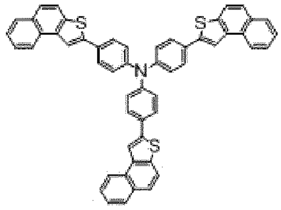 |
| **274** | **275** | **276** |
| 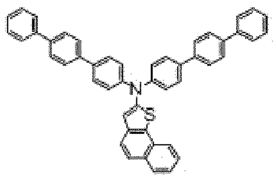 | 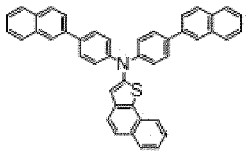 | 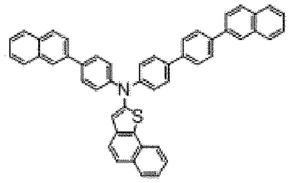 |
| **277** | **278** | **279** |
| 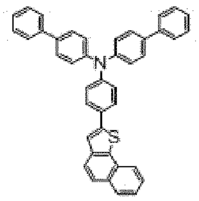 | 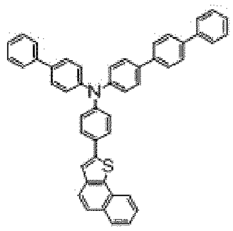 | 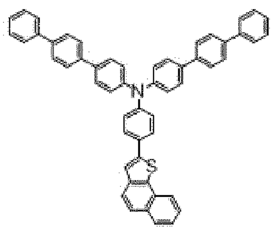 |
| **280** | **281** | **282** |

(continued)

| | | |
|---|---|---|
| 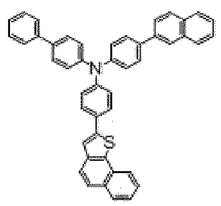 | 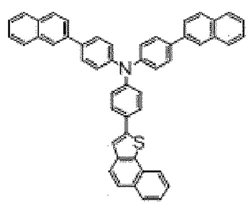 | 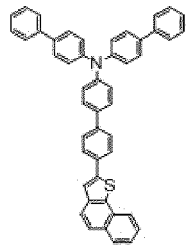 |
| **283** | **284** | **285** |
| 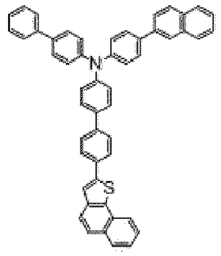 | 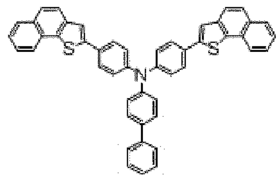 | 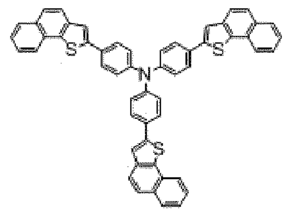 |
| **286** | **287** | **288** |
| 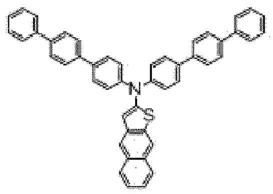 | 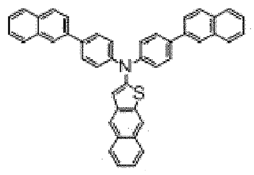 | 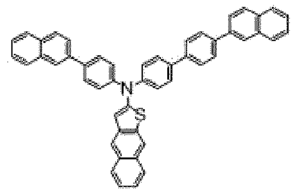 |
| **289** | **290** | **291** |
| 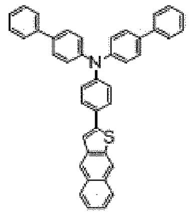 | 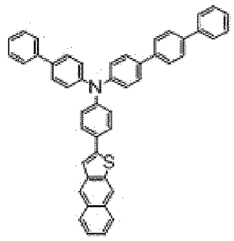 | 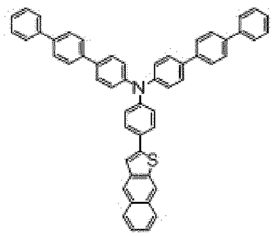 |
| **292** | **293** | **294** |
| 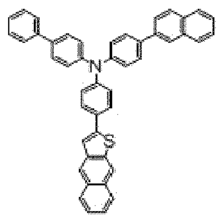 | 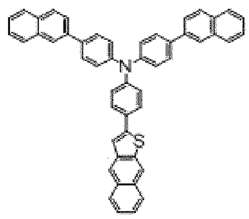 | 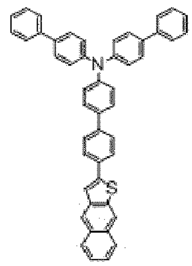 |
| **295** | **296** | **297** |

(continued)

| | | |
|---|---|---|
| 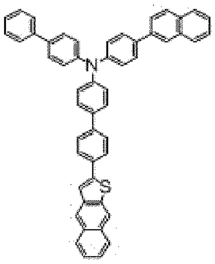 | 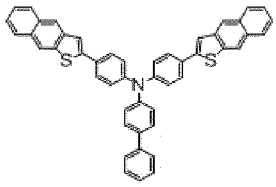 | 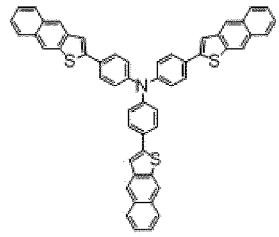 |
| **298** | **299** | **300** |
| 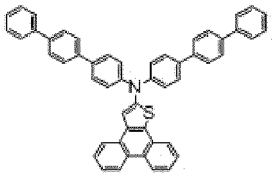 | 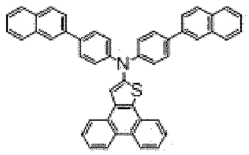 | 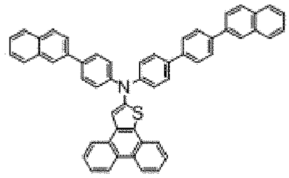 |
| **301** | **302** | **303** |
| 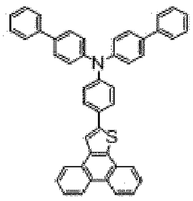 | 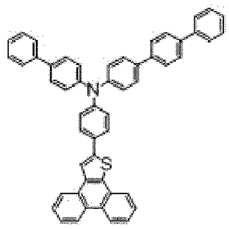 | 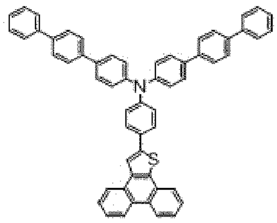 |
| **304** | **305** | **306** |
| 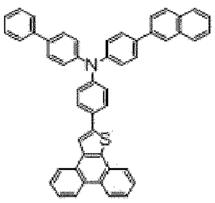 | 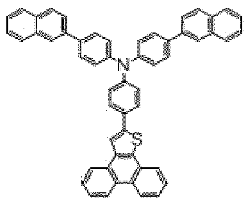 | 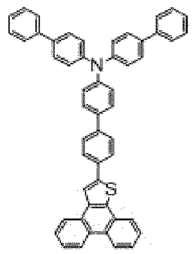 |
| **307** | **308** | **309** |
| 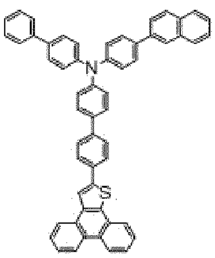 | 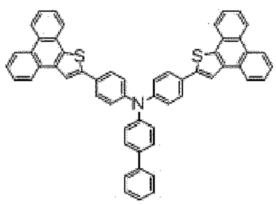 | 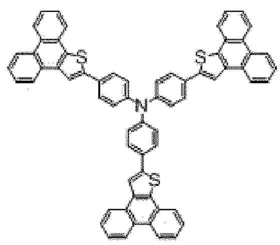 |
| **310** | **311** | **312** |

(continued)

| | | |
|---|---|---|
| 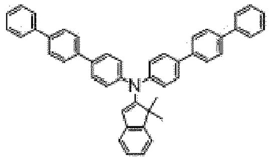 | 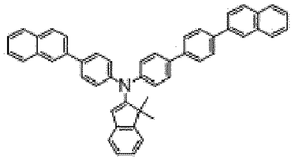 | 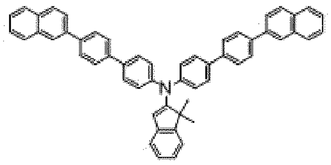 |
| **313** | **314** | **315** |
| 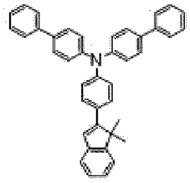 | 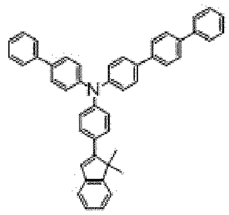 | 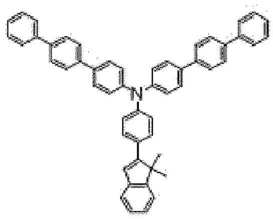 |
| **316** | **317** | **318** |
| 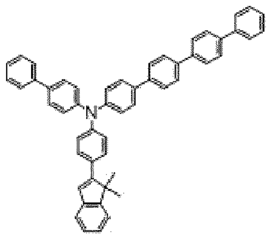 | 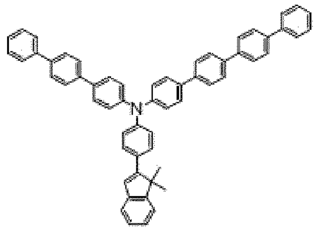 | 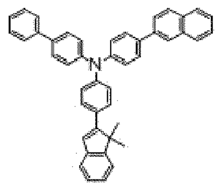 |
| **319** | **320** | **321** |
| 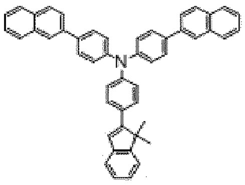 | 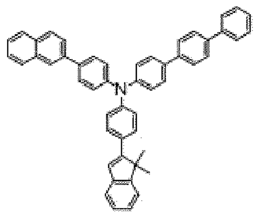 | 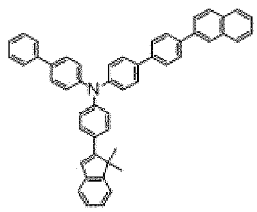 |
| **322** | **323** | **324** |
| 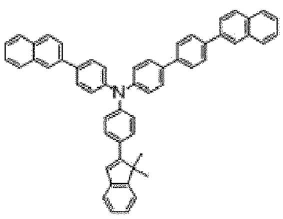 | 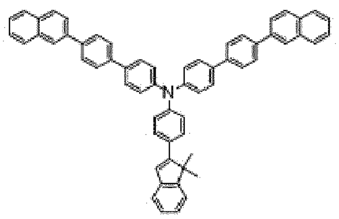 | 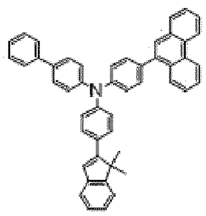 |
| **325** | **326** | **327** |

(continued)

| | | |
|---|---|---|
| 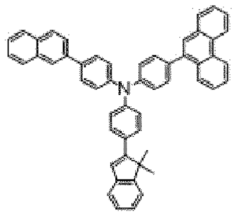 | 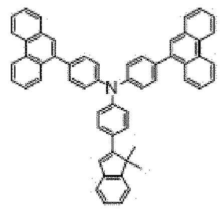 | 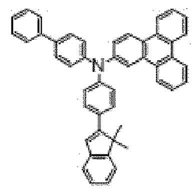 |
| 328 | 329 | 330 |
| 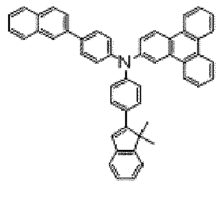 | 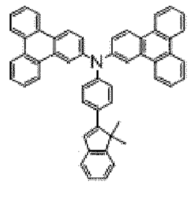 | 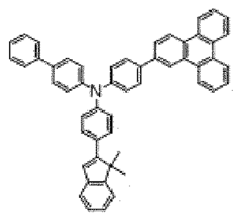 |
| 331 | 332 | 333 |
| 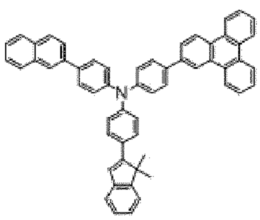 | 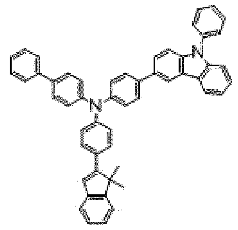 | 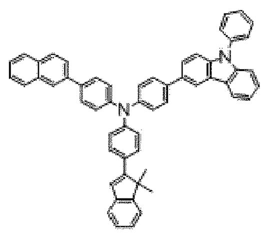 |
| 334 | 335 | 336 |
| 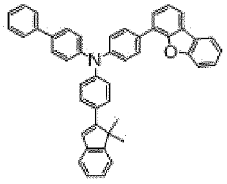 | 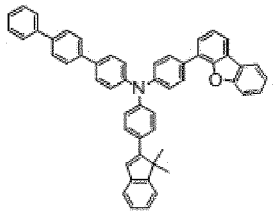 | 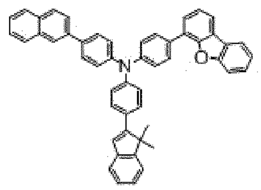 |
| 337 | 338 | 339 |
| 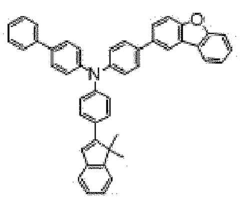 | 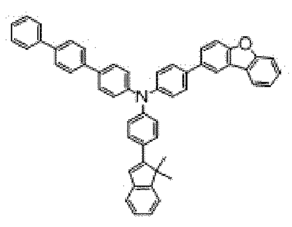 | 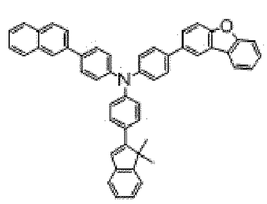 |
| 340 | 341 | 342 |

(continued)

| | | |
|---|---|---|
| 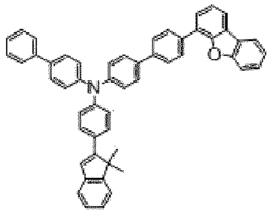 | 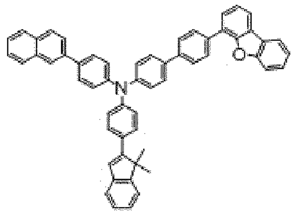 | 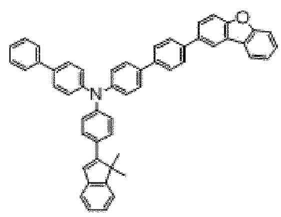 |
| **343** | **344** | **345** |
| 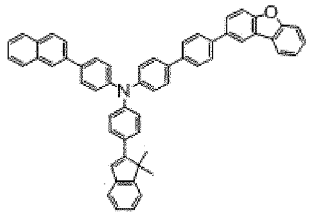 | 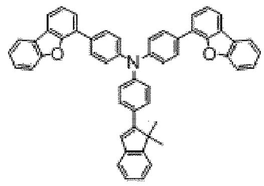 | 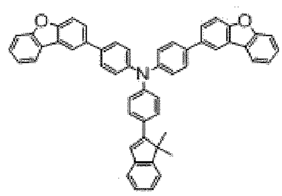 |
| **346** | **347** | **348** |
| 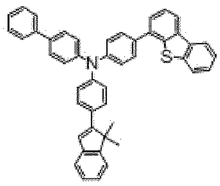 | 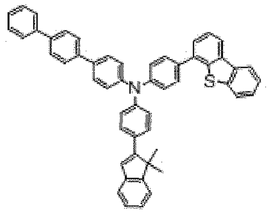 | 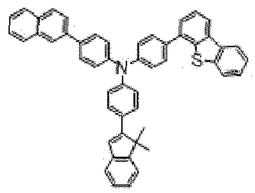 |
| **349** | **350** | **351** |
| 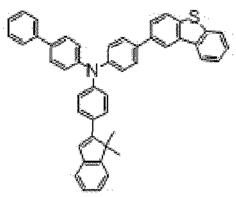 | 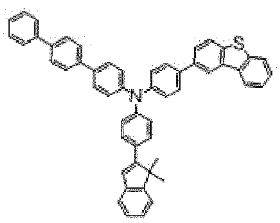 | 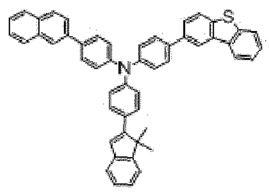 |
| **352** | **353** | **354** |
| 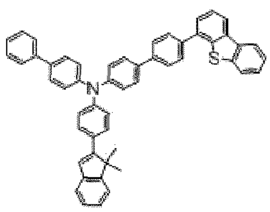 | 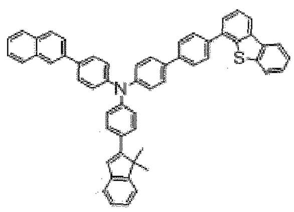 | 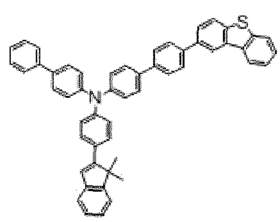 |
| **355** | **356** | **357** |

(continued)

| | | |
|---|---|---|
| 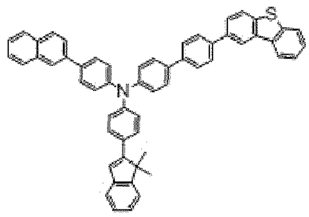 | 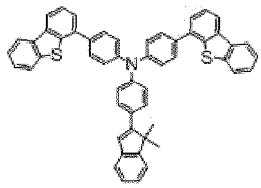 | 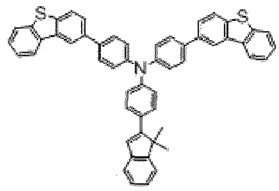 |
| **358** | **359** | **360** |
| 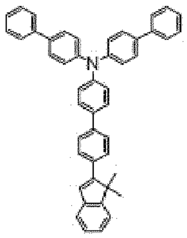 | 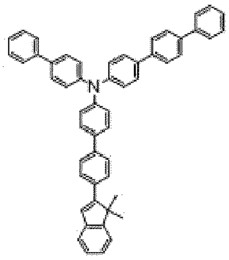 | 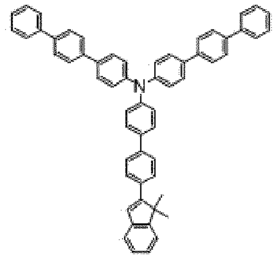 |
| **361** | **362** | **363** |
| 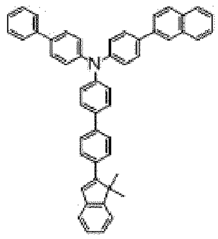 | 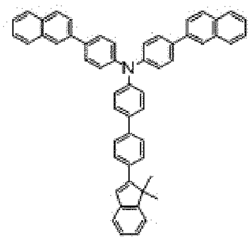 | 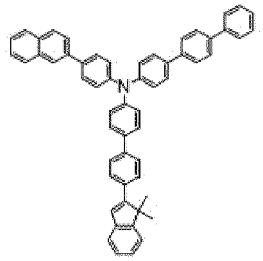 |
| **364** | **365** | **366** |
| 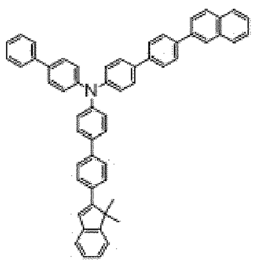 | 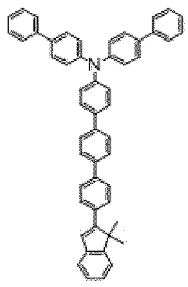 | 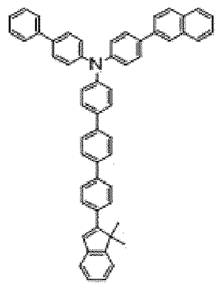 |
| **367** | **368** | **369** |
| 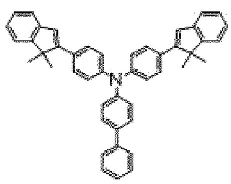 | 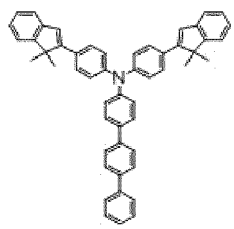 | 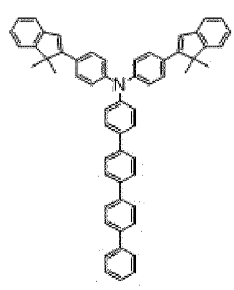 |
| **370** | **371** | **372** |

(continued)

| | | |
|---|---|---|
| 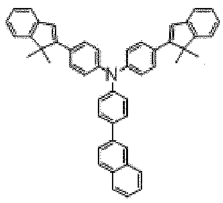 | 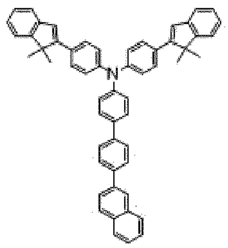 | 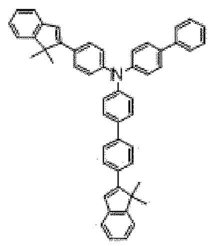 |
| **373** | **374** | **375** |
| 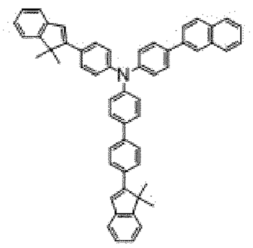 | 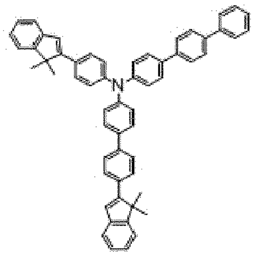 | 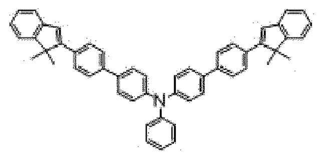 |
| **376** | **377** | **378** |
| 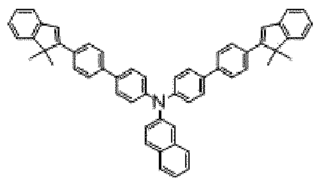 | 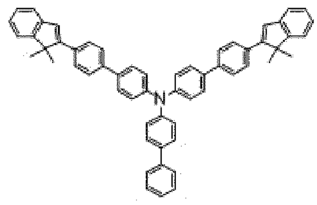 | 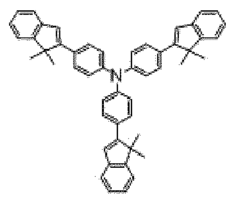 |
| **379** | **380** | **381** |
| 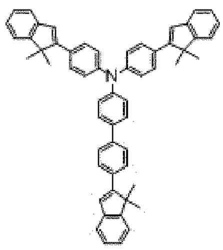 | 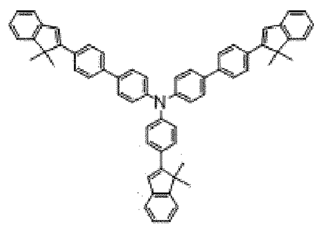 | 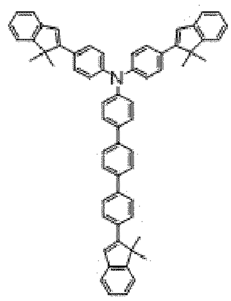 |
| **382** | **383** | **384** |
| 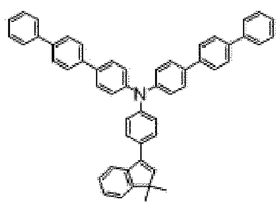 | 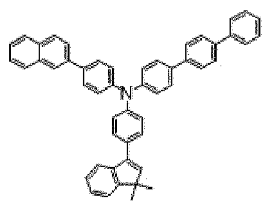 | 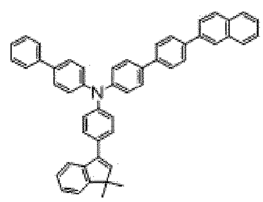 |
| **385** | **386** | **387** |

(continued)

| | | |
|---|---|---|
| 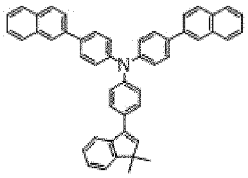 | 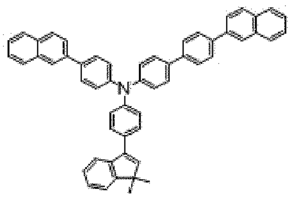 | 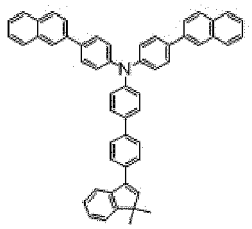 |
| **388** | **389** | **390** |
| 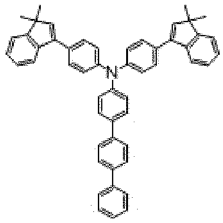 | 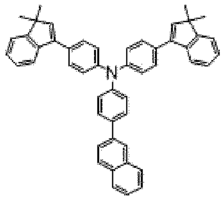 | 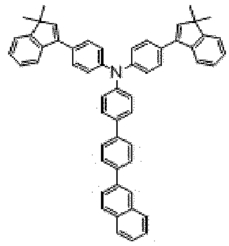 |
| **391** | **392** | **393** |
| 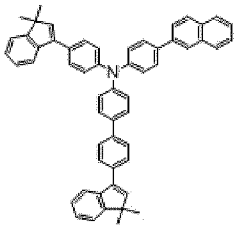 | 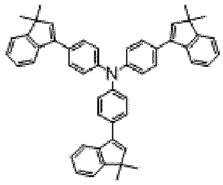 | 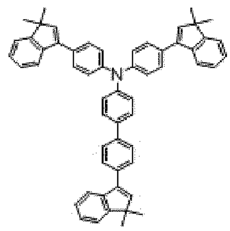 |
| **394** | **395** | **396** |
| 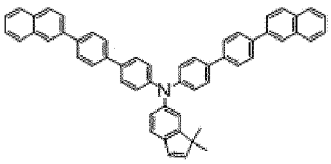 | 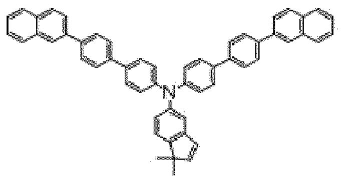 | 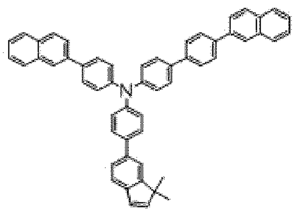 |
| **397** | **398** | **399** |
| 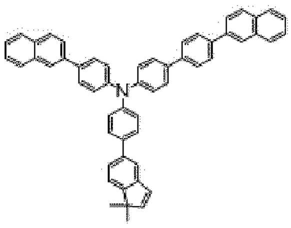 | 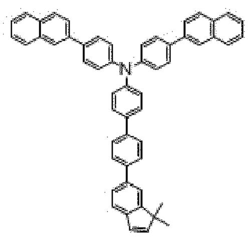 | 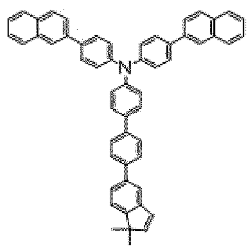 |
| **400** | **401** | **402** |

(continued)

| | | |
|---|---|---|
| 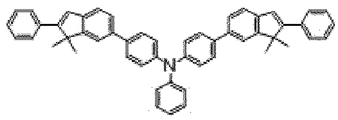 | 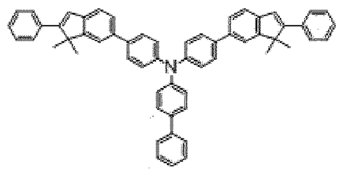 | 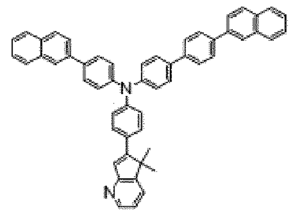 |
| **403** | **404** | **405** |
| 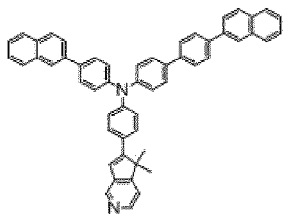 | 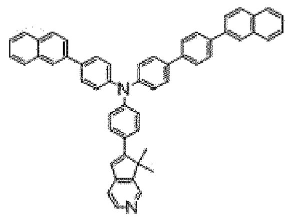 | 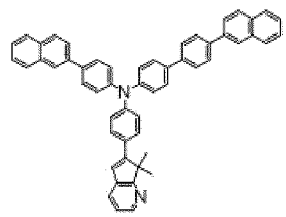 |
| **406** | **407** | **408** |
| 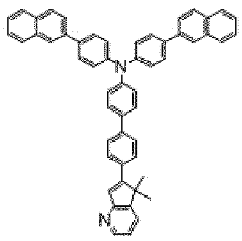 | 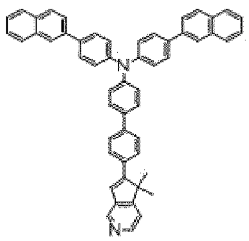 | 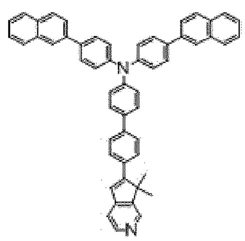 |
| **409** | **410** | **411** |
| 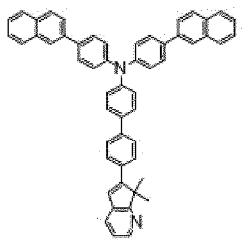 | 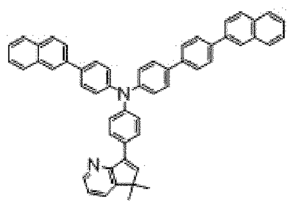 | 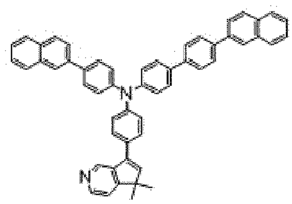 |
| **412** | **413** | **414** |
| 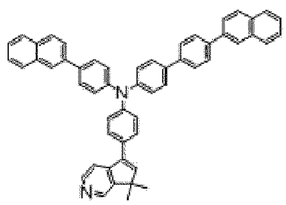 | 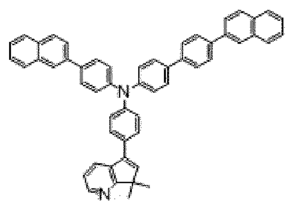 | 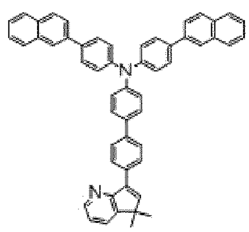 |
| **415** | **416** | **417** |

(continued)

| | | |
|---|---|---|
| 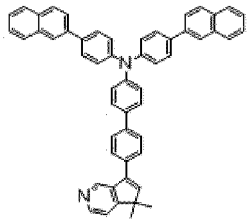 | 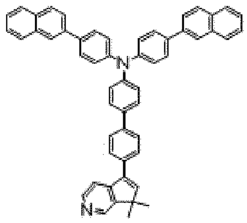 | 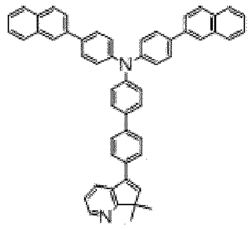 |
| **418** | **419** | **420** |
| 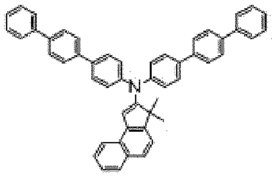 | 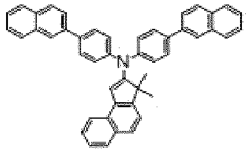 | 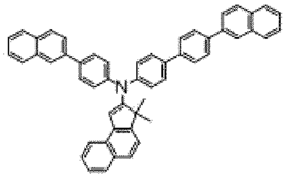 |
| **421** | **422** | **423** |
| 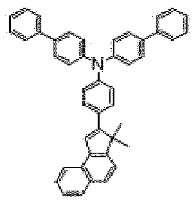 | 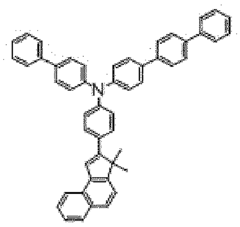 | 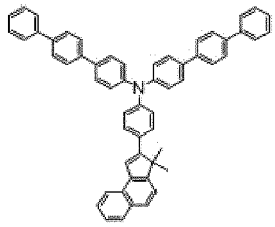 |
| **424** | **425** | **426** |
| 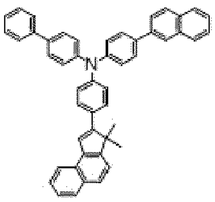 | 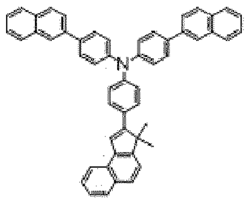 | 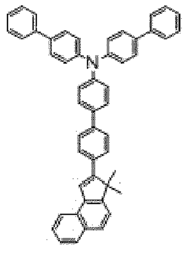 |
| **427** | **428** | **429** |
| 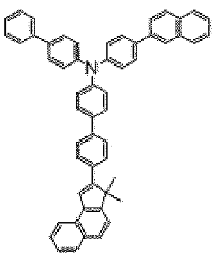 | 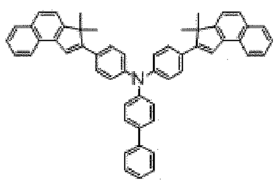 | 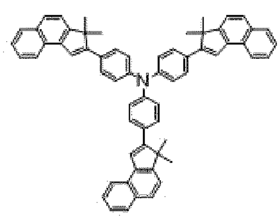 |
| **430** | **431** | **432** |

(continued)

| | | |
|---|---|---|
| 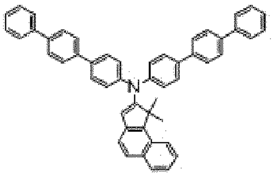 | 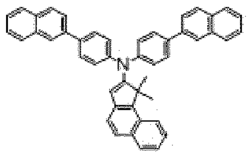 | 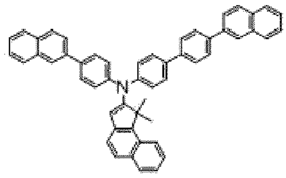 |
| **433** | **434** | **435** |
| 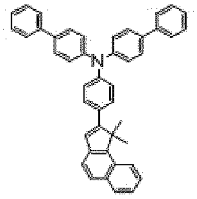 | 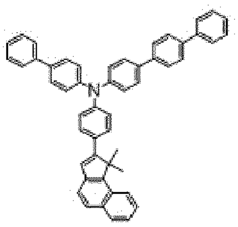 | 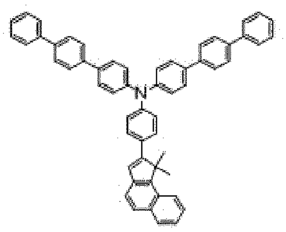 |
| **436** | **437** | **438** |
| 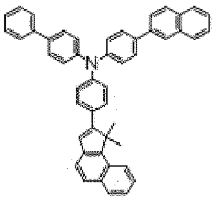 | 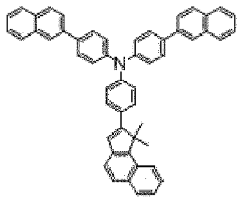 | 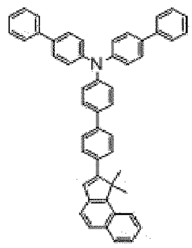 |
| **439** | **440** | **441** |
| 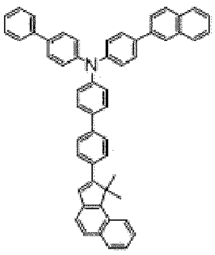 | 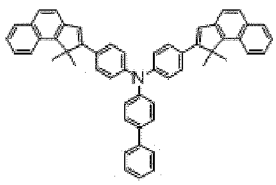 | 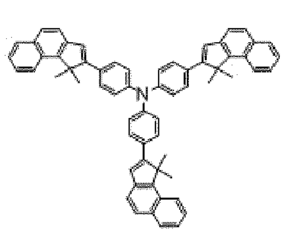 |
| **442** | **443** | **444** |
| 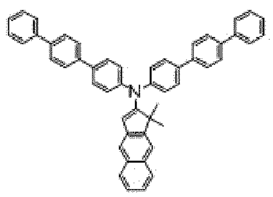 | 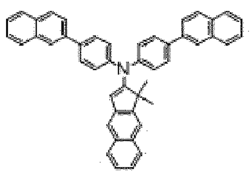 | 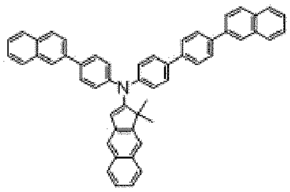 |
| **445** | **446** | **447** |

(continued)

| | | |
|---|---|---|
| 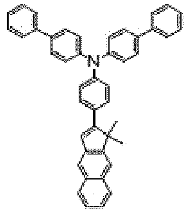 | 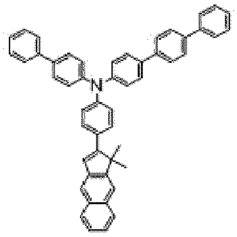 | 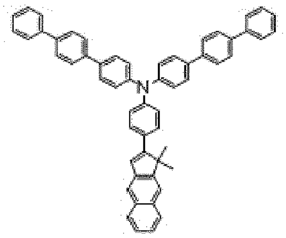 |
| **448** | **449** | **450** |
| 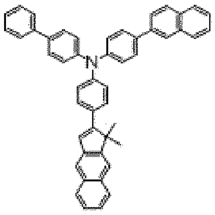 | 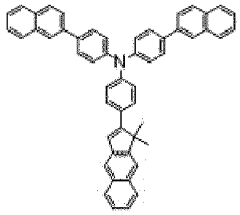 | 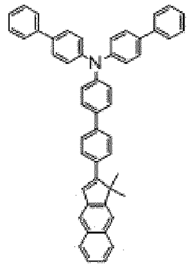 |
| **451** | **452** | **453** |
| 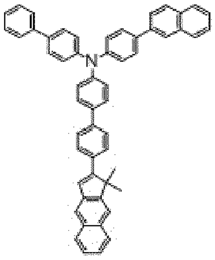 | 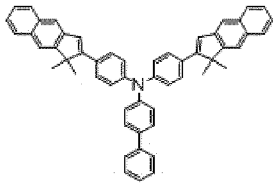 | 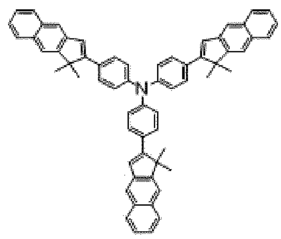 |
| **454** | **455** | **456** |
| 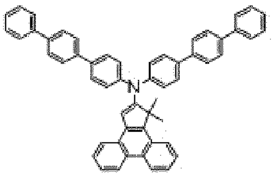 | 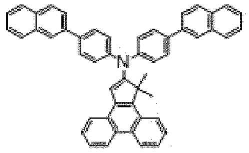 | 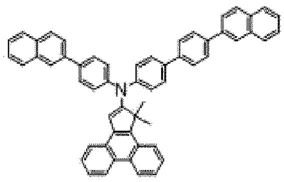 |
| **457** | **458** | **459** |
| 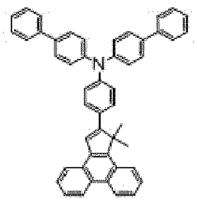 | 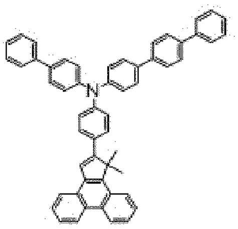 | 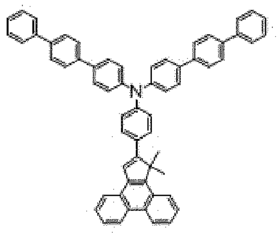 |
| **460** | **461** | **462** |

(continued)

| | | |
|---|---|---|
| 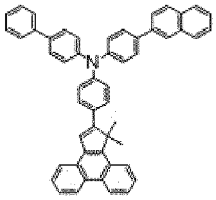 | 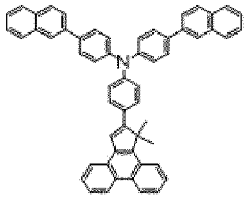 | 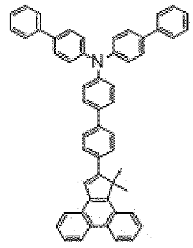 |
| 463 | 464 | 465 |
| 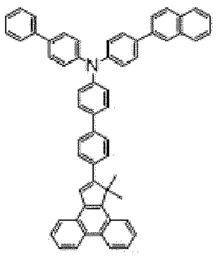 | 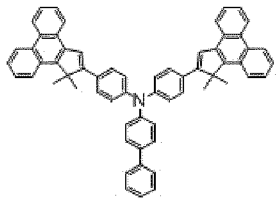 | 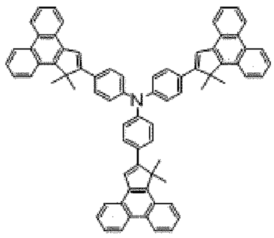 |
| 466 | 467 | 468 |
| 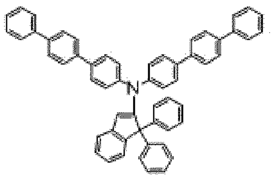 | 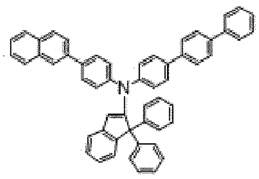 | 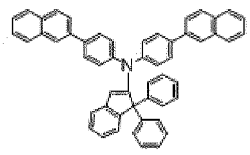 |
| 469 | 470 | 471 |
| 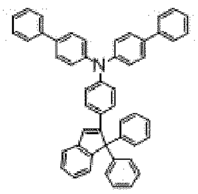 | 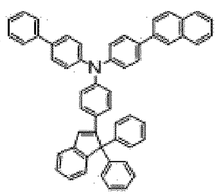 | 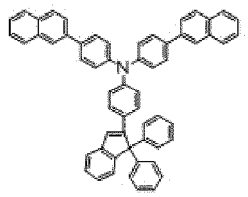 |
| 472 | 473 | 474 |
| 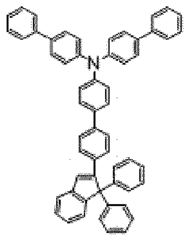 | 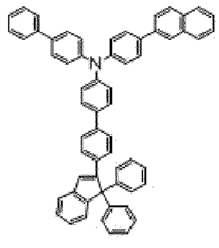 | 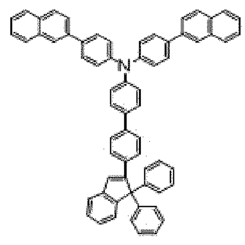 |
| 475 | 476 | 477 |

(continued)

| | | |
|---|---|---|
| 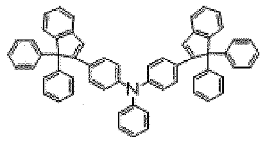 | 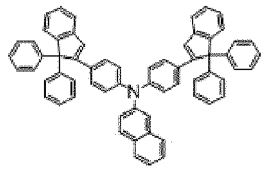 | 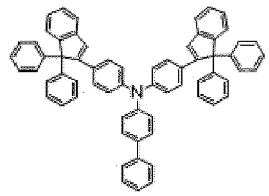 |
| **478** | **479** | **480** |
| 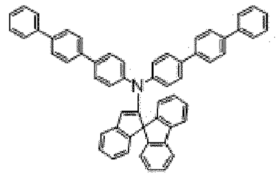 | 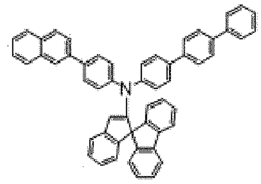 | 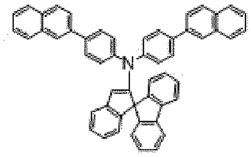 |
| **481** | **482** | **483** |
| 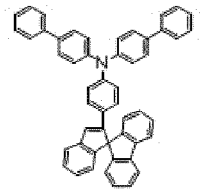 | 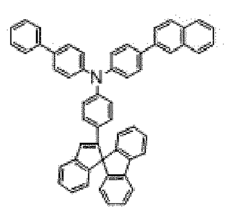 | 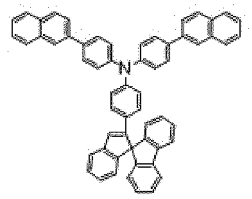 |
| **484** | **485** | **486** |
| 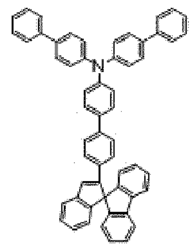 | 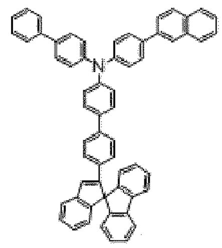 | 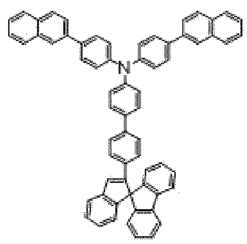 |
| **487** | **488** | **489** |
| 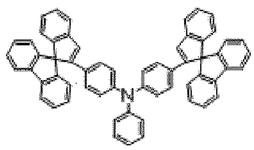 | 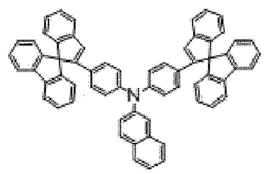 | 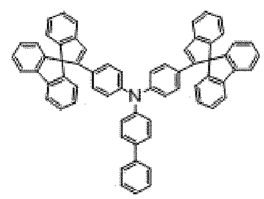 |
| **490** | **491** | **492** |

(continued)

| | | |
|---|---|---|
| 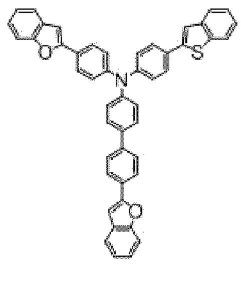 | 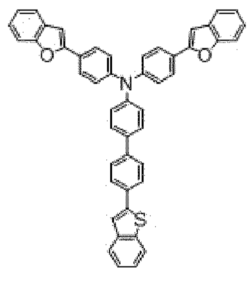 | 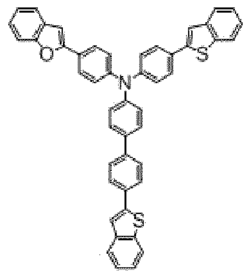 |
| **493** | **494** | **495** |
| 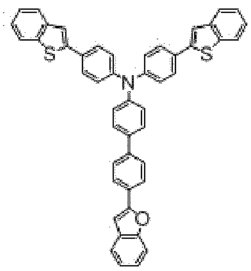 | 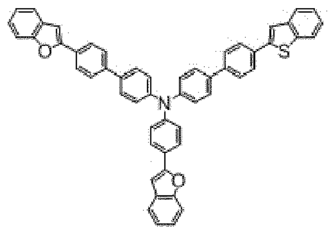 | 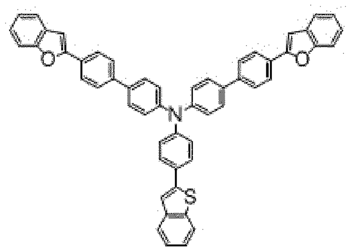 |
| **496** | **497** | **498** |
| 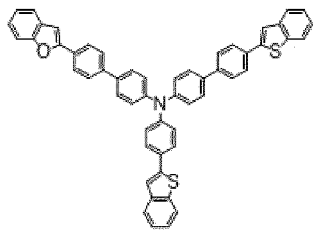 | 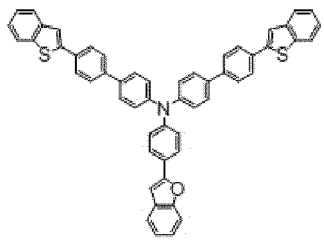 | 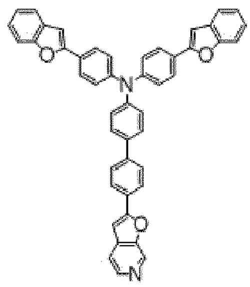 |
| **499** | **500** | **501** |
| 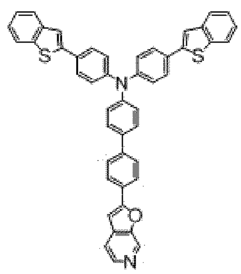 | 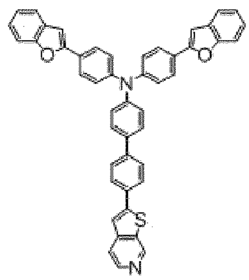 | 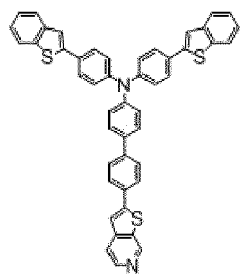 |
| **502** | **503** | **504** |
| | | |

FIG. 1

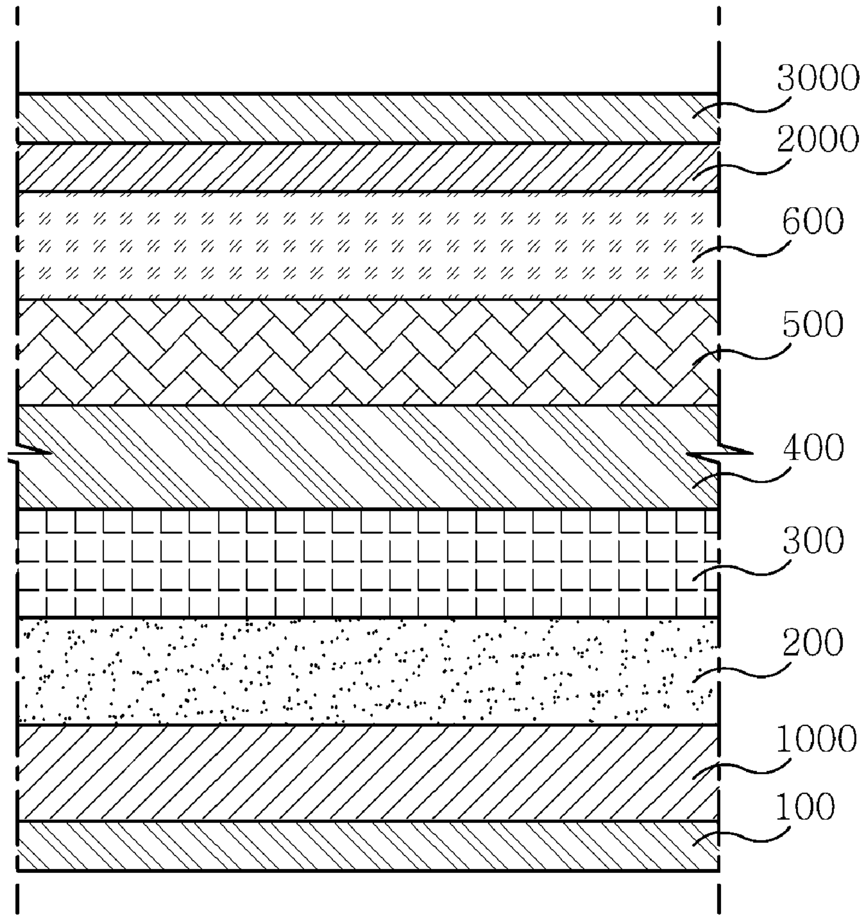

FIG.2

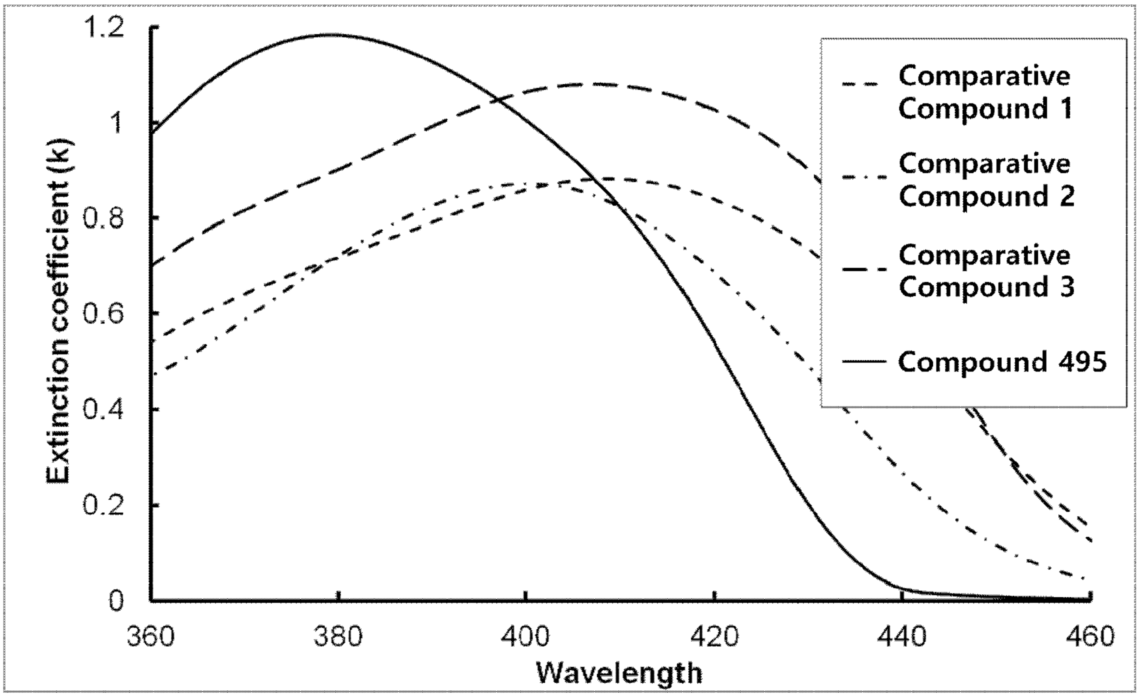
Comparative Compound 1
Comparative Compound 2
Comparative Compound 3
Compound 495
Extinction coefficient (k)
Wavelength
1.2
1
0.8
0.6
0.4
0.2
0
360
380
400
420
440
460

European Patent Office

# EUROPEAN SEARCH REPORT

Application Number
EP 21 19 4297

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | KR 2021 0052311 A (DONGJIN SEMICHEM CO LTD [KR]) 10 May 2021 (2021-05-10)<br>* paragraphs [0206] - [0207]; compounds 1-12,14-212,214-240,253-492 * | 1-7,9-14<br>8 | INV.<br>H01L51/52<br>C07C211/00 |
| A | KR 2021 0035041 A (DONGJIN SEMICHEM CO LTD [KR]) 31 March 2021 (2021-03-31)<br>* paragraph [0001]; claims 1-14 * | 1-14 | |
| A | KR 2020 0136115 A (DONGJIN SEMICHEM CO LTD [KR]) 7 December 2020 (2020-12-07)<br>* paragraph [0001]; claims 1-11 * | 1-14 | |
| A | KR 2020 0062616 A (DONGJIN SEMICHEM CO LTD [KR]) 4 June 2020 (2020-06-04)<br>* paragraph [0017]; claim 1 * | 1-14 | |
| A | WO 2020/171221 A1 (HODOGAYA CHEM CO LTD) 27 August 2020 (2020-08-27)<br>* claim 1 * | 1-14 | |
| | | | TECHNICAL FIELDS SEARCHED (IPC) |
| | | | H01L<br>C07C |

1 The present search report has been drawn up for all claims

| Place of search | Date of completion of the search | Examiner |
|---|---|---|
| The Hague | 4 February 2022 | Welter, Steve |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 19 4297

This annex lists the patent family members relating to the patent documents cited in the above-mentioned European search report. The members are as contained in the European Patent Office EDP file on
The European Patent Office is in no way liable for these particulars which are merely given for the purpose of information.

04-02-2022

| Patent document cited in search report | Publication date | Patent family member(s) | Publication date |
|---|---|---|---|
| KR 20210052311 A | 10-05-2021 | CN 112745264 A | 04-05-2021 |
| | | KR 20210052311 A | 10-05-2021 |
| KR 20210035041 A | 31-03-2021 | CN 112538060 A | 23-03-2021 |
| | | KR 20210035041 A | 31-03-2021 |
| KR 20200136115 A | 07-12-2020 | CN 111995530 A | 27-11-2020 |
| | | KR 20200136115 A | 07-12-2020 |
| | | TW 202104162 A | 01-02-2021 |
| KR 20200062616 A | 04-06-2020 | CN 111217778 A | 02-06-2020 |
| | | KR 20200062616 A | 04-06-2020 |
| WO 2020171221 A1 | 27-08-2020 | CN 113382993 A | 10-09-2021 |
| | | EP 3929193 A1 | 29-12-2021 |
| | | JP WO2020171221 A1 | 16-12-2021 |
| | | KR 20210131321 A | 02-11-2021 |
| | | TW 202041503 A | 16-11-2020 |
| | | WO 2020171221 A1 | 27-08-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020040098238
- JP H11329734 A